(19) Europäisches Patentamt
European Patent Office
Office européen des brevets

(11) EP 3 392 292 B1

(12) EUROPEAN PATENT SPECIFICATION

(45) Date of publication and mention of the grant of the patent:
**28.06.2023 Bulletin 2023/26**

(21) Application number: **16875649.2**

(22) Date of filing: **13.12.2016**

(51) International Patent Classification (IPC):
***C08G 73/10*** *(2006.01)* ***C08G 73/22*** *(2006.01)*
***G03F 7/037*** *(2006.01)* ***G03F 7/038*** *(2006.01)*
***G03F 7/20*** *(2006.01)*

(52) Cooperative Patent Classification (CPC):
**G03F 7/037; C08G 73/1039; C08G 73/1071; C08G 73/12; C08G 73/22; C08L 79/085; G03F 7/0233; G03F 7/039; G03F 7/0755**

(86) International application number:
**PCT/JP2016/087094**

(87) International publication number:
**WO 2017/104672 (22.06.2017 Gazette 2017/25)**

(54) **METHOD FOR PRODUCING HETEROCYCLE-CONTAINING POLYMER PRECURSOR, HETEROCYCLE-CONTAINING POLYMER PRECURSOR, AND USE FOR SAME**

VERFAHREN ZUR HERSTELLUNG EINES HETEROZYKLUSHALTIGEN POLYMERVORLÄUFERS, HETEROZYKLUSHALTIGER POLYMERVORLÄUFER UND VERWENDUNG DAVON

PROCÉDÉ DE PRODUCTION D’UN PRÉCURSEUR DE POLYMÈRE CONTENANT UN HÉTÉROCYCLE, PRÉCURSEUR DE POLYMÈRE CONTENANT UN HÉTÉROCYCLE ET SON UTILISATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.12.2015 JP 2015246498**

(43) Date of publication of application:
**24.10.2018 Bulletin 2018/43**

(73) Proprietor: **FUJIFILM Corporation**
**Tokyo 106-8620 (JP)**

(72) Inventors:
- **KAWABATA, Takeshi**
  **Shizuoka 421-0396 (JP)**
- **IWAI, Yu**
  **Shizuoka 421-0396 (JP)**
- **SHIBUYA, Akinori**
  **Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**JP-A- S5 968 332** **JP-A- 2014 122 279**
**JP-A- 2015 108 053** **JP-B1- S 446 068**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

## BACKGROUND OF THE INVENTION

1. Field of the Invention

The present invention relates to a method of manufacturing a heterocycle-containing polymer precursor, a heterocycle-containing polymer precursor, a composition including the heterocycle-containing polymer precursor, a cured film obtained by curing the composition, a method of manufacturing a cured film, and a semiconductor device.

2. Description of the Related Art

A cyclized and cured thermosetting resin such as a polyimide resin has excellent heat resistance and excellent insulation properties and thus is used for an insulating layer of a semiconductor device and the like.
Since the polyimide resin has low solubility in a solvent, the polyimide resin is used in the state of a precursor (polyimide precursor) before the cyclization reaction, is applied to a substrate or the like, and is then heated to cyclize the polyimide precursor and to form a cured film.
For example, JP2014-122279A discloses a resin composition including (a) a polyimide precursor having a structural unit represented by Formula (1) and (b) a metal complex compound represented by Formula (22).

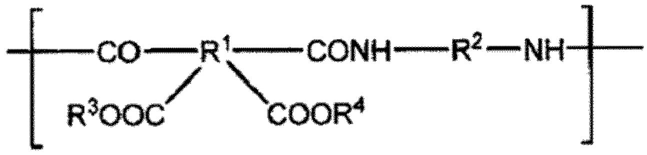

(In the formula, $R^1$ is a tetravalent organic group. $R^2$ is a divalent organic group. $R^3$ and $R^4$ each independently represent a hydrogen atom, an alkyl group having 1 to 20 carbon atoms, a cycloalkyl group having 3 to 20 carbon atoms, or a monovalent organic group having a carbon-carbon unsaturated double bond.)

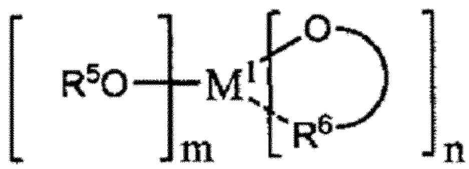

(In the formula, $M^1$ is a metal atom selected from titanium and zirconium. m is an integer of 0 to 4, n is an integer of 0 to 4, and a sum of m and n is 4. $R^5$ each independently represent an alkyl group having 1 to 18 carbon atoms. $R^6$ each independently represent a monovalent organic group, and the monovalent organic group has one or more groups that may form a coordinate bond with $M^1$ selected from a hydroxyl group, a carbonyl group, and an amino group.)
JP2015-108053A discloses a resin composition containing a polyimide precursor having a structural unit represented by Formula (1) and 2,4,6-trimethylpyridinium p-toluenesulfonate.

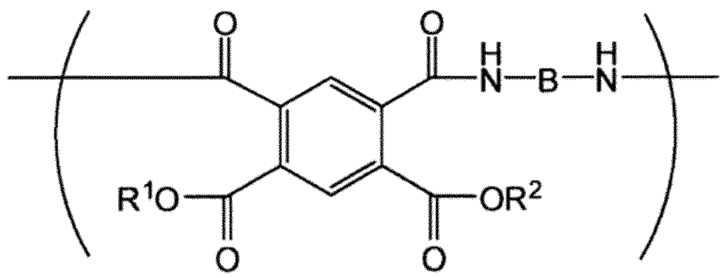

(1)

(Formula (1), B is a divalent organic group as below. $R^1$ and $R^2$ each independently represent a hydrogen atom or a monovalent organic group.)

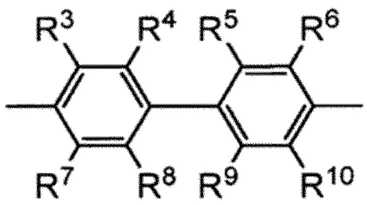

(In the formula, $R^3$ to $R^{10}$ each independently represent a hydrogen atom, a fluorine atom, a trifluoromethyl group, or a methyl group. Here, at least one of $R^3$ to $R^{10}$ is a fluorine atom, a trifluoromethyl group, or a methyl group.).

JP S59 068332 A describes a polyimide precursor material prepared by using an aliphatic tetracarboxylic acid and a diamine, which has carboxylic group and amino group at the polymer terminals, and the thus obtained polyimide precursor has a rate of remaining acid value of 5 to 40 %.

## SUMMARY OF THE INVENTION

However, as a result of the research on JP2014-122279A or JP2015-108053A, it has been found that the cyclization rate of the obtained polyimide precursor is slow.

The present invention has the purpose of solving the above problem and an object of the invention is to provide a method of manufacturing a heterocycle-containing polymer precursor having a fast cyclization rate, a heterocycle-containing polymer precursor, a composition, a cured film, a method of manufacturing a cured film, and a semiconductor device.

Based on the above object, the present inventors have conducted research and found that the above problem may be solved by a step of halogenating dicarboxylic acid or a dicarboxylic acid derivative by using a halogenating agent in the manufacturing of the heterocycle-containing polymer precursor and performing reaction with diamine, so as to adjust a difference between a molar amount of a halogenating agent and a molar amount of water included in a reaction system before the reaction of the halogenating agent to become 2.10 times or less of a total molar amount of dicarboxylic acid and dicarboxylic acid derivative of a raw material. That is, the present inventors have found that the above object can be achieved by the following means.

Specifically, the above problem has been solved by <1> and preferably by <2> to <17>.

<1> A method of manufacturing a heterocycle-containing polymer precursor using dicarboxylic acid or dicarboxylic acid derivative and diamine as raw materials, comprising:

halogenating the dicarboxylic acid or the dicarboxylic acid derivative by using a halogenating agent and performing reaction with diamine; and
adjusting a difference between a molar amount of the halogenating agent and a molar amount of water included in a reaction system before reaction of the halogenating agent to become 2.10 times or less of a total molar amount of the dicarboxylic acid and the dicarboxylic acid derivative as the raw materials.

<2> The method of manufacturing a heterocycle-containing polymer precursor according to <1>, in which, in the heterocycle-containing polymer precursor, an acid value of an acid group having pH at a neutralization point in a range of 5.0 to 9.0 is 4.0 mgKOH/g or less.
<3> The method of manufacturing a heterocycle-containing polymer precursor according to <1> or <2>, further comprising: measuring a water content of the reaction system before the reaction of the halogenating agent and adjusting an addition amount of the halogenating agent according to the water content.
<4> The method of manufacturing a heterocycle-containing polymer precursor according to <1> or <2>, further comprising: adding water before the halogenating agent is added.
<5> The method of manufacturing a heterocycle-containing polymer precursor according to any one of <1> to <4>, in which the molar amount of the halogenating agent is 2.00 to 2.10 times of the total molar amount of the dicarboxylic acid and the dicarboxylic acid derivative as the raw material.
<6> The method of manufacturing a heterocycle-containing polymer precursor according to any one of <1> to <5>, in which the heterocycle-containing polymer precursor includes a repeating unit represented by Formula (2) and a repeating unit represented by Formula (3),

Formula (2)

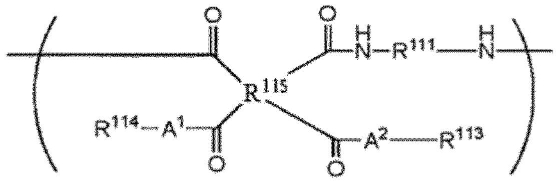

Formula (3)

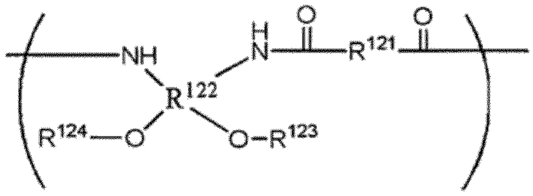

in Formula (2), $A^1$ and $A^2$ each independently represent an oxygen atom or NH,
$R^{111}$ represents a divalent organic group, $R^{115}$ represents a tetravalent organic group, $R^{113}$ and $R^{114}$ each independently represent a hydrogen atom or a monovalent organic group; and
in Formula (3), $R^{121}$ represents a divalent organic group, $R^{122}$ represents a tetravalent organic group, and $R^{123}$ and $R^{124}$ each independently represent a hydrogen atom or a monovalent organic group.

<7> A method of manufacturing a heterocycle-containing polymer precursor according to any one of <1> to <6>, in which a total number of a terminal group represented by Formula (2-2) and a terminal group represented by Formula (3-2) included in the heterocycle-containing polymer precursor is 2.5% or less of a total number of a total repeating unit;

Formula (2-2)

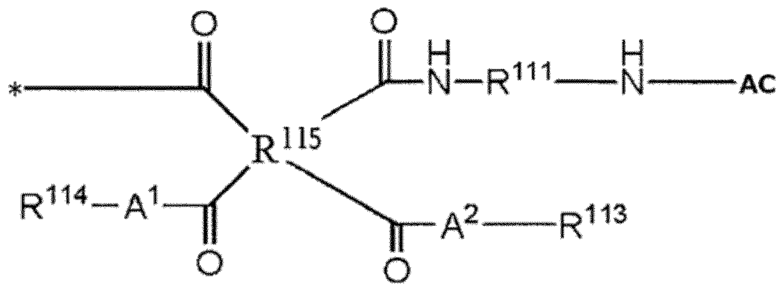

Formula (3-2)

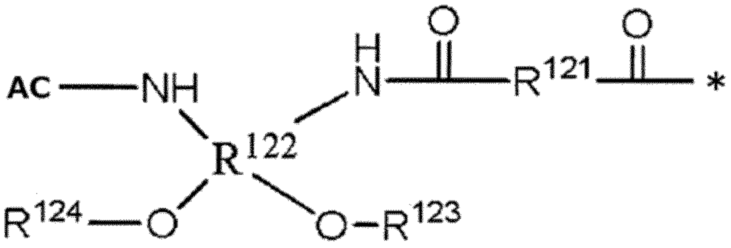

in Formula (2-2), $A^1$ and $A^2$ each independently represent an oxygen atom or NH,
$R^{111}$ represents a divalent organic group, $R^{115}$ represents a tetravalent organic group, $R^{113}$ and $R^{114}$ each independently represent a hydrogen atom or a monovalent organic group, AC represents an acid group having pH of a neutralization point in a range of 5.0 to 9.0, and * represents a bonding position to a main chain of a

polyimide precursor; and

in Formula (3-2), $R^{121}$ represents a divalent organic group, $R^{122}$ represents a tetravalent organic group, and $R^{123}$ and $R^{124}$ each independently represent a hydrogen atom or a monovalent organic group, AC represents an acid group having pH of the neutralization point in a range of 5.0 to 9.0, and * represents a bonding position to a main chain of a polybenzoxazole precursor.

<8> The method of manufacturing a heterocycle-containing polymer precursor according to any one of <1> to <7>, in which a weight-average molecular weight of the heterocycle-containing polymer precursor is 20,000 to 30,000.

<9> A heterocycle-containing polymer precursor, which is a heterocycle-containing polymer precursor selected from a polyimide precursor material and a polybenzoxazole precursor material and in which an acid value of an acid group having pH of a neutralization point in a range of 5.0 to 9.0 is 4.0 mgKOH/g or less.

<10> In the heterocycle-containing polymer precursor according to <9>, a total number of a terminal group represented by Formula (2-2) and a terminal group represented by Formula (3-2) included in the heterocycle-containing polymer precursor is 2.5% or less of a total number of a total repeating unit;

Formula (2-2)

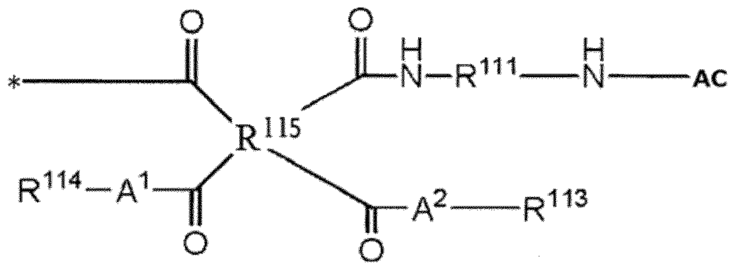

Formula (3-2)

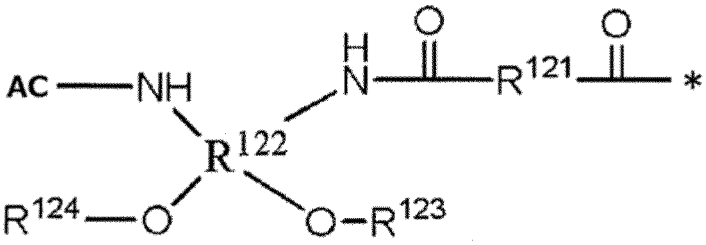

in Formula (2-2), $A^1$ and $A^2$ each independently represent an oxygen atom or NH,

$R^{111}$ represents a divalent organic group, $R^{115}$ represents a tetravalent organic group, $R^{113}$ and $R^{114}$ each independently represent a hydrogen atom or a monovalent organic group, AC represents an acid group having pH of a neutralization point in a range of 5.0 to 9.0, and * represents a bonding position to a main chain of a polyimide precursor; and

in Formula (3-2), $R^{121}$ represents a divalent organic group, $R^{122}$ represents a tetravalent organic group, and $R^{123}$ and $R^{124}$ each independently represent a hydrogen atom or a monovalent organic group, AC represents an acid group having pH of the neutralization point in a range of 5.0 to 9.0, and * represents a bonding position to a main chain of a polybenzoxazole precursor.

<11> The heterocycle-containing polymer precursor according to <9> or <10>, in which a weight-average molecular weight of the heterocycle-containing polymer precursor is 20,000 to 30,000.

<12> A composition comprising: the heterocycle-containing polymer precursor according to any one of <9> to <11>.

<13> The composition according to <12>, further comprising: a photopolymerization initiator.

<14> A cured film obtained by curing the composition according to <12> or <13>.

<15> The cured film according to <14>, which is an interlayer insulating film for a rewiring layer.

<16> A method of manufacturing a cured film comprising: a step of applying the composition according to <12> or <13> to a substrate; and a step of curing the composition applied to the substrate.

<17> A semiconductor device comprising: the cured film according to <14> or <15>.

According to the present invention, it is possible to provide a method of manufacturing a heterocycle-containing polymer precursor having a fast cyclization rate, a heterocycle-containing polymer precursor, a composition, a cured film, a method of manufacturing a cured film, and a semiconductor device.

## BRIEF DESCRIPTION OF THE DRAWINGS

Fig. 1 is a schematic view illustrating a configuration of an embodiment of a semiconductor device.

## DESCRIPTION OF THE PREFERRED EMBODIMENTS

The following description of components according to the present invention may be made based on a representative embodiment of the present invention, but the present invention is not limited to the embodiment.

In the present specification, in a case where there is no description regarding whether a group (atomic group) is substituted or unsubstituted, the group includes both of a group having a substituent and a group not having a substituent. For example, an "alkyl group" includes not only an alkyl group not having a substituent (unsubstituted alkyl group) but also an alkyl group having a substituent (substituted alkyl group).

In the present specification, the "actinic ray" means, for example, a bright line spectrum of a mercury lamp, far ultraviolet rays represented by excimer laser, extreme ultraviolet rays (EUV light), X rays, electron beams, and the like. In the present invention, the light means actinic rays or radiation. Unless described otherwise, the expression "exposure" in the present specification means not only exposure by far ultraviolet rays represented by a mercury lamp, excimer laser, X rays, EUV light, or the like, but also drawing by particle beams such as electron beams, ion beams, or the like.

According to the present specification, the numerical range expressed by using "to" means a range including numerical values described before and after "to" as a lower limit value and an upper limit value.

In the present specification, "(meth)acrylate" represents both or any one of "acrylate" and "methacrylate", "(meth)allyl" represents both or any one of "allyl" and "metaallyl", "(meth)acrylic" represents both or any one of "acrylic" and "methacrylic", and "(meth)acryloyl" means both or any one of "acryloyl" and "methacryloyl".

In the present specification, the expression "step" includes not only an independent step but also include a case where the step is not clearly distinguished from other steps as long as the intended action of the step is achieved.

In the present specification, a concentration of a solid content is a mass percentage of a mass of the other components excluding a solvent, with respect to the total mass of a composition. Unless described otherwise, the concentration of the solid content means the concentration at 25°C.

In the present specification, unless described otherwise, the weight-average molecular weight (Mw) is defined as value in terms of polystyrene by GPC measurement. In the present specification, a weight-average molecular weight (Mw) may be obtained by using, for example, HLC-8220 (manufactured by Tosoh Corporation) and using guard columns HZ-L, TSKgel Super HZM-M, TSKgel Super HZ4000, TSKgel Super HZ3000, and TSKgel Super HZ2000 (manufactured by Tosoh Corporation) as columns. Unless described otherwise, an eluent is measured by using tetrahydrofuran (THF). Unless described otherwise, detection is performed by using a 254 nm wavelength detector of ultraviolet rays (UV rays).

The method of manufacturing a heterocycle-containing polymer precursor according to the present invention is a method of manufacturing a heterocycle-containing polymer precursor using dicarboxylic acid or dicarboxylic acid derivative and diamine as raw materials and includes halogenating dicarboxylic acid or dicarboxylic acid derivative by using a halogenating agent and performing reaction with diamine and adjusting a difference between a molar amount of the halogenating agent and a molar amount of water included in a reaction system before reaction of the halogenating agent to become 2.10 times or less of a total molar amount of dicarboxylic acid and dicarboxylic acid derivative as a raw material. According to this configuration, it is possible to obtain the heterocycle-containing polymer precursor having a fast cyclization rate. In a case where synthesis is performed in a plurality of steps as the same synthesis method, it is possible to obtain a heterocycle-containing polymer precursor having constant cyclization time.

The reason is not clear, but it is considered as follows.

In the manufacturing method of the present invention, after the dicarboxylic acid or the dicarboxylic acid derivative as a raw material is halogenated by using a halogenating agent, reaction is performed with diamine, but in a case where an amount of water in a reaction solution is small compared with an amount of a halogenating agent, unreacted halogenating agent increases.

As disclosed in "Chemische Berichte, 1910, vol. 43, p. 3297", for example, $SOCl_2$ is present in the presence of amine, the following reaction occurs.

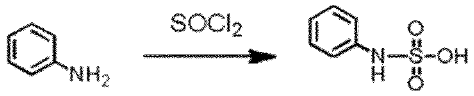

That is, in the manufacturing of the heterocycle-containing polymer precursor, for example, it is assumed that the following side reaction occurs.

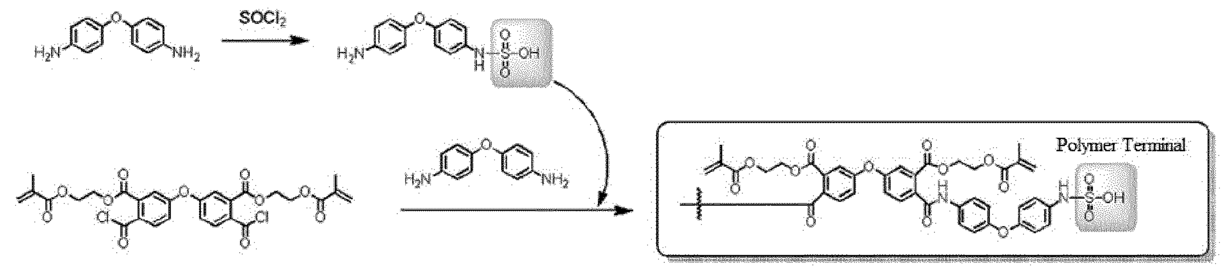


Here, cyclization reaction such as imidization proceeds by heating, but is accelerated by base conditions and is inhibited under acidic conditions. That is, as described above, in a case where an acid group of a strong acid (for example, an acid group having pH of a neutralization point in the range of 5.0 to 9.0) is bond to a polymer terminal, a cyclization rate is slowed down. According to the present invention, it is assumed that the bonding of strong acid to a polymer terminal may be suppressed by adjusting a difference between a molar amount of the halogenating agent and a molar amount of water included in a reaction system before reaction of the halogenating agent to become 2.10 times or less of a total molar amount of dicarboxylic acid and dicarboxylic acid derivative as a raw material. For example, the heterocycle-containing polymer precursor that may be obtained by the manufacturing method of the present invention may cause the acid value of the acid group having pH of the neutralization point in the range of 5.0 to 9.0 to be 4.0 mgKOH/g or less.

The water content in the reaction system may be influenced by various factors. Even in a case where synthesis is performed in a plurality of steps as the same synthesis method, the cyclization rate may vary depending on manufacturing times in some cases. However, according to the present invention, it is assumed that, even in a case where the heterocycle-containing polymer precursor material is manufactured in a plurality of steps by the above adjustment, unnecessary side reactions hardly occur proceed, and a heterocycle-containing polymer precursor having a constant cyclization rate may be obtained.

Hereinafter, a method of manufacturing the heterocycle-containing polymer precursor material according to the present invention is specifically described below.

The manufacturing method of the present invention includes halogenating dicarboxylic acid or a dicarboxylic acid derivative by using a halogenating agent. A difference (hereinafter, referred to as a "difference between molar amounts of a halogenating agent and water") between an added molar amount of a halogenating agent and a molar amount of water included in a reaction system before reaction of the halogenating agent is preferably adjusted to be 2.10 times or less of the total molar amount (hereinafter, also referred to as a "molar amount of dicarboxylic acid and the like as a raw material") of dicarboxylic acid and a dicarboxylic acid derivative as a raw material. The upper limit value of the difference between molar amounts of a halogenating agent and water / a molar amount of dicarboxylic acid and the like as a raw material is preferably 2.05 or less, more preferably 2.00 or less, and may be 1.97 or less. The lower limit value of the difference between molar amounts of a halogenating agent and water / a molar amount of dicarboxylic acid and the like as a raw material is not particularly limited, and is preferably 1.90 or more and more preferably 1.95 or more.

The reaction system before the reaction of the halogenating agent refers to a reaction system in a stage before a stage in which a halogenating agent is reacted with dicarboxylic acid or a dicarboxylic acid derivative in a synthesis reaction system of the heterocycle-containing polymer precursor according to the present invention.

According to the present invention, as provided in examples described below, in a case where a dicarboxylic acid derivative (for example, dicarboxylic acid dianhydride) is added as a raw material, is converted to dicarboxylic acid, and then reacts with diamine, a dicarboxylic acid derivative, the dicarboxylic acid derivative is converted to dicarboxylic acid by substantially 100 mol%. That is, a "total molar amount of a dicarboxylic acid and dicarboxylic acid derivative as a raw material" may be regarded as a molar amount of a dicarboxylic acid derivative.

According to the present invention, a method of adjusting a difference between molar amounts of a halogenating agent and water to be 2.10 times or less of a molar amount of dicarboxylic acid and the like as a raw material is not particularly limited, and well-known methods may be employed.

As a first embodiment of the adjusting method, a method of measuring a water content of a reaction system before reaction of a halogenating agent and adjusting an addition amount of a halogenating agent according to a water content is exemplified. Here, in a case where a heterocycle-containing polymer precursor material is manufactured in a plurality of steps, the measurement of the water content may be performed for each manufacturing step. However, after the adjustment of a reaction tank and the control of the external environment are completed, for example, in a case

of the production in an industrial scale, the measurement of the water content may be appropriately omitted.

As a second embodiment of the adjusting method, a method of adding water before the addition of the halogenating agent is exemplified. Also in the present embodiment, before adding water, it is preferable to measure a water content of the reaction system before the reaction of the halogenating agent and to add water according to the water content.

A method of measuring a water content is measured by a method described in the examples below. In a case where it is difficult to obtain the equipment and the like used in the examples due to the discontinuance or the like, other equipment or the like having equivalent performances may be used.

According to the present invention, after the adjustment, dicarboxylic acid or a dicarboxylic acid derivative is halogenated by using a halogenating agent and is reacted with diamine.

According to the present invention, a molar amount of a halogenating agent added to a reaction system is preferably 2.00 to 2.10 times of a molar amount of dicarboxylic acid or the like as a raw material. It is possible to reduce an unreacted halogenating agent by causing the molar amount of the halogenating agent to be in this range. According to the present invention, a lower limit value of a molar amount of a halogenating agent / a molar amount of a dicarboxylic acid or the like as a raw material may be 2.02 or more. An upper limit value of a molar amount of a halogenating agent / a molar amount of a dicarboxylic acid or the like as a raw material is preferably 2.09 or less and may be 2.07 or less.

A reaction temperature of a halogenating agent with dicarboxylic acid or dicarboxylic acid derivative is preferably -50°C to 10°C, and the reaction time thereof is preferably 30 minutes to four hours.

According to the present invention, a dicarboxylic acid derivative is directly reacted with a halogenating agent, but a case of converting a dicarboxylic acid derivative to dicarboxylic acid or another dicarboxylic acid derivative and performing reaction with a halogenating agent is included.

According to the present invention, after the adjustment, dicarboxylic acid or a dicarboxylic acid derivative is halogenated and is reacted with diamine.

According to the present invention, dicarboxylic acid or a dicarboxylic acid derivative as a raw material which is added to a reaction system and diamine preferably has a molar ratio of 1 : 1.8 to 1 : 2.2 and more preferably has a molar ratio of 1 : 1.9 to 1 : 2.1. In a case where the molar ratio is in the range, the effect of the present invention is more effectively exhibited.

A reaction temperature of halogenated dicarboxylic acid or a halogenated dicarboxylic acid derivative and diamine is preferably -50°C to 10°C, and the reaction time thereof is preferably 30 minutes to four hours.

<Halogenating agent>

The halogenating agent used in the present invention is not particularly limited, as long as the halogenating agent halogenates dicarboxylic acid or a dicarboxylic acid derivative. However, chloride is preferable, and $SOCl_2$, oxalyl chloride, phosphoryl chloride, sulfuryl chloride, phosphorus trichloride, and phosphorus pentachloride are exemplified, and $SOCl_2$ is more preferable.

The halogenating agent may be used singly and two or more kinds thereof may be used in combination.

<Dicarboxylic acid or dicarboxylic acid derivative>

According to the present invention, as a raw material of a heterocycle-containing polymer precursor, dicarboxylic acid or a dicarboxylic acid derivative is used. The dicarboxylic acid derivative refers to a compound derived from dicarboxylic acid, and examples thereof include tetracarboxylic acid dianhydride, tetracarboxylic acid tetraester, and dicarboxylic acid diester.

«Case of manufacturing polyimide precursor material»

In a case of manufacturing a polyimide precursor material, a tetracarboxylic acid dianhydride is preferable as dicarboxylic acid or a dicarboxylic acid derivative used in the present invention. The dicarboxylic acid or the dicarboxylic acid derivative may be used singly and two or more kinds thereof may be used in combination.

Tetracarboxylic acid dianhydride is preferably represented by Formula (0).

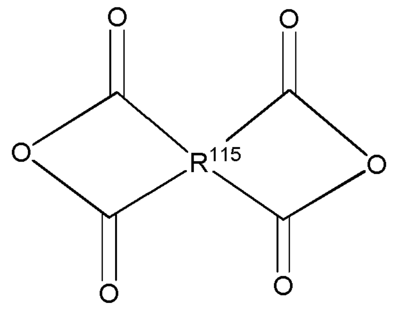

(0)

In Formula (0), $R^{115}$ represents a tetravalent organic group. A preferable range of $R^{115}$ is the same as $R^{115}$ in Formula (2), and a preferable range thereof is also the same.

Specific examples of tetracarboxylic acid dianhydride include at least one selected from pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenonetetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenonetetracarboxylic acid dianhydride, 4,4'-oxydiphthalic acid dianhydride, 2,3,6,7-naphthalenetetracarboxylic acid dianhydride, 1,4,5,7-naphthalenetetracarboxylic acid dianhydride, 2,2-bis(3,4-dicarboxyphenyl) propane dianhydride, 2,2-bis(2,3-dicarboxyphenyl) propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalenetetracarboxylic acid dianhydride, 2,2',3,3'-diphenyltetracarboxylic acid dianhydride, 3,4,9,10-perylenetetracarboxylic acid dianhydride, 1,2,4,5-naphthalenetetracarboxylic acid dianhydride, 1,4,5,8-naphthalenetetracarboxylic acid dianhydride, 1,8,9,10-phenanthrene tetracarboxylic acid dianhydride, 1,1-bis(2,3-dicarboxyphenyl) ethane dianhydride, 1,1-bis(3,4-dicarboxyphenyl) ethane dianhydride, 1,2,3,4-benzenetetracarboxylic acid dianhydride, an alkyl derivative thereof having 1 to 6 carbon atoms, or an alkoxy derivative thereof having 1 to 6 carbon atoms.

Preferable examples thereof also include Tetracarboxylic Acid Dianhydrides (DAA-1) to (DAA-5).

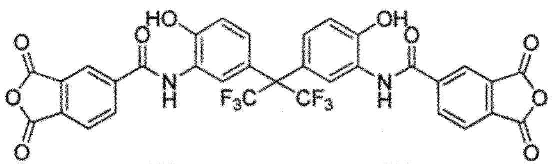

(DAA-1)

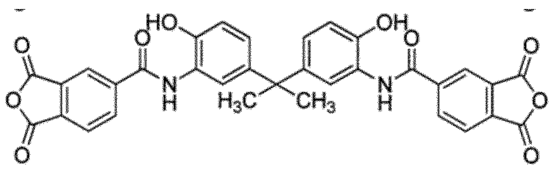

(DAA-2)

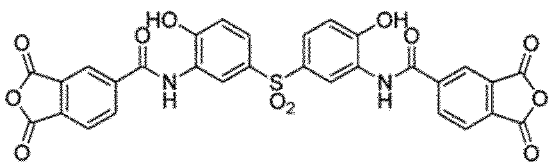

(DAA-3)

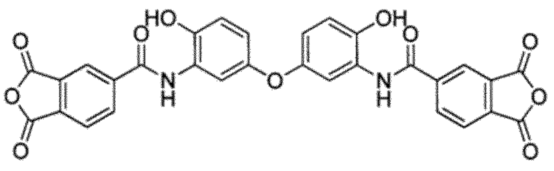

(DAA-4)

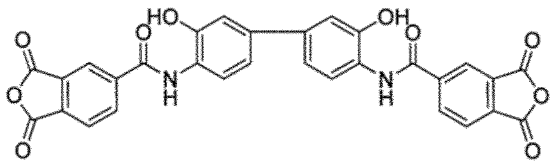

(DAA-5)

<<Conversion to dicarboxylic acid>>

It is preferable that tetracarboxylic acid dianhydride is generally converted to dicarboxylic acid diester before halogenation. Specifically, it is preferable to causing a compound represented by Formula (Q) to react with tetracarboxylic acid dianhydride and converting the compound to dicarboxylic acid to be used.

Formula (Q) $HA^3\text{-}R^{113}$

In Formula (Q), $A^3$ represents an oxygen atom or NH, and $R^{113}$ represents a monovalent organic group.
$A^3$ is preferably an oxygen atom.
The organic group as $R^{113}$ is the same as $R^{113}$ of Formula (2). According to the present invention, particularly, it is preferable that $R^{113}$ has a polymerizable group.
The polymerizable group is a group that may perform crosslinking reaction by the action of actinic rays, radiation, radical, acid, or base, and preferable examples thereof include a group having an ethylenically unsaturated bond, an alkoxymethyl group, a hydroxymethyl group, an acyloxymethyl group, an epoxy group, an oxetanyl group, a benzoxazolyl group, a block isocyanate group, a methylol group, and an amino group. As the polymerizable group included in the heterocycle-containing polymer precursor, a group having an ethylenically unsaturated bond is preferable.
Examples of the group having an ethylenically unsaturated bond include a vinyl group, a (meth)allyl group, and a group represented by Formula (III).

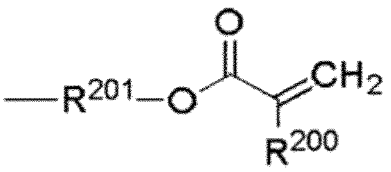

(III)

In Formula (III), $R^{200}$ preferably represents a hydrogen atom or a methyl group, and a methyl group is preferable.
In Formula (III), $R^{201}$ represents an alkylene group having 2 to 12 carbon atoms, $-CH_2CH(OH)CH_2-$, or a polyoxyalkylene group having 4 to 30 carbon atoms.
Examples of preferable $R^{201}$ include an ethylene group, a propylene group, a trimethylene group, a tetramethylene group, a 1,2-butanediyl group, a 1,3-butanediyl group, a pentamethylene group, a hexamethylene group, an octamethylene group, a dodecamethylene group, and $-CH_2CH(OH)CH_2-$, and an ethylene group, a propylene group, a trimethylene group, and $-CH_2CH(OH)CH_2-$ are more preferable.
It is particularly preferable that $R^{200}$ is a methyl group, and $R^{201}$ is an ethylene group.
Specific examples of the compound represented by Formula (Q) include 2-hydroxyethyl methacrylate, allyl alcohol, and parahydroxystyrene. The molar ratio in a case where a tetracarboxylic acid dianhydride and a compound represented by Formula (Q) react with each other is preferably 1 : 1.8 to 1 : 2.2 and more preferably 1 : 1.9 to 1 : 2.1.
The reaction temperature of the tetracarboxylic acid dianhydride and the compound represented by Formula (Q) is preferably 20°C to 100°C, and the reaction time thereof is preferably 1 to 20 hours.

«Case of manufacturing polybenzoxazole precursor material»

In a case of manufacturing a polybenzoxazole precursor material, dicarboxylic acid is preferable as the dicarboxylic acid or the dicarboxylic acid derivative used in the present invention. The dicarboxylic acid may be used singly and two or more kinds thereof may be used in combination.
The dicarboxylic acid is preferably dicarboxylic acid including an aliphatic group and dicarboxylic acid including an aromatic group and is more preferably dicarboxylic acid including an aromatic group.
The dicarboxylic acid including an aliphatic group is preferably a dicarboxylic acid including a linear or branched (preferably linear) aliphatic group and more preferably a dicarboxylic acid including a linear or branched (preferably linear) aliphatic group and two COOH's. The number of carbon atoms of the linear or branched (preferably linear) aliphatic

group is preferably 2 to 30, more preferably 2 to 25, even more preferably 3 to 20, particularly preferably 4 to 15, and still even more preferably 5 to 10. A linear aliphatic group is preferably an alkylene group.

Examples of the dicarboxylic acid including a linear aliphatic group include malonic acid, dimethyl malonic acid, ethyl malonic acid, isopropyl malonic acid, di-n-butylmalonic acid, succinic acid, tetrafluorosuccinic acid, methyl succinic acid, 2,2-dimethyl succinic acid, 2,3-dimethyl succinic acid, dimethyl methyl succinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methyl glutaric acid, adipic acid, octafluoroadipic acid, 3-methyladipic acid, pimelic acid, 2,2,6,6-tetramethyl pimelic acid, suberic acid, dodecafluorosuberic acid, azelaic acid, sebacic acid, hexadecafluoro sebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, hen eicosane diacid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, and dicarboxylic acid represented by the following formula.

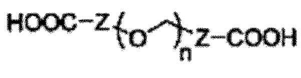 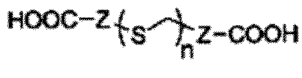

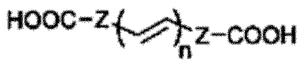 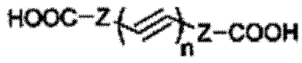

(In the formula, Z is a hydrocarbon group having 1 to 6 carbon atoms, and n is an integer of 1 to 6.)

The dicarboxylic acid including an aromatic group is preferably a dicarboxylic acid including the following aromatic group and more preferably a dicarboxylic acid only including the following aromatic group and two COOH's.

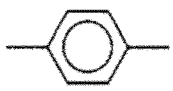 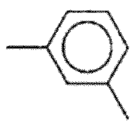 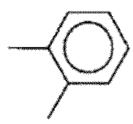 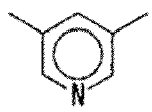

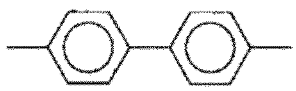 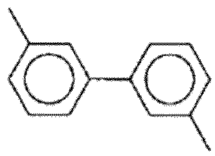 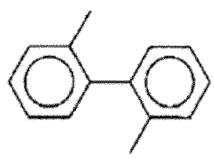

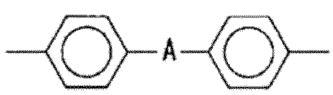 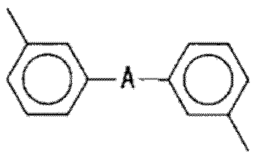 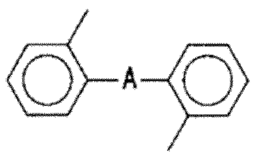

In the formula, A is a divalent group selected from the group consisting of $-CH_2-$, -O-, -S-, $-SO_2-$, -CO-, -NHCO-, $-C(CF_3)_2-$, and $-C(CH_3)_2-$.

As specific examples of the dicarboxylic acid including an aromatic group, 4,4'-carbonyldibenzoic acid and 4,4'-dicarboxydiphenyl ether, and terephthalic acid are preferable.

<Diamine>

«Case of manufacturing polyimide precursor material»

In a case of manufacturing a polyimide precursor material, examples of diamine according to the present invention include linear or branched aliphatic or cyclic aliphatic or aromatic diamine. The diamine may be used singly and two or more kinds thereof may be used in combination.

Specifically, diamine including a linear or branched aliphatic group having 2 to 20 carbon atoms, an cyclic aliphatic group having 6 to 20 carbon atoms, an aromatic group having 6 to 20 carbon atoms, or a group obtained by combining these is preferable, diamine including a group including an aromatic group having 6 to 20 carbon atoms is

more preferable. Examples of the aromatic group include the following.

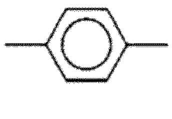
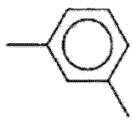
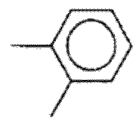
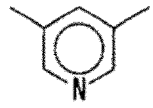

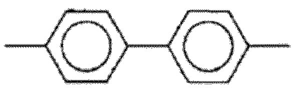
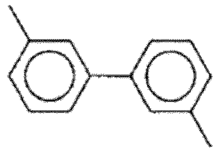
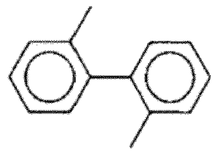

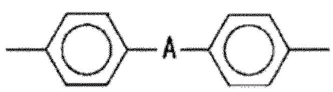
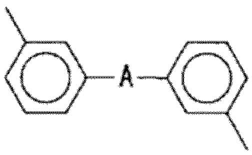
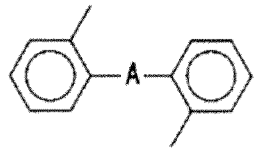

In the formula, A is preferably a single bond, a hydrocarbon group having 1 to 10 carbon atoms that may be substituted with a fluorine atom, a group selected from -O-, -C(=O)-, -S-, $-S(=O)_2-$, -NHCO-, and the combination thereof, more preferably a single bond, an alkylene group having 1 to 3 carbon atoms that may be substituted with a fluorine atom, and a group selected from -O-, -C(=O)-, -S-, and $-SO_2-$, and even more preferably a divalent group selected from the group consisting of $-CH_2-$, -O-, -S-, $-SO_2-$, $-C(CF_3)_2-$, and $-C(CH_3)_2-$.

Specifically, examples of diamine include at least one kind of diamine selected from 1,2-diaminoethane, 1,2-diaminopropane, 1,3-diaminopropane, 1,4-diaminobutane, and 1,6-diaminohexane; 1,2- or 1,3-diaminocyclopentane, 1,2-, 1,3-, or 1,4-diaminocyclohexane, 1,2-, 1,3-, or 1,4-bis(aminomethyl) cyclohexane, bis-(4-aminocyclohexyl) methane, bis-(3-aminocyclohexyl) methane, 4,4'-diamino-3,3'-dimethylcyclohexylmethane, and isophorone diamine; and m- and p-phenylenediamine, diaminotoluene, 4,4'- and 3,3'-diaminobiphenyl, 4,4'-diaminodiphenyl ether, 3,3-diaminodiphenyl ether, 4,4'- and 3,3'-diaminodiphenylmethane, 4,4'- and 3,3'-diaminodiphenyl sulfone, 4,4'- and 3,3'-diaminodiphenyl sulfide, 4,4'- and 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl) propane, 2,2-bis(4-aminophenyl) hexafluoropropane, 2,2-bis(3-hydroxy-4-aminophenyl) propane, 2,2-bis(3-hydroxy-4-aminophenyl) hexafluoropropane, 2,2-bis(3-amino-4-hydroxyphenyl) propane, 2,2-bis(3-amino-4-hydroxyphenyl) hexafluoropropane, bis(3-amino-4-hydroxyphenyl) sulfone, bis(4-amino-3-hydroxyphenyl) sulfone, 4,4'-diaminoparterphenyl, 4,4'-bis(4-aminophenoxy) biphenyl, bis[4-(4-aminophenoxy) phenyl] sulfone, bis[4-(3-aminophenoxy) phenyl] sulfone, bis[4-(2-aminophenoxy) phenyl] sulfone, 1,4-bis(4-aminophenoxy) benzene, 9,10-bis(4-aminophenyl) anthracene, 3,3'-dimethyl-4,4'-diaminodiphenyl sulfone, 1,3-bis(4-aminophenoxy) benzene, 1,3-bis(3-aminophenoxy) benzene, 1,3-bis(4-aminophenyl) benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy) phenyl] propane, 2,2-bis[4-(4-aminophenoxy) phenyl] hexafluoropropane, 9,9-bis(4-aminophenyl) -10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl) fluorene, 4,4'-dimethyl-3,3'-diaminodiphenyl sulfone, 3,3',5,5'-tetramethyl-4,4'-diaminodiphenylmethane, 2,4- and 2,5-diaminocumene, 2,5-dimethyl-p-phenylenediamine, acetoguanamine, 2,3,5,6-tetramethyl-p-phenylenediamine, 2,4,6-trimethyl-m-phenylenediamine, bis(3-aminopropyl) tetramethyldisiloxane, 2,7-diamino fluorene, 2,5-diaminopyridine, 1,2-bis(4-aminophenyl) ethane, diaminobenzanilide, ester of diaminobenzoic acid, 1,5-diaminonaphthalene, diaminobenzotrifluoride, diaminoanthraquinone, 1,3-bis(4-aminophenyl) hexafluoropropane, 1,4-bis(4-aminophenyl) octafluorobutane, 1,5-bis(4-aminophenyl) decafluoropentane, 1,7-bis(4-aminophenyl) tetradecafluoroheptane, 2,2-bis[4-(3-aminophenoxy) phenyl] hexafluoropropane, 2,2-bis[4-(2-aminophenoxy) phenyl] hexafluoropropane, 2,2-bis[4-(4-aminophenoxy)-3,5-dimethylphenyl] hexafluoropropane, 2,2-bis[4-(4-aminophenoxy)-3,5-bis(trifluoromethyl) phenyl] hexafluoropropane, p-bis(4-amino-2-trifluoromethylphenoxy) benzene, 4,4'-bis(4-amino-2-trifluoromethylphenoxy) biphenyl, 4,4'-bis(4-amino-3-trifluoromethylphenoxy) biphenyl, 4,4'-bis(4-amino-2-trifluoromethylphenoxy) diphenyl sulfone, 4,4'-bis(3-amino-5-trifluoromethylphenoxy) diphenyl sulfone, 2,2-bis[4-(4-amino-3-trifluoromethylphenoxy) phenyl] hexafluoropropane, 3,3',5,5'-tetramethyl-4,4'-diaminobiphenyl, 4,4'-diamino-2,2'-bis(trifluoromethyl) biphenyl, 2,2',5,5',6,6'-hexafluorotrazine, or 4,4‴-diaminoquaterphenyl.

Diamine (DA-1) to (DA-18) is also preferable.

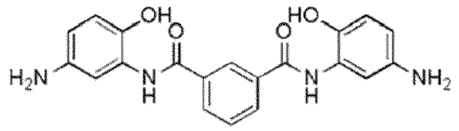

(DA-1)

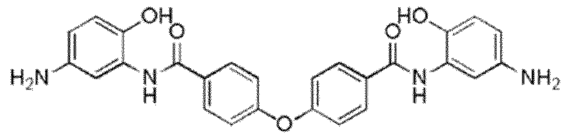

(DA-2)

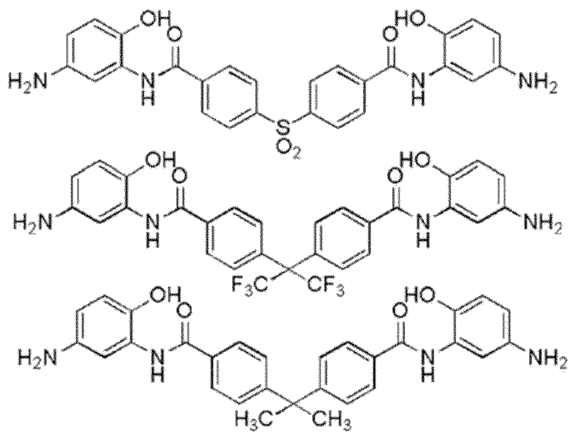

(DA-3)

(DA-4)

(DA-5)

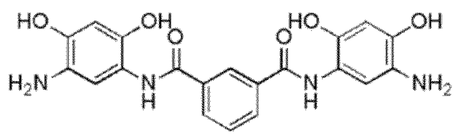

(DA-6)

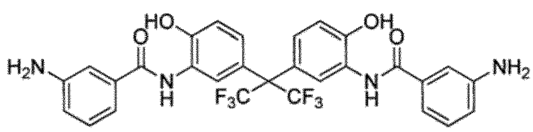

(DA-7)

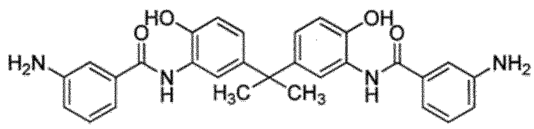

(DA-8)

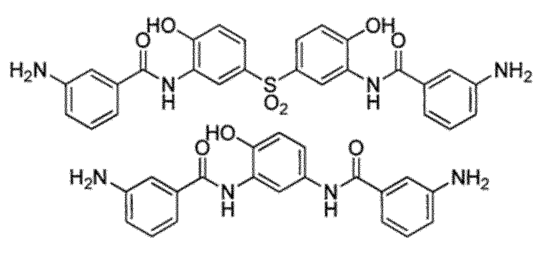

(DA-9)

(DA-10)

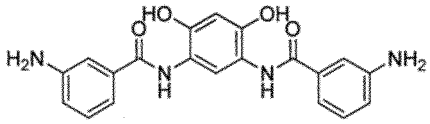
(DA-11)

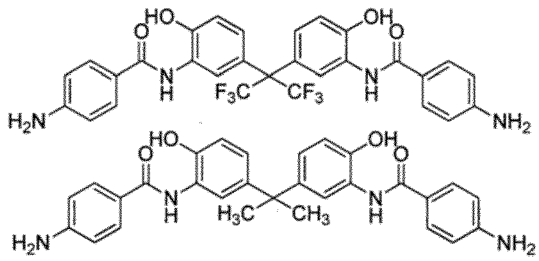
(DA-12)

(DA-13)

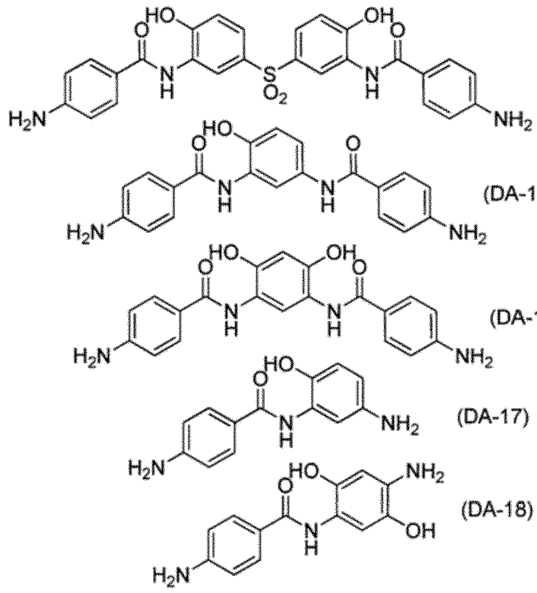
(DA-14)

(DA-15)

(DA-16)

(DA-17)

(DA-18)

Preferable examples include diamine having at least two alkylene glycol units in a main chain. Diamine containing two or more of any one or both of an ethylene glycol chain or a propylene glycol chain in one molecule is preferable, and diamine not containing an aromatic ring is more preferable. Specific examples thereof include JEFFAMINE (registered trademark) KH-511, JEFFAMINE (registered trademark) ED-600, JEFFAMINE (registered trademark) ED-900, JEFFAMINE (registered trademark) ED-2003, JEFFAMINE (registered trademark) EDR-148, and JEFFAMINE (registered trademark) EDR-176, D-200, D-400, D-2000, and D-4000 (above are trade names, manufactured by HUNTSMAN Corporation), 1-(1-(1-(2-aminopropoxy) propan-2-yl) oxy), and 1-(2-(2-(2-aminopropoxy) ethoxy) propoxy) propan-2-amine, and the present invention is not limited thereto.

Structures of JEFFAMINE (registered trademark)KH-511, JEFFAMINE (registered trademark) ED-600, JEFFAMINE (registered trademark) ED-900, JEFFAMINE (registered trademark) ED-2003, JEFFAMINE (registered trademark) EDR-148, and JEFFAMINE (registered trademark) EDR-176 are provided below.

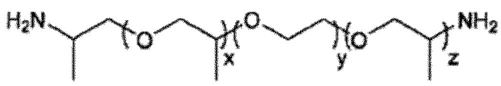

KH-51 1 (y = 2. 0. x+z = 1. 2)
ED-600 (y = 9. 0, x+z = 3. 6)
ED-900 (y = 12. 5, x+z = 6. 0)
ED-2003(y = 39. 0, x+z = 6. 0)

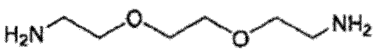

EDR-148

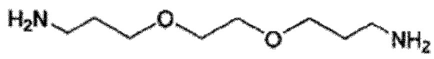

EDR-176

In the above x, y, and z are average values.

«Case of manufacturing polybenzoxazole precursor material»

In a case of manufacturing a polybenzoxazole precursor material, the diamine used in the present invention is preferably a bisaminophenol derivative represented by Formula (A).

$Ar(NH_2)_2(OH)_2$ ··· (A)

In the formula, Ar is an aromatic group.

The diamine may be used singly and two or more kinds thereof may be used in combination.

Examples of the bisaminophenol derivative of Formula (A) include 3,3'-diamino-4,4'-dihydroxybiphenyl, 4,4'-diamino-3,3'-dihydroxybiphenyl, 3,3'-diamino-4,4'-dihydroxydiphenyl sulfone, 4,4'-diamino-3,3'-dihydroxydiphenyl sulfone, bis-(3-amino-4-hydroxyphenyl) methane, 2,2-bis-(3-amino-4-hydroxyphenyl) propane, 2,2-bis-(3-amino-4-hydroxyphenyl) hexafluoropropane, 2,2-bis-(4-amino-3-hydroxyphenyl) hexafluoropropane, bis-(4-amino-3-hydroxyphenyl) methane, 2,2-bis-(4-amino-3-hydroxyphenyl) propane, 4,4'-diamino-3,3'-dihydroxybenzophenone, 3,3'-diamino-4,4'-dihydroxybenzophenone, 4,4'-diamino-3,3'-dihydroxydiphenyl ether, 3,3'-diamino-4,4'-dihydroxydiphenyl ether, 1,4-diamino-2,5-dihydroxybenzene, 1,3-diamino-2,4-dihydroxybenzene, and 1,3-diamino-4,6-dihydroxybenzene. These bisaminophenol derivatives may be used singly or in a mixture.

Among bisaminophenol derivatives represented by Formula (A), a bisaminophenol derivative having the following aromatic group is preferable.

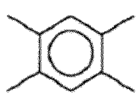

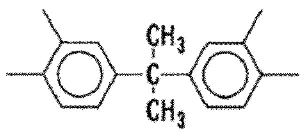

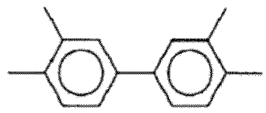

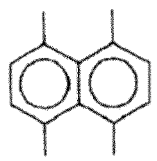

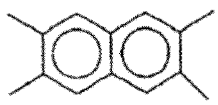

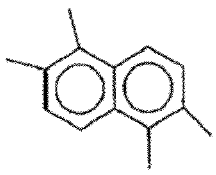

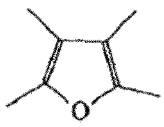

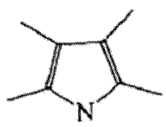

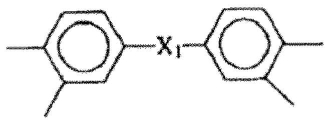

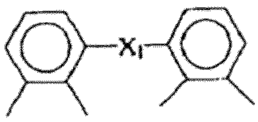

In the formula, X1 represents -O-, -S-, $-C(CF_3)_2-$, $-CH_2-$, $-SO_2-$, or -NHCO-. With respect to the above structure, -OH and -NH2 included in the structure of Formula (A) are bonded to ortho positions (adjacent positions) as in the following structure.

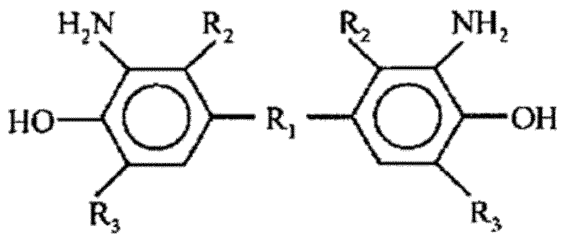

(A - s)

In Formula (A-s), $R_1$ is a hydrogen atom, alkylene, substituted alkylene, -O-, -S-, $-SO_2-$, -CO-, -NHCO-, a single bond, or an organic group selected from the group of Formula (A-sc). $R_2$'s are any one of a hydrogen atom, an alkyl group, an alkoxy group, an acyloxy group, and a cyclic alkyl group and may be identical to or different from each other. $R_3$'s are any one of a hydrogen atom, a linear or branched alkyl group, an alkoxy group, an acyloxy group, and a cyclic alkyl group and may be identical to or different from each other.

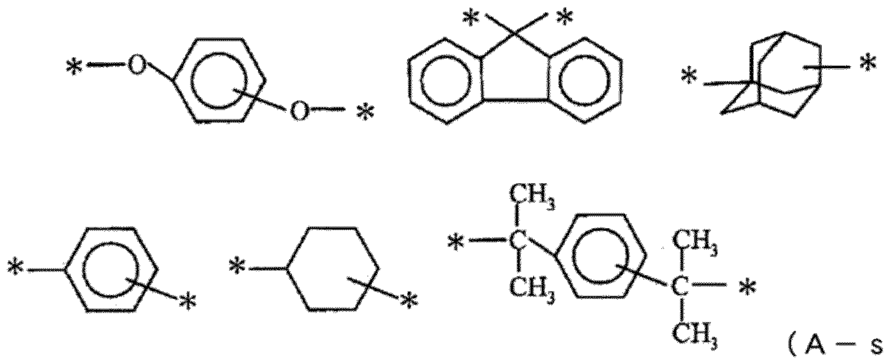

(A - s c)

(In Formula (A-sc), * represents a region that is bonded to an aromatic ring of an aminophenol group of the bisaminophenol derivative represented by Formula (A-s).)

It is considered that in a case where a substituent is at the ortho position of the phenolic hydroxyl group, that is, $R_3$, in Formula (A-s), the carbonyl carbon and the hydroxyl group of the amide bond come closer to each other in terms of distance. Therefore, since the effect of obtaining a high cyclization rate in a case of being cured at a low temperature increases, the substituent is the ortho position is particularly preferable.

It is particularly preferable that $R_2$ in Formula (A-s) is an alkyl group and $R_3$ is an alkyl group, since it is possible to obtain a polybenzoxazole precursor having excellent balance and sufficient solubility in a case where an aqueous alkaline solution is used in a developer while the effect of high transparency to i lines and a high cyclization rate in a case of being cured at low temperature is maintained.

It is even more preferable that $R_1$ in Formula (A-s) is alkylene or substituted alkylene. Specific examples of the alkylene and substituted alkylene according to R1 include $-CH_2-$, $-CH(CH_3)-$, $-C(CH_3)_2-$, $-CH(CH_2CH_3)-$, $-C(CH_3)(CH_2CH_3)-$, $-C(CH_2CH_3)(CH_2CH_3)-$, $-CH(CH_2CH_2CH_3)-$, $-C(CH_3)(CH_2CH_2CH_3)-$, $-CH(CH(CH_3)_2)-$, $-C(CH_3)(CH(CH_3)_2)-$, $-CH(CH_2CH_2CH_2CH_3)-$, $-C(CH_3)(CH_2CH_2CH_2CH_3)-$, $-CH(CH_2CH(CH_3)_2)-$, $-C(CH_3)(CH_2CH(CH_3)_2)-$, $-CH(CH_2CH_2CH_2CH_2CH_3)-$, $-C(CH_3)(CH_2CH_2CH_2CH_2CH_3)-$, $-CH(CH_2CH_2CH_2CH_2CH_2CH_3)-$, and $-C(CH_3)(CH_2CH_2CH_2CH_2CH_2CH_3)-$. Among these, $-CH_2-$, $-CH(CH_3)-$, and $-C(CH_3)_2-$ are more preferable, since it is possible to obtain a polybenzoxazole precursor having excellent balance and sufficient solubility not only to an aqueous alkaline solution but also to a solvent while the effect of high transparency to i lines and a high cyclization rate in a case of being cured at low temperature is maintained.

As the method of manufacturing a bisaminophenol derivative represented by Formula (A-s), for example, paragraphs 0085 to 0094 and Example 1 (paragraphs 0189 to 0190) of JP2013-256506Amay be referred to.

Specific examples of the structures of the bisaminophenol derivative represented by Formula (A-s) include structures disclosed in paragraphs 0070 to 0080 of JP2013-256506A. It is obvious that the present invention is not limited thereto.

<Reaction solvent>

In the method of manufacturing the heterocycle-containing polymer precursor of the present invention, it is preferable to use an organic solvent during the reaction. The organic solvent may be used singly or two or more kinds thereof may be used in combination.

The organic solvent may be appropriately determined according to the raw material, and examples thereof include pyridine, diethylene glycol dimethyl ether (diglyme), N-methylpyrrolidone, and N-ethylpyrrolidone.

<Terminal sealing agent>

In the method of manufacturing the heterocycle-containing polymer precursor according to the present invention, it is preferable to seal a terminal with a terminal sealing agent such as an acid anhydride, monocarboxylic acid, a monoacid chloride compound, a mono active ester compound, or the like in order to further improve the preservation stability. Among these, it is more preferable to use monoamine, and examples of the preferable compound of monoamine include aniline, 2-ethynylaniline, 3-ethynylaniline, 4-ethynylaniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more kinds of these may be used, and a plurality of different terminal groups may be introduced by the reaction with a plurality of terminal sealing agents.

<Solid precipitation>

The manufacturing method of the present invention may further include a step of precipitating the heterocycle-containing polymer precursor. Specifically, the solid precipitation may be performed by depositing the heterocycle-containing polymer precursor in the reaction solution in water and dissolving the heterocycle-containing polymer precursor in a solvent in which the heterocycle-containing polymer precursor such as tetrahydrofuran is soluble.
Thereafter, the heterocycle-containing polymer precursor is dried, and the powder-like heterocycle-containing polymer precursor may be obtained.

<Preferable structure of heterocycle-containing polymer precursor>

The heterocycle-containing polymer precursor obtained by the manufacturing method of the present invention is selected from the polyimide precursor material and the polybenzoxazole precursor material as described above. Hereinafter, the preferable ranges of these precursor materials are described.

«Polyimide precursor material»

The polyimide precursor material obtained by the manufacturing method of the present invention preferably includes a repeating unit represented by Formula (2).

Formula (2)

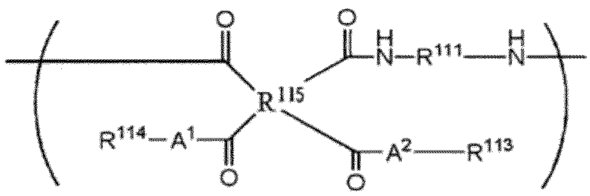

In Formula (2), $A^1$ and $A^2$ each independently represent an oxygen atom or NH, $R^{111}$ represents a divalent organic group, $R^{115}$ represents a tetravalent organic group, and $R^{113}$ and $R^{114}$ each independently represent a hydrogen atom or a monovalent organic group.
$A^1$ and $A^2$ in Formula (2) are preferably an oxygen atom or NH and more preferably an oxygen atom.
$R^{111}$ in Formula (2) represents a divalent organic group. Examples of the divalent organic group include a linear or branched aliphatic group, a cyclic aliphatic group, and a group including an aromatic group. A linear or branched aliphatic group having 2 to 20 carbon atoms, a cyclic aliphatic group having 6 to 20 carbon atoms, an aromatic group having 6 to 20 carbon atoms, or a group including the combination thereof is preferable, and an aromatic group having 6 to 20 carbon atoms is more preferable.

The preferable range is a residue of diamine used in the manufacturing of the polyimide precursor material.

$R^{115}$ in Formula (2) represents a tetravalent organic group. The tetravalent organic group preferably a tetravalent organic group including an aromatic ring and more preferably a group represented by Formula (5) or (6).

Formula (5)

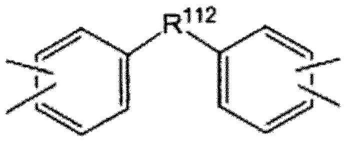

In Formula (5), $R^{112}$ is preferably a single bond, a hydrocarbon group having 1 to 10 carbon atoms that may be substituted with a fluorine atom, a group selected from -O-, -CO-, -S-, $-SO_2-$, -NHCO-, and the combination thereof, more preferably a single bond, an alkylene group having 1 to 3 carbon atoms that is substituted with a fluorine atom, and a group selected from -O-, -CO-, -S- and $-SO_2-$, and even more preferably a divalent group selected from the group consisting of $-CH_2-$, $-C(CF_3)_2-$, $-C(CH_3)_2-$, -O-, -CO-, -S-, and $-SO_2-$.

Formula (6)

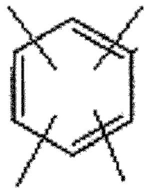

Specific examples of $R^{115}$ include a tetracarboxylic acid residue that remains after the removal of the anhydride group from tetracarboxylic acid dianhydride.

In view of solubility to an alkaline developer, it is preferable to have an OH group on at least one of $R^{111}$ or $R^{115}$. More specifically, examples of $R^{111}$ include a residue of a bisaminophenol derivative of Formula (A).

$R^{113}$ and $R^{114}$ each independently represent a hydrogen atom or a monovalent organic group, and it is preferable that at least one of $R^{113}$ or $R^{114}$ is a polymerizable group. The polymerizable group has the same meaning as the polymerizable group that may be included in the compound represented by Formula (Q), and the preferable ranges are also the same. According to the present invention, it is preferable that at least one of $R^{113}$ or $R^{114}$ is a polymerizable group, and it is more preferable that both of $R^{113}$ and $R^{114}$ are polymerizable groups.

As the monovalent organic group represented by $R^{113}$ or $R^{114}$, a substituent that improves the solubility of the developer is preferably used.

In view of solubility to an aqueous developer, $R^{113}$ or $R^{114}$ may be a hydrogen atom or a monovalent organic group. Examples of the monovalent organic group include an aromatic group and an aralkyl group which have one, two, or three acidic groups and preferably one acidic group which is bonded to carbon forming an aryl group. Specifically, examples thereof include an aromatic group having 6 to 20 carbon atoms that has an acidic group and an aralkyl group having 7 to 25 carbon atoms that has an acidic group. More specifically, examples thereof include a phenyl group that has an acidic group and a benzyl group that has an acidic group. The acidic group is preferably an OH group.

$R^{113}$ or $R^{114}$ is more preferably a hydrogen atom, 2-hydroxybenzyl, 3-hydroxybenzyl, and 4-hydroxybenzyl, in view of solubility with respect to the aqueous developer.

In view of solubility to the organic solvent, $R^{113}$ or $R^{114}$ is preferably a monovalent organic group. The monovalent organic group preferably includes a linear or branched alkyl group, a cyclic alkyl group, and an aromatic group and more preferably an alkyl group substituted with an aromatic group.

The number of carbon atoms of the alkyl group is preferably 1 to 30. The alkyl group may have any one of linear shape, a branched shape, or a cyclic shape. Examples of the linear or branched alkyl group include a methyl group, an ethyl group, a propyl group, a butyl group, a pentyl group, a hexyl group, a heptyl group, an octyl group, a nonyl group, a decyl group, a dodecyl group, a tetradecyl group, an octadecyl group, an isopropyl group, an isobutyl group, a sec-butyl group, a t-butyl group, a 1-ethylpentyl group, and 2-ethylhexyl group. The cyclic alkyl group may be a monocyclic cyclic alkyl group or a polycyclic cyclic alkyl group. Examples of the monocyclic cyclic alkyl group include a cyclopropyl group, a cyclobutyl group, a cyclopentyl group, a cyclohexyl group, a cycloheptyl group, and a cyclooctyl group. Examples of the polycyclic cyclic alkyl group include an adamantyl group, a norbomyl group, a bornyl group, a

camphenyl group, a decahydronaphthyl group, a tricyclodecanyl group, a tetracyclodecanyl group, a camphoroyl group, a dicyclohexyl group, and a pinene group. Among them, in view of compatibility with high-sensitivity, a cyclohexyl group is most preferable. The alkyl group substituted with the following aromatic group is preferably a linear alkyl group substituted with an aromatic group.

Examples of the aromatic group include substituted or unsubstituted benzene rings, naphthalene rings, pentalene rings, indene rings, azulene rings, heptalene rings, an indacene rings, perylene rings, pentacene rings, acenaphthene rings, phenanthrene rings, anthracene rings, naphthacene rings, chrysene rings, triphenylene rings, fluorene rings, biphenyl rings, pyrrole rings, furan rings, thiophene rings, imidazole rings, oxazole rings, thiazole rings, pyridine rings, pyrazine rings, pyrimidine rings, pyridazine rings, indolizine rings, indole rings, benzofuran rings, benzothiophene rings, isobenzofuran rings, quinolizine rings, quinoline rings, phthalazine rings, naphthyridine rings, quinoxaline rings, quinoxazoline rings, isoquinoline rings, carbazole rings, phenanthridine rings, acridine rings, phenanthroline rings, thianthrene rings, chromene rings, xanthene rings, phenoxathiin rings, phenothiazine rings, or phenazine rings. A benzene ring is most preferable.

In Formula (2), in a case where $R^{113}$ is a hydrogen atom or in a case where $R^{114}$ is a hydrogen atom, the polyimide precursor may form counter salt with a tertiary amine compound having an ethylenically unsaturated bond. Examples of the tertiary amine compound having an ethylenically unsaturated bond include N,N-dimethylaminopropyl methacrylate.

In the case of alkali development, in view of improving the resolution, the polyimide precursor preferably has a fluorine atom in the structural unit. Owing to a fluorine atom, water repellency is provided to the surface of the film during alkali development, so that the penetration from the surface or the like can be suppressed. The content of the fluorine atom in the polyimide precursor is preferably 10 mass% or more and preferably 20 mass% or less in view of solubility to an aqueous alkaline solution.

In order to improve the adhesiveness to the substrate, an aliphatic group having a siloxane structure may be copolymerized. Specifically, examples of the diamine component include bis(3-aminopropyl) tetramethyldisiloxane and bis(p-aminophenyl) octamethylpentasiloxane.

The repeating unit represented by Formula (2) is preferably a repeating unit represented by Formula (2-1). That is, at least one of the heterocycle-containing polymer precursors used in the present invention is preferably a precursor having a repeating unit represented by Formula (2-1). According to the structure, it is possible to widen the width of the exposure latitude.

Formula (2-1)

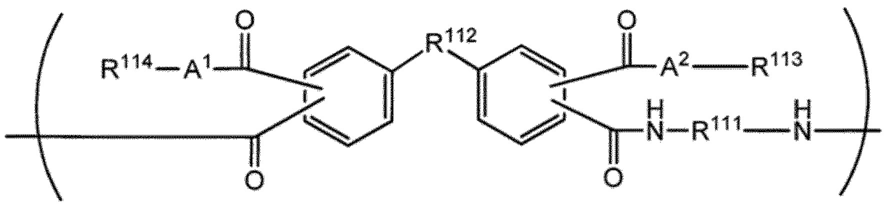

In Formula (2-1), $A^1$ and $A^2$ represent an oxygen atom, $R^{111}$ and $R^{112}$ each independently represent a divalent organic group, $R^{113}$ and $R^{114}$ each independently represent a hydrogen atom or a monovalent organic group, and at least one of $R^{113}$ or $R^{114}$ is a polymerizable group.

$A^1$, $A^2$, $R^{111}$, $R^{113}$, and $R^{114}$ are each independently the same as $A^1$, $A^2$, $R^{111}$, $R^{113}$, and $R^{114}$ in Formula (2), and the preferable ranges thereof are also the same.

$R^{112}$ is the same as $R^{112}$ in Formula (5), and a preferable range thereof is also the same.

The polyimide precursor may have one kind or two or more kinds of the repeating structural unit represented by Formula (2). The polyimide precursor may contain a structural isomer of the repeating unit represented by Formula (2). It is obvious that the polyimide precursor may include other kinds of repeating structural units, in addition to the repeating unit of Formula (2).

As one embodiment of the polyimide precursor according to the present invention, a polyimide precursor in which which the content of the repeating unit represented by Formula (2) is 50 mol% or more, more preferably 70 mol% or more, and particularly preferably 90 mol% or more with respect to the total repeating unit is exemplified.

«Polybenzoxazole precursor material»

The polybenzoxazole precursor material obtained by the manufacturing method of the present invention preferably includes a repeating unit represented by Formula (3).

Formula (3)

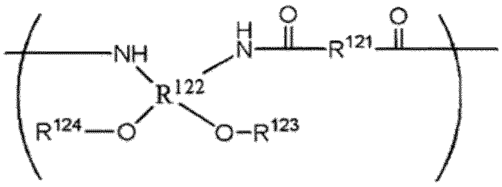

In Formula (3), $R^{121}$ represents a divalent organic group, $R^{122}$ represents a tetravalent organic group, and $R^{123}$ and $R^{124}$ each independently represent a hydrogen atom or a monovalent organic group.

In Formula (3), $R^{121}$ in Formula (2) represents a divalent organic group. The divalent organic group is preferably a group including at least one of the aliphatic group or the aromatic group. The aliphatic group is preferably a linear aliphatic group. As these preferable ranges, the aforementioned carboxylic acid residue is exemplified.

In Formula (3), $R^{122}$ represents a tetravalent organic group. The tetravalent organic group has the same as $R^{115}$ in Formula (2), and the preferable range thereof is also the same.

The polybenzoxazole precursor may include other kinds of repeating structural units, in addition to the repeating unit of Formula (3).

In view of suppressing the occurrence of warping due to ring closure, it is preferable to contain a diamine residue represented by Formula (SL) as other kinds of repeating structural units.

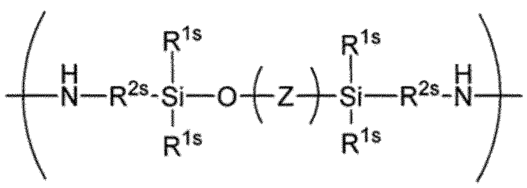

(SL)

a: 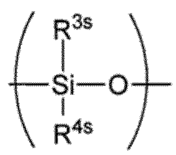 b: 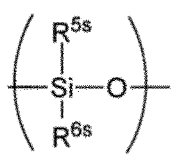

In Formula (SL), Z has an a structure and a b structure, $R^{1s}$ is a hydrogen atom or a hydrocarbon group having 1 to 10 carbon atoms, $R^{2s}$ is a hydrocarbon group having 1 to 10 carbon atoms, at least one of $R^{3s}$, $R^{4s}$, $R^{5s}$, or $R^{6s}$ is an aromatic group, the rest is a hydrogen atom or an organic group having 1 to 30 carbon atoms, and these may be identical to or different from each other. The polymerization of the a structure and the b structure may be the block polymerization or the random polymerization. In the Z portion, the a structure is 5 to 95 mol%, the b structure is 95 to 5 mol%, and a + b is 100 mol%.

In Formula (SL), as the preferable Z, for example, $R^{5s}$ and $R^{6s}$ in the b structure are phenyl groups. The molecular weight of the structure represented by Formula (SL) is preferably 400 to 4,000 and more preferably 500 to 3,000. The molecular weight may be obtained by the gel permeation chromatography generally used. In a case where the molecular weight is in the range, an effect of decreasing the modulus of elasticity of the polybenzoxazole precursor after dehydration ring closure so as to suppress warping and an effect of improving solubility may be obtained together.

In the case where a diamine residue represented by Formula (SL) is included as another kind of repeating structural unit, in view of improving the alkali solubility, it is preferable to include a tetracarboxylic acid residue remaining after removal of an anhydride group from tetracarboxylic acid dianhydride as a repeating structural unit. Examples of the tetracarboxylic acid residue include the examples of $R^{115}$ in Formula (2).

<<Acid group and acid value>>

The total number of the acid group which is included in the heterocycle-containing polymer precursor according to the present invention and in which pH of the neutralization point is in the range of 5.0 to 9.0 is preferably 2.5% or less, more preferably 2.0% or less, and even more preferably 1.5% or less with respect to the total number of the total repeating unit. The lower limit value is preferably 0% and may be 0.5% or more.

The acid group in which pH of the neutralization point is in the range of 5.0 to 9.0 is preferably an acid group in which pH of the neutralization point is in the range of 6.0 to 8.0. Specific examples of the acid group in which pH of

the neutralization point is in the range of 5.0 to 9.0 include a phosphoric acid group and a sulfonic acid group.

Particularly, according to the present invention, with respect to a total number of a terminal group represented by Formula (2-2) and a terminal group represented by Formula (3-2) which are included in the heterocycle-containing polymer precursor, a total number of the total repeating units is preferably in the above range.

Formula (2-2)

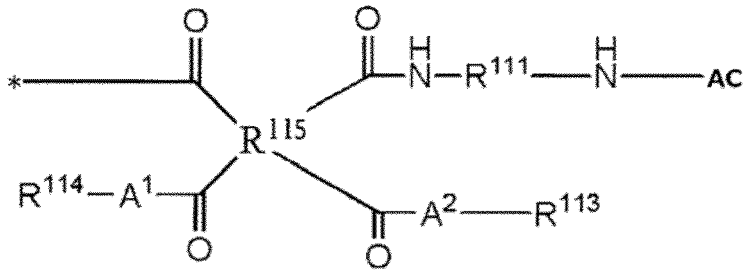

Formula (3-2)

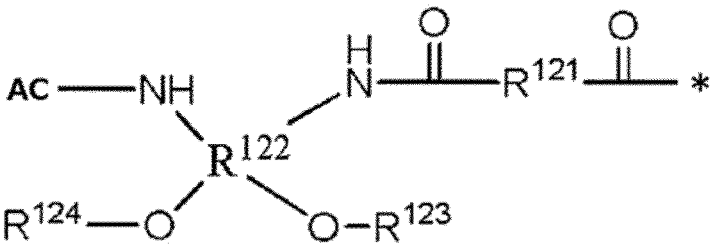

In Formula (2-2), $A^1$ and $A^2$ each independently represent an oxygen atom or NH.

$R^{111}$ represents a divalent organic group, $R^{115}$ represents a tetravalent organic group, $R^{113}$ and $R^{114}$ each independently represent a hydrogen atom or a monovalent organic group, AC represents an acid group having pH of a neutralization point in a range of 5.0 to 9.0, and * represents a bonding position to a main chain of a polyimide precursor; and In Formula (3-2), $R^{121}$ represents a divalent organic group, $R^{122}$ represents a tetravalent organic group, and $R^{123}$ and $R^{124}$ each independently represent a hydrogen atom or a monovalent organic group, AC represents an acid group having pH of the neutralization point in a range of 5.0 to 9.0, and * represents a bonding position to a main chain of a polybenzoxazole precursor.

In Formula (2-2), $A^1$, $A^2$, $R^{111}$, $R^{115}$, $R_{113}$, and $R^{114}$ are each independently the same as $A^1$, $A^2$, $R^{111}$, $R^{115}$, $R^{113}$, and $R^{114}$ in Formula (2), and the preferable ranges thereof are also the same.

In Formula (3-2), $R^{122}$, $R^{123}$, and $R^{124}$ are each independently the same as $R^{122}$, $R^{123}$, and $R^{124}$ in Formula (3), and the preferable ranges thereof are also the same.

According to the present invention, the heterocycle-containing polymer precursor is selected from a polyimide precursor material and a polybenzoxazole precursor material, and an acid value of an acid group in which pH of a neutralization point is preferably in the range of 5.0 to 9.0 is 4.0 mgKOH/g or less. The acid value is more preferably 3.0 mgKOH/g or less, and even more preferably 2.0 mgKOH/g or less. The lower limit value is preferably 0 mgKOH/g and may be 0.1 mgKOH/g or more.

According to this configuration, the cyclization rate becomes faster, and also it becomes easy to obtain a heterocycle-containing polymer precursor having an even weight-average molecular weight.

According to the present invention, for example, it is possible to obtain the heterocycle-containing polymer precursor having the weight-average molecular weight (Mw) of 5,000 to 100,000, more preferably 10,000 to 50,000, and particularly preferably 20,000 to 30,000. A number-average molecular weight (Mn) of the heterocycle-containing polymer precursor obtained by manufacturing method of the present invention is preferably 5,000 to 14,000, more preferably 6,000 to 10,000, and even more preferably 7,500 to 9,000. The degree of dispersion (Mw/Mn) is preferably 1.0 to 10.0, more preferably 1.1 to 5.0, and even more preferably 1.2 to 4.0.

The acid value of the heterocycle-containing polymer precursor, the amount of the acid group, the weight-average molecular weight, and the number-average molecular weight are measured by the method described in the following example.

Subsequently, the heterocycle-containing polymer precursor of the present invention is specifically described.

The heterocycle-containing polymer precursor of the present invention is a heterocycle-containing polymer

precursor selected from the polyimide precursor material and the polybenzoxazole precursor material, and an acid value of the acid group in which pH of the neutralization point is in the range of 5.0 to 9.0 is 4.0 mgKOH/g or less.

For example, the heterocycle-containing polymer precursor is preferably manufactured by the method of manufacturing the heterocycle-containing polymer precursor of the present invention.

The preferable range of the heterocycle-containing polymer precursor of the present invention is the same as the heterocycle-containing polymer precursor described in the section of the method of manufacturing of the heterocycle-containing polymer precursor of the present invention.

Subsequently, the composition of the present invention is specifically described.

The composition of the present invention includes the heterocycle-containing polymer precursor of the present invention. In a case where the composition of the present invention includes the heterocycle-containing polymer precursor, other components are not particularly determined, and other components may be appropriately formulated according to the application or the like. The composition of the present invention may include one heterocycle-containing polymer precursor or may include two or more kinds thereof.

The composition of the present invention preferably includes the heterocycle-containing polymer precursor, and the photopolymerization initiator and the composition is preferably used as a photosensitive resin composition. The photosensitive resin composition of the present invention is preferably used as a negative-type photosensitive resin composition. In a case where the photosensitive resin composition is used as the negative-type photosensitive resin composition, the polymerizable compound may be included. As the polymerizable compound, it is preferable to include a compound having an ethylenically unsaturated bond. A thermal polymerization initiator, a corrosion inhibitor, a thermal base generator, a polymerization inhibitor, and the like may be included.

The photosensitive resin composition of the present invention may be a positive-type photosensitive resin composition. Particularly, in a case where the photosensitive resin composition is a positive-type photosensitive resin composition, the heterocycle-containing polymer precursor preferably includes the polybenzoxazole precursor. Also in a case where the photosensitive resin composition is used as the positive-type photosensitive resin composition, the polymerizable compound may be included.

Without departing from the gist of the present invention, the composition used in the present invention may include polyimide and polybenzoxazole having a closed ring structure.

According to the composition of the present invention, the content of the heterocycle-containing polymer precursor is preferably 20 to 100 mass%, more preferably 50 to 99 mass%, even more preferably 70 to 98 mass%, and particularly preferably 80 to 95 mass% with respect to the total solid content of the composition.

Hereinafter, the component that may be included in the composition of the present invention is described below. The present invention may include components in addition to these, and it is obvious that these components are not essentially included.

<Photopolymerization initiator>

The composition of the present invention may contain the photopolymerization initiator. Particularly, in a case where the composition includes a photoradical polymerization initiator, a composition layer is formed by applying the composition to a semiconductor wafer or the like and irradiated with light, such that curing by radicals occurs, and the solubility in the light irradiated portion may be reduced. Therefore, for example, the composition layer is exposed via a photo mask having a pattern obtained by masking only the electrode portion, and thus there is an advantage that a region having different solubility may be easily manufactured according to the pattern of the electrode.

The photopolymerization initiator is not particularly limited as long as the photopolymerization initiator has a function of initiating the polymerization reaction (crosslinking reaction) of the polymerizable compound, and may be appropriately selected from the well-known photopolymerization initiators. For example, the photopolymerization initiator preferably has the photosensitivity to light from the ultraviolet region to the visible region. The photopolymerization initiator may be an activator which generates an active radical by some action with the photosensitized sensitizer.

The photopolymerization initiator preferably contains at least one compound having a molecular light absorption coefficient of at least about 50 in the range of about 300 to 800 nm (preferably 330 to 500 nm). The molecular light absorption coefficient of the compound may be measured by using the well-known method, and specifically, it is preferable to be measured by using an ethyl acetate solvent at a concentration of 0.01 g/L in an ultraviolet-visible spectrophotometer (Cary-5 spectrophotometer manufactured by Varian Inc.).

As the photopolymerization initiator, the well-known compound may be used without limitation, but examples thereof include a halogenated hydrocarbon derivative (for example, a derivative having a triazine skeleton, having an oxadiazole skeleton, or having a trihalomethyl group), an acylphosphine compound such as acylphosphine oxide, hexaarylbiimidazole, an oxime compound such as an oxime derivative, organic peroxide, a thio compound, a ketone compound, aromatic onium salt, keto oxime ether, an aminoacetophenone compound, hydroxyacetophenone, an azo-based compound, an azide compound, a metallocene compound, an organoboron compound, and an iron arene complex.

Examples of the halogenated hydrocarbon compound having a triazine skeleton include compounds disclosed in Bull. Chem. Soc. Japan, 42, 2924 (1969) written by Wakabayashi et al., compounds disclosed in GB1388492B, compounds disclosed in JP1978-133428A (JP-S53-133428A), compounds disclosed in DE3337024B, compounds disclosed in J. Org. Chem.; 29, 1527 (1964) by F. C. Schaefer et al., compounds disclosed in JP1987-58241A (JP-S62-58241A), compounds disclosed in JP1993-281728A (JP-H05-281728A), compounds disclosed in JP1993-34920A(JP-H05-34920A), and compounds disclosed in US4212976A.

Examples of the compounds disclosed in US4212976A include a compound having an oxadiazole skeleton (for example, 2-trichloromethyl-5-phenyl-1,3,4-oxadiazole, 2-trichloromethyl-5-(4-chlorophenyl)-1,3,4-oxadiazole, 2-trichloromethyl-5-(2-naphthyl)-1,3,4-oxadiazole, 2-tribromomethyl-5-phenyl-1,3,4-oxadiazole, 2-tribromomethyl-5-(2-naphthyl)-1,3,4-oxadiazole; 2-trichloromethyl-5-styryl-1,3,4-oxadiazole, 2-trichloromethyl-5-(4-chlorostyryl)-1,3,4-oxadiazole, 2-trichloromethyl-5-(4-methoxystyryl)-1,3,4-oxadiazole, 2-trichloromethyl-5-(1-naphthyl)-1,3,4-oxadiazole, 2-trichloromethyl-5-(4-n-butoxystyryl)-1,3,4-oxadiazole, and 2-tribromomethyl-5-styryl-1,3,4-oxadiazole).

Examples of the photopolymerization initiator in addition to the above include compounds disclosed in paragraph 0086 of JP2015-087611A, and compounds disclosed in JP1978-133428A (JP-S53-133428A), JP1982-1819B (JP-S57-1819B), JP1982-6096B (JP-S57-6096B), and US3615455A.

Examples of the ketone compound include compounds disclosed in paragraph 0087 of JP2015-087611A.

As the commercial products, KAYACURE DETX (Nippon Kayaku Co., Ltd.) is also preferably used.

As the photopolymerization initiator, a hydroxyacetophenone compound, an aminoacetophenone compound, and an acylphosphine compound may also be suitably used. More specifically, for example, an aminoacetophenone-based initiator disclosed in JP1998-291969A (JP-H10-291969A) and an acylphosphine oxide-based initiator disclosed in JP4225898B may be used.

As a hydroxyacetophenone-based initiator, IRGACURE-184 (IRGACURE is a registered trademark), DAROCUR-1173, IRGACURE-500, IRGACURE-2959, and IRGACURE-127 (trade name: all are manufactured by BASF SE) may be used.

As the aminoacetophenone-based initiator, IRGACURE-907, IRGACURE-369, and IRGACURE-379 (trade name: all are manufactured by BASF SE) which are commercially available products may be used.

As the aminoacetophenone-based initiator, compounds disclosed in JP2009-191179A in which an absorption wavelength is matched to a light source of 365 nm, 405 nm, or the like may also be used.

As the acylphosphine-based initiator, IRGACURE-819 or DAROCUR-TPO (trade name: all are manufactured by BASF SE) which are commercially available products may be used.

As the photopolymerization initiator, an oxime compound is more preferably exemplified. As specific examples of the oxime compound, compounds disclosed in JP2001-233842A, compounds disclosed in JP2000-80068A, and compounds disclosed in JP2006-342166A may be used.

Examples of the preferable oxime compound include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropane-1-one, 2-benzoyloxyimino-1-phenylpropane-1-one, 3-(4-toluenesulfonyloxy) iminobutan-2-one, and 2-ethoxycarbonyloxyimino-1-phenylpropane-1-one.

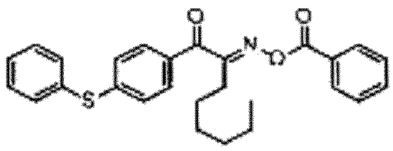

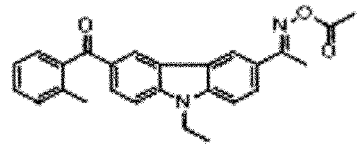

Examples of the oxime compound include compounds disclosed in each document of J. C. S. Perkin II (1979) pp. 1653 - 1660, J. C. S. Perkin II (1979) pp. 156 - 162, Journal of Photopolymer Science and Technology (1995) pp. 202 - 232, and compounds disclosed in JP2000-66385A, and compounds disclosed in JP2000-80068A, JP2004-534797A, and JPA 2006-342166.

As the commercially available products, IRGACURE OXE-01 (manufactured by BASF SE), IRGACURE OXE-02 (manufactured by BASF SE), and N-1919 (manufactured by ADEKA Corporation) are also appropriately used. TR-PBG-304 (manufactured by Changzhou Tronly New Electronics Materials Co., Ltd.), ADEKA ARKLS NCI-831, and ADEKA ARKLS NCI-930 (manufactured by ADEKA Corporation) may be used. TR-PBG-304 (manufactured by

Changzhou Tronly New Electronics Materials Co., Ltd.), ADEKA ARKLS NCI-831, and ADEKA ARKLS NCI-930 (manufactured by ADEKA Corporation) may be used.

A compound disclosed in JP2009-519904A in which oxime is linked to an N position of a carbazole ring, a compound disclosed in US7626957B in which a hetero substituent is introduced at a benzophenone moiety, a compound disclosed in JP2010-15025A and US2009-292039A in which a nitro group is introduced at a dye moiety, a ketoxime compound disclosed in US2009-131189A, a compound disclosed in US7556910B in which a triazine skeleton and an oxime skeleton are included in the same molecule, and a compound disclosed in JP2009-221114A which has an absorption maximum at 405 nm and has good sensitivity to a g-line light source may be used.

Cyclic oxime compounds disclosed in JP2007-231000A and JP2007-322744Amay be appropriately used. Among the cyclic oxime compounds, particularly, a cyclic oxime compound which is ring-condensed with carbazole dyes and which is disclosed in JP2010-32985A and JP2010-185072A has high light absorptivity and is preferable in view of high-sensitivity.

A compound disclosed in JP2009-242469A which is a compound having an unsaturated bond in a specific region of an oxime compound may be suitably used.

It is possible to use an oxime compound having a fluorine atom. Specific examples of the oxime compound include a compound disclosed in JP2010-262028A, Compounds 24 and 36 to 40 disclosed in paragraph 0345 of JP2014-500852A, and Compound (C-3) disclosed in paragraph 0101 of JP2013-164471A. Specific examples thereof include the following compounds.

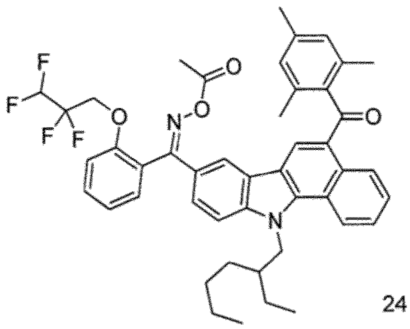

24

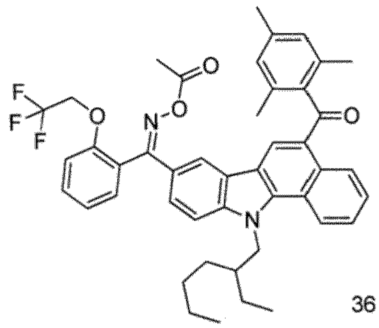

36

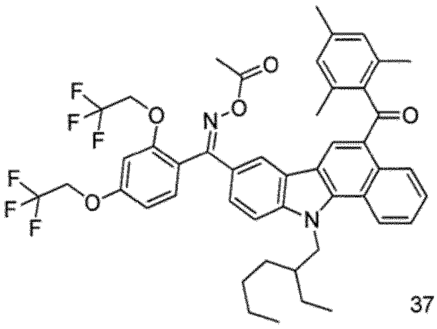

37

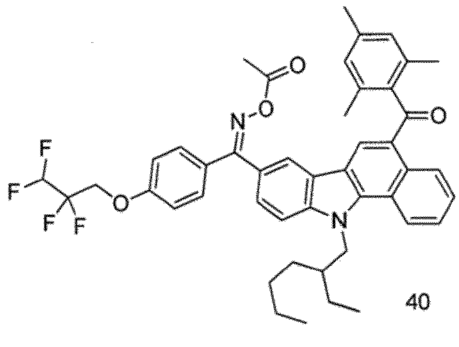

40

Examples of the most preferable oxime compound include an oxime compound having a specific substituent which is disclosed in JP2007-269779A and an oxime compound having a thioaryl group disclosed in JP2009-191061A.

In view of exposure sensitivity, the photopolymerization initiator is preferably a compound selected from the group consisting of a trihalomethyl triazine compound, a benzyl dimethyl ketal compound, an $\alpha$-hydroxy ketone compound, an $\alpha$-aminoketone compound, an acylphosphine compound, a phosphine oxide compound, a metallocene compound, an oxime compound, a triaryl imidazole dimer, an onium compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.

It is even more preferable that at least one compound selected from the group consisting of a trihalomethyl triazine compound, an $\alpha$-aminoketone compound, an acylphosphine compound, a phosphine oxide compound, an oxime compound, a triaryl imidazole dimer, an onium compound, a benzophenone compound, an acetophenone compound, a trihalomethyl triazine compound, an $\alpha$-aminoketone compound, an oxime compound, a triaryl imidazole dimer, and a benzophenone compound is most preferable, and an oxime compound is most preferably used.

In a case where the composition includes a photopolymerization initiator, the content of the photopolymerization

initiator is preferably 0.1 to 30 mass%, more preferably 0.1 to 20 mass%, and even more preferably 0.1 to 10 mass% with respect to the total solid content of the composition.

The photopolymerization initiators may be used singly, and two or more kinds thereof may be used. In a case where two or more kinds of the photopolymerization initiator are used, it is preferable that the sum thereof is in the above range.

<Polymerizable compound>

The composition of the present invention preferably contains the polymerizable compound. In a case where the polymerizable compound is contained, it is possible to form a cured film having more excellent heat resistance.

The polymerizable compound is a compound having a polymerizable group, and a well-known compound in which crosslinking reaction may be performed by radical, acid, base, and the like may be used. As the polymerizable group, the polymerizable groups described in the section of the heterocycle-containing polymer precursor are exemplified.

The compound having an ethylenically unsaturated bond used in the present invention is more preferably a compound including two or more ethylenically unsaturated groups.

For example, the polymerizable compound may be any one chemical form such as a monomer, a prepolymer, an oligomer, a mixture thereof, and a multimer thereof.

According to the present invention, a monomer-type polymerizable compound (hereinafter, also referred to as a polymerizable monomer) is a compound different from a polymer compound. The polymerizable monomer is typically a low molecular compound is typically and preferably a low molecular compound having a molecular weight of 2,000 or less, more preferably a low molecular compound having 1,500 or less, and even more preferably a low molecular compound having a molecular weight of 900 or less. The molecular weight of the polymerizable monomer is generally 100 or more.

The oligomer-type polymerizable compound is typically a polymer having a comparatively low molecular weight and is preferably a polymer to which 10 to 100 polymerizable monomers are bonded. As the molecular weight, a weight-average molecular weight in terms of polystyrene by a gel permeation chromatography (GPC) is preferably 2,000 to 20,000, more preferably 2,000 to 15,000, and most preferably 2,000 to 10,000.

The number of functional groups of the polymerizable compound according to the present invention means the number of the polymerizable groups in one molecule.

In view of the resolution, the polymerizable compound preferably includes at least one of difunctional or higher functional polymerizable compounds including two or more polymerizable groups and more preferably includes at least one trifunctional or higher functional polymerizable compound.

In view of forming the three dimensional crosslinking structure and improving the heat resistance, the polymerizable compound according to the present invention preferably includes at least one of trifunctional or higher functional polymerizable compound. The polymerizable compound may be a mixture of a difunctional or lower functional polymerizable compound and a trifunctional or higher functional polymerizable compound.

<<Compound having ethylenically unsaturated bond>>

The group having an ethylenically unsaturated bond is preferably a styryl group, a vinyl group, a (meth)acryloyl group, and a (meth)allyl group and more preferably a (meth)acryloyl group.

Specific examples of the compound having an ethylenically unsaturated bond include unsaturated carboxylic acid (for example, acrylic acid, methacrylic acid, itaconic acid, crotonic acid, isocrotonic acid, and maleic acid) and esters thereof, amides thereof, and a multimer thereof, and the compound having an ethylenically unsaturated bond is preferably ester of unsaturated carboxylic acid and a polyhydric alcohol compound, amides of unsaturated carboxylic acid and a polyvalent amine compound, and a multimer thereof. An addition reaction product of unsaturated carboxylic acid ester or amides having a nucleophilic substituent such as a hydroxy group, an amino group, or a mercapto group with monofunctional or polyfunctional isocyanates or epoxies or a dehydration condensation reaction product with monofunctional or polyfunctional carboxylic acid and the like is also preferably used. Unsaturated carboxylic acid ester or amides having an electrophilic substituent such as an isocyanate group or an epoxy group, an addition reaction product with monofunctional or polyfunctional alcohols, amines, or thiols, unsaturated carboxylic acid ester or amides having a releasable substituent such as a halogen group or a tosyloxy group, or a substitution reaction product with monofunctional or polyfunctional alcohols, amines, or thiols are also appropriate. As another example, instead of the unsaturated carboxylic acid, a vinyl benzene derivative such as unsaturated phosphonic acid or styrene, or a compound group substituted with vinyl ether, allyl ether, and the like may be used.

With respect to specific examples of the monomer of the ester of the polyhydric alcohol compound and the unsaturated carboxylic acid, examples of acrylic ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylol ethane triacrylate, hexanediol diacrylate, 1,4-cyclohexanediol diacrylate, tetraethylene glycol diacrylate, pentaerythritol diacrylate, pentaerythritol triacrylate, dipentaerythritol diacrylate, dipentaerythritol hexaacrylate, pentaerythritol tetraacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide modified triacrylate, and polyester acrylate oligomer.

Examples of the methacrylic acid ester include tetramethylene glycol dimethacrylate, triethylene glycol dimethacrylate, neopentyl glycol dimethacrylate, trimethylolpropane trimethacrylate, trimethylol ethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy) phenyl] dimethyl methane, and bis-[p-(methacryloxyethoxy) phenyl] dimethyl methane.

Examples of the itaconic acid ester, ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of the crotonic acid ester include ethylene glycol dicrotonate, tetramethylene glycol dicrotonate, pentaerythritol dicrotonate, and sorbitol tetradicrotonate.

Examples of the isocrotonic acid ester include ethylene glycol diisocrotonate, pentaerythritol diisocrotonate, and sorbitol tetraisocrotonate.

Examples of the maleate ester include ethylene glycol dimaleate, triethylene glycol dimaleate, pentaerythritol dimaleate, and sorbitol tetramaleate.

Examples of the other ester include aliphatic alcohol-based esters disclosed in JP1971-27926B (JP-S46-27926B), JP1976-47334B (JP-S51-47334B), and JP1982-196231A (JP-S57-196231A), esters having an aromatic skeleton disclosed in JP1984-5240A (JP-S59-5240A), JP1984-5241A (JP-S59-5241A), and JP1990-226149A (JP-H02-226149), and esters including an amino group disclosed in JP1989-165613A (JP-H01-165613A) may be preferably used.

Specific examples of the amide monomer of a polyvalent amine compound and unsaturated carboxylic acid include methylene bis-acrylamide, methylene bis-methacrylamide, 1,6-hexamethylene bis-acrylamide, 1,6-hexamethylene bis-methacrylamide, diethylenetriamine trisacrylamide, xylylene bisacrylamide, and xylylene bismethacrylamide.

Examples of other preferable amide-based monomer include a monomer having a cyclohexylene structure disclosed in JP1979-21726B (JP-S54-21726B).

A urethane-based addition polymerizable monomer manufactured by using addition reaction between isocyanate and a hydroxyl group is also preferable, and specific examples thereof include a vinyl urethane compound including two or more polymerizable vinyl groups in one molecule obtained by adding a vinyl monomer including a hydroxyl group represented by the following formula to a polyisocyanate compound having two or more isocyanate groups in one molecule as disclosed in JP1973-41708B (JP-S48-41708B).

$$CH_2 = C(R^4)COOCH_2CH(R^5)OH$$

(Here, $R^4$ and $R^5$ represent H or $CH_3$.)

Urethane acrylates disclosed in JP1976-37193A (JP-S51-37193A), JP1990-32293B (JP-H02-32293B), and JP1990-16765B (JP-H02-16765B) and urethane compounds having an ethylene oxide skeleton disclosed in JP1983-49860B (JP-S58-49860B), JP1981-17654B (JP-S56-17654B), JP1987-39417B (JP-S62-39417B), and JP1987-39418B (JP-S62-39418B) are also suitable.

As the compound having an ethylenically unsaturated bond, compounds disclosed in paragraphs 0095 to 0108 of JP2009-288705A may be appropriately used in the present invention.

As the compound having an ethylenically unsaturated bond, a compound having a boiling point of 100°C or higher under normal pressure is also preferable. Examples thereof include monofunctional acrylate and methacrylate such as polyethylene glycol mono(meth)acrylate, polypropylene glycol mono(meth)acrylate, and phenoxyethyl (meth)acrylate; those obtained by adding ethylene oxide or propylene oxide to polyfunctional alcohol and being (meth)acrylated such as polyethylene glycol di(meth)acrylate, trimethylol ethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylolpropane tri(acryloyloxypropyl) ether, and tri(acryloyloxyethyl) isocyanurate, glycerin, or trimethylol ethane, urethane (meth)acrylates disclosed in JP1973-41708B (JP-S48-41708B), JP1975-6034B (JP-S50-6034B), and JP1976-37193A (JP-S51-37193A), polyester acrylates disclosed in JP1973-64183A (JP-S48-64183A), JP1974-43191B (JP-S49-43191B), and JP1977-30490B (JP-S52-30490B), polyfunctional acrylate or methacrylate such as epoxy acrylates which are reaction products with an epoxy resin and (meth)acrylic acid, and a mixture thereof. Compounds disclosed in paragraphs 0254 to 0257 of JP2008-292970A are preferable. Examples thereof include polyfunctional (meth)acrylate that may be obtained by reacting polyfunctional

carboxylic acid with a compound having a cyclic ether group such as glycidyl (meth)acrylate and an ethylenically unsaturated group.

As the other preferable compound having an ethylenically unsaturated bond, a compound having two or more groups having a fluorene ring disclosed in JP2010-160418A, JP2010-129825A, and JP4364216B and having two or more ethylenically unsaturated bonds, and a cardo resin may be used.

Other examples thereof include specific unsaturated compounds disclosed in JP1971-43946B (JP-S46-43946B), JP1989-40337B (JP-H01-40337B), and JP1989-40336B (JP-H01-40336B) and vinyl phosphonic acid compounds disclosed in JP1990-25493A (JP-H02-25493A). In this case, a structure containing a perfluoroalkyl group disclosed in JP1986-22048A (JP-S61-22048A) is appropriately used. Those introduced as photopolymerizable monomers and oligomers introduced in the Journal of the Adhesion Society of Japan, vol. 20, No. 7, pages 300 to 308 (1984) may also be used.

In addition, a compound having an ethylenically unsaturated bond which is represented by Formulae (MO-1) to (MO-5) may be appropriately used. In the formulae, in a case where T is an oxyalkylene group, a terminal on the carbon atom side is bonded to R.

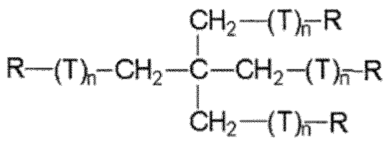

(MO-1)

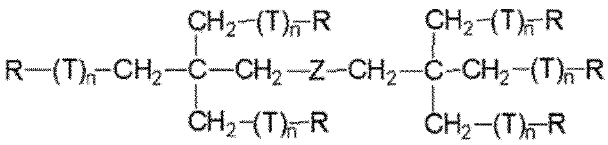

(MO-2)

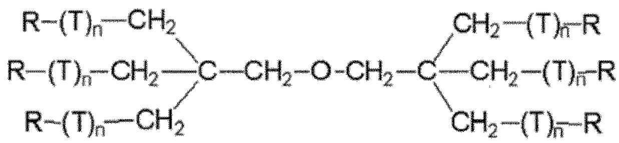

(MO-3)

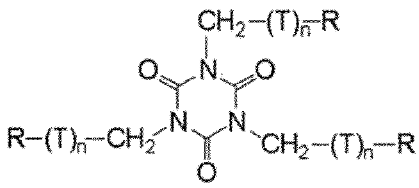

(MO-4)

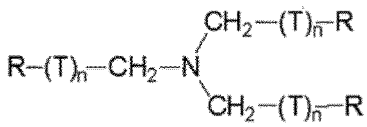

(MO-5)

R:

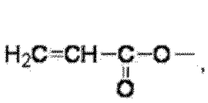, 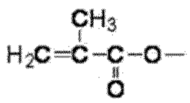, 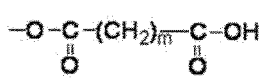, 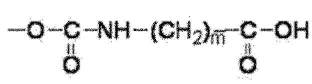, $-OH$,

$-CH_3$, 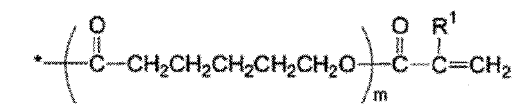

T: *-$(CH_2)_m$-*, -$OCH_2$-, -$OCH_2CH_2$-, -$OCH_2CH_2CH_2$-, -$OCH_2CH_2CH_2CH_2$-, -O(CO)-$(CH_2)_m$-, -COO-$(CH_2)_m$-, -$OCH(CH_3)$-$CH_2$-, -$OCH_2CH(CH_3)$-, -O-
Z: -O- ,

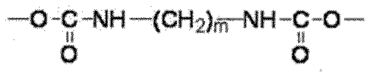

In the formula, n is an integer of 0 to 14, and m is an integer of 0 to 8. A plurality of R's and T's that are present in one molecule may be identical to or different from each other.

In each of the polymerizable compounds represented by Formulae (MO-1) to (MO-5), at least one of the plurality of R's represent a group represented by -OC(=O)CH=$CH_2$, or -OC(=O)C($CH_3$)=$CH_2$.

As the specific examples of the compound having an ethylenically unsaturated bond which is represented by Formulae (MO-1) to (MO-5), compounds disclosed in paragraphs 0248 to 0251 of JP2007-269779A may be appropriately used in the present invention.

Compounds obtained by adding ethylene oxide or propylene oxide to polyfunctional alcohols and being (meth)acrylated which are disclosed in JP1998-62986A (JP-H10-62986A) as Formulae (1) and (2) together with the specific examples thereof may be also used as polymerizable compounds.

Compounds disclosed in paragraphs 0104 to 0131 of JP2015-187211A may be employed. Particularly, compounds disclosed in paragraphs 0128 to 0130 of JP2015-187211A are exemplified as preferable embodiments.

The compound having an ethylenically unsaturated bond is preferably a structure in which dipentaerythritol triacrylate (as a commercially available product, KAYARAD D-330; manufactured by Nippon Kayaku Co., Ltd.), dipentaerythritol tetraacrylate (as a commercially available product, KAYARAD D-320; manufactured by Nippon Kayaku Co., Ltd.), dipentaerythritol penta(meth)acrylate (as a commercially available product, KAYARAD D-310; manufactured by Nippon Kayaku Co., Ltd.), dipentaerythritol hexa(meth)acrylate (as a commercially available product, KAYARAD DPHA; manufactured by Nippon Kayaku Co., Ltd.), and a (meth)acryloyl group thereof are bonded via ethylene glycol and a propylene glycol residue. Oligomer types thereof may be used.

Pentaerythritol derivatives and/or dipentaerythritol derivatives of Formulae (MO-1) and (MO-2) are provided as preferable examples.

Commercially available products of the polymerizable compound include SR-494 which is a tetrafunctional acrylate having four ethyleneoxy chains manufactured by Sartomer, DPCA-60 which is hexafunctional acrylate having six pentyleneoxy chains manufactured by Nippon Kayaku Co., Ltd., TPA-330 which is trifunctional acrylate having three isobutylene oxy chains, urethane oligomers UAS-10 and UAB-140 (manufactured by Nippon Paper Industries Co., Ltd.), NK ESTER M-40G, NK ESTER 4G, NK ESTER M-9300, NK ESTER A-9300, and UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, and AI-600 (manufactured by Kyoeisha Chemical Co., Ltd.), and BLEMMER PME400 (manufactured by NOF Corporation).

As the compound having an ethylenically unsaturated bond, urethane acrylates of JP1973-41708B (JP-S48-41708B), JP1976-37193A (JP-S51-37193A), JP1990-32293B (JP-H02-32293B), JP1990-16765B (JP-H02-16765B) and a urethane compound having an ethylene oxide skeleton which is disclosed in JP1983-49860B (JP-S58-49860B), JP1981-17654B (JP-S56-17654B), JP1987-39417B (JP-S62-39417B), and JP1987-39418B (JP-S62-39418B) are also appropriate. As the polymerizable compound, addition polymerizable monomers having an amino structure or a sulfide structure in the molecule which are disclosed in JP1988-277653A (JP-S63-277653A), JP1988-260909A (JP-S63-260909A), and JP1989-105238A (JP-H01-105238A) are used.

The compound having an ethylenically unsaturated bond may be a polyfunctional monomer having an acid group such as a carboxyl group, a sulfonic acid group, and a phosphoric acid group. The polyfunctional monomer having an acid group is preferably ester of an unsaturated carboxylic acid and an aliphatic polyhydroxy compound, more preferably a polyfunctional monomer obtained by causing nonaromatic carboxylic anhydride to react with an unreacted hydroxy group of an aliphatic polyhydroxy compound so as to have an acid group, and particularly preferably ester in which an aliphatic polyhydroxy compound is pentaerythritol and /or dipentaerythritol. Examples of the commercially available product include M-510 and M-520 as a polybasic acid modified acrylic oligomer manufactured by Toagosei Co., Ltd.

The polyfunctional monomer having an acid group may be used singly, and two or more kinds thereof may be used in a mixture. If necessary, a polyfunctional monomer not having an acid group and a polyfunctional monomer having an acid group may be used in combination.

The acid value of the polyfunctional monomer having an acid group is preferably 0.1 to 40 mgKOH/g and particularly preferably 5 to 30 mgKOH/g. In a case where the acid value of the polyfunctional monomer is in the above range, the manufacturing and handling properties are excellent, and further developability is excellent. The polymerizability is favorable.

Examples of the polymerizable compound having a caprolactone structure include DPCA-20 (compound in which m = 1, the number of groups represented by Formula (D) = 2, and $R^1$ are all hydrogen atoms in Formulae (C) to (E)), DPCA-30 (compound in which m = 1, the number of groups represented by Formula (D) = 3, and $R^1$ are all hydrogen atoms in the same formulae), DPCA-60 (compound in which m = 1, the number of groups represented by Formula (D) = 6, and $R^1$ are all hydrogen atoms in the same formulae), and DPCA-120 (compound in which m = 2, the number of groups represented by Formula (D) = 6, and $R^1$ are all hydrogen atoms in the same formulae), which are commercially available from Nippon Kayaku Co., Ltd. as KAYARAD DPCA series.

According to the present invention, the compound having a caprolactone structure and an ethylenically unsaturated bond may be used singly or two or more kinds thereof may be used in combination.

In view of favorable polymerizability and heat resistance, the content of the compound having an ethylenically unsaturated bond in the composition is preferably 1 to 50 mass% with respect to the total solid content of the composition. The lower limit is more preferably 5 mass% or more. The upper limit is more preferably 30 mass% or less. The compound having an ethylenically unsaturated bond may be used singly and two or more kinds thereof may be used in a mixture.

A mass ratio (heterocycle-containing polymer precursor/polymerizable compound) between the heterocycle-containing polymer precursor and the compound having an ethylenically unsaturated bond is preferably 98/2 to 10/90, more preferably 95/5 to 30/70, and most preferably 90/10 to 50/50. In a case where the mass ratio of the heterocycle-containing polymer precursor and the compound having an ethylenically unsaturated bond is in the above range, it is possible to form a cured film having excellent polymerizability and heat resistance.

<<Compound having hydroxymethyl group, alkoxymethyl group, or acyloxymethyl group>>

The compound having a hydroxymethyl group, an alkoxymethyl group, or an acyloxymethyl group is preferably a compound represented by Formula (AM1).

(AM1)

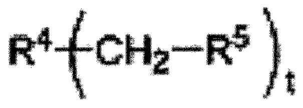

(In the formula, t represents an integer of 1 to 20, $R^4$ represents a t-valent organic group having 1 to 200 carbon atoms, and $R^5$ represents a group represented by Formula (AM2) or (AM3).)

Formula (AM2) Formula (AM3)

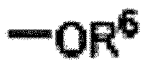

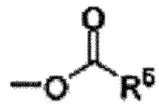

(In the formula, $R^6$ represents a hydroxyl group or an organic group having 1 to 10 carbon atoms.)

The compound represented by Formula (AM1) is preferably 5 parts by mass to 40 parts by mass with respect to 100 parts by mass of the heterocycle-containing polymer precursor. 10 parts by mass to 35 parts by mass is even more preferable. In the entire polymerizable compound, it is preferable to contain 10 mass% to 90 mass% of the compound represented by Formula (AM4) and contain 10 mass% to 90 mass% of the compound represented by Formula (AM5) in the total thermal crosslinking agent.

(AM4)

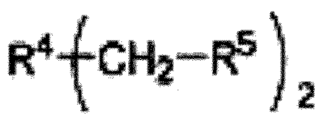

(In the formula, $R^4$ represents a divalent organic group having 1 to 200 carbon atoms, and $R^5$ represents a

group represented by Formula (AM2) or (AM3).)

(AM5)

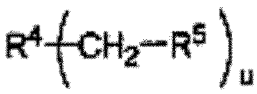

(In the formula, u represents an integer of 3 to 8, $R^4$ represents a u-valent organic group having 1 to 200 carbon atoms, and $R^5$ represents a group represented by Formula (AM2) or (AM3).)

Formula (AM2) **$-OR^6$**

Formula (AM3)

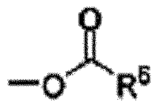

(In the formula, $R^6$ represents a hydroxyl group or an organic group having 1 to 10 carbon atoms.)

According to the content in the above range, in a case where the composition layer is formed on the uneven substrate, less cracks are generated. The composition has excellent pattern workability and may have high heat resistance in which the 5% weight loss temperature is 350°C or higher and more preferably 380°C or higher. Specific examples of the compound represented by Formula (AM4) include 46DMOC and 46DMOEP (above are trade names manufactured by Asahi Yukizai Corporation), DML-MBPC, DML-MBOC, DML-OCHP, DML-PCHP, DML-PC, DML-PTBP, DML-34X, DML-EP, DML-POP, dimethylolBisOC-P, DML-PFP, DML-PSBP, and DML-MTrisPC (above are trade names, manufactured by Honshu Chemical Industry Co., Ltd.), NIKALAC MX-290 (trade name, manufactured by Samwa Chemical Co., Ltd.), and 2,6-dimethoxymethyl-4-t-buthylphenol, 2,6-dimethoxymethyl-p-cresol, and 2,6-diacethoxymethyl-p-cresol.

Specific examples of the compound represented by Formula (AM5) include TriML-P, TriML-35XL, TML-HQ, TML-BP, TML-pp-BPF, TML-BPA, TMOM-BP, HML-TPPHBA, HML-TPHAP, HMOM-TPPHBA, and HMOM-TPHAP (above are trade names, manufactured by Honshu Chemical Industry Co., Ltd.), TM-BIP-A (trade name, manufactured by Asahi Yukizai Corporation), NIKALAC MX-280, NIKALAC MX-270, and NIKALAC MW-100LM (above are trade names, manufactured by Samwa Chemical Co., Ltd.).

<<Epoxy compound (compound having epoxy group)>>

As the epoxy compound, a compound having two or more epoxy groups in one molecule is preferable. With respect to the epoxy group, crosslinking reaction is performed at 200°C or lower, dehydration reaction by crosslinking does not occur, and thus film shrinkage hardly occurs. Therefore, the inclusion of an epoxy compound is effective for low temperature curing and low warping of the composition.

The epoxy compound preferably contains a polyethylene oxide group. Accordingly, the modulus of elasticity decreases, and warping can be further reduced. Since flexibility is high, a cured film also having excellent elongation and the like may be obtained. The polyethylene oxide group means that the number of repeating units of ethylene oxide is 2 or more and the number of repeating units is preferably 2 to 15.

Examples of the epoxy compound include bisphenol A type epoxy resin; bisphenol F type epoxy resin; an alkylene glycol type epoxy resin such as propylene glycol diglycidyl ether; a polyalkylene glycol type epoxy resin such as polypropylene glycol diglycidyl ether; and epoxy group-containing silicone such as polymethyl (glycidyloxypropyl) siloxane, but the present invention is not limited thereto. Specifically, examples thereof include EPICLON (registered trademark) 850-S, EPICLON (registered trademark) HP-4032, EPICLON (registered trademark) HP-7200, EPICLON (registered trademark) HP-820, EPICLON (registered trademark) HP-4700, EPICLON (registered trademark) EXA-4710, EPICLON (registered trademark) HP-4770, EPICLON (registered trademark) EXA-859CRP, EPICLON (registered trademark) EXA-1514, EPICLON (registered trademark) EXA-4880, EPICLON (registered trademark) EXA-4850-150, EPICLON EXA-4850-1000, EPICLON (registered trademark) EXA-4816, and EPICLON (registered trademark) EXA-4822

(above are trade names manufactured by DIC Corporation), RIKARESIN (registered trademark) BEO-60E (trade name, New Japan Chemical Co., Ltd.), and EP-4003S and EP-4000S (above are trade names, ADEKA Corporation). Among these, an epoxy resin containing a polyethylene oxide group is preferable in view of excellent heat resistance and low warping. For example, EPICLON (registered trademark) EXA-4880, EPICLON (registered trademark) EXA-4822, and RIKARESIN (registered trademark) BEO-60E contain polyethylene oxide groups and thus are preferable.

The epoxy compound is preferably 5 to 50 parts by mass, more preferably 10 to 50 parts by mass, and even more preferably 10 to 40 parts by mass with respect to 100 parts by mass of the heterocycle-containing polymer precursor. In a case where the formulation amount is 5 parts by mass or more, warping of the cured film may be further suppressed, and in a case where the formulation amount is 50 parts by mass or less, the pattern filling due to reflow in a case of curing may be further suppressed.

<<Oxetane compound (compound having oxetanyl group)>>

Examples of the oxetane compound include a compound having two or more oxetane rings in one molecule, 3-ethyl-3-hydroxymethyloxetane, 1,4-bis{[(3-ethyl-3-oxetanyl) methoxy] methyl} benzene, 3-ethyl-3-(2-ethylhexylmethyl) oxetane, and 1,4-benzenedicarboxylic acid-bis[(3-ethyl-3-oxetanyl) methyl] ester. As a specific example, the ARON OXETANE series (for example, OXT-121, OXT-221, OXT-191, and OXT-223) manufactured by Toagosei Co., Ltd. may be appropriately used, and these may be used singly or two or more kinds thereof may be used in a mixture.

The content of the oxetane compound is preferably 5 to 50 parts by mass, more preferably 10 to 50 parts by mass, and even more preferably 10 to 40 parts by mass with respect to 100 parts by mass of the heterocycle-containing polymer precursor.

<<Benzoxazine compound (compound having benzoxazolyl group)>>

The benzoxazine compound is preferable, because the benzoxazine compound performs crosslinking reaction by ring opening addition reaction, degassing due to curing does not occur, shrinkage due to heat is small, and thus occurrence of warpage may be suppressed.

Preferable examples of the benzoxazine compound include B-a type benzoxazine and B-m type benzoxazine (above are trade names manufactured by Shikoku Chemicals Corporation), A benzoxazine adduct of a polyhydroxystyrene resin, and phenol novolak type dihydrobenzoxazine compound. These may be used singly or two or more kinds thereof may be used in a mixture.

The content of the benzoxazine compound is preferably 5 to 50 parts by mass, more preferably 10 to 50 parts by mass, and even more preferably 10 to 40 parts by mass with respect to 100 parts by mass of the heterocycle-containing polymer precursor.

<Resin including phenolic OH group>

In a case where the composition of the present invention is an alkaline developable positive composition, it is preferable to include a resin including a phenolic OH group, in view of adjusting the solubility in an alkali developer and obtaining favorable sensitivity.

Preferable examples of the resin including a phenolic OH group include a novolak resin and a polyhydroxystyrene resin.

«Novolak resin»

The novolak resin may be obtained by polycondensing phenols and aldehydes by a well-known method. Two or more kinds of the novolak resins may be used in combination.

Preferable examples of the phenols include phenol, o-cresol, m-cresol, p-cresol, 2,3-xylenol, 2,5-xylenol, 3,4-xylenol, 3,5-xylenol, 2,3,5-trimethylphenol, and 3,4,5-trimethylphenol. Particularly, phenol, m-cresol, p-cresol, 2,3-xylenol, 2,5-xylenol, 3,4-xylenol, 3,5-xylenol, and 2,3,5-trimethylphenol are preferable. Two or more kinds of these phenols be used in combination. In view of solubility to an alkaline developer, m-cresol is preferable, and a combination of m-cresol and p-cresol is also preferable. That is, as the novolak resin, it is preferable to include an m-cresol residue or a cresol novolak resin including a m-cresol residue and a p-cresol residue. At this point, a molar ratio (m- cresol residue/p-cresol residue, m/p) of a m-cresol residue and a p-cresol residue in the cresol novolak resin is preferably 1.8 or more. In a case where the molar ratio is in this range, appropriate solubility in an alkaline developer may be exhibited, and thus favorable sensitivity may be obtained. The molar ratio is more preferably 4 or more.

Preferable examples of the aldehydes include formalin, paraformaldehyde, acetaldehyde, benzaldehyde, hydroxybenzaldehyde, and chloroacetaldehyde. Two or more kinds of these aldehydes may be used.

A wholly aromatic type novolak resin obtained by polycondensation with an acid catalyst using a compound represented by Formula (Phe) as phenols and a compound represented by Formula (Ald) as aldehydes is preferable in view of providing high heat resistance to a cured film of the composition of the present invention.

Formula (Phe)

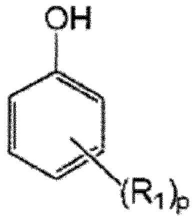

In Formula (Phe), $R^1$ represents an organic group selected from an alkyl group having 1 to 20 carbon atoms and an alkoxy group, p is an integer of 1 to 3 and is preferably an integer of 2 to 3.

Formula (Ald)

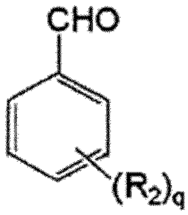

In Formula (Ald), $R_2$ represents a group selected from a hydrogen atom, an alkyl group having 1 to 20 carbon atoms, an alkoxy group, and a hydroxy group, and q is an integer of 0 to 3.

As the phenol compound represented by Formula (Phe), a phenol compound having 1 to 3 substituents and preferably having 2 to 3 substituents is used, and the substituent is an organic group selected from an alkyl group having 1 to 20 carbon atoms and an alkoxy group. Specific examples of the alkyl group having 1 to 20 carbon atoms and the alkoxy group including a methyl group, an ethyl group, a propyl group, a methoxy group, and an ethoxy group. As the phenol compound, for example, it is preferable to use o-cresol, m-cresol, p-cresol, 2,3-dimethylphenol, 2,4-dimethylphenol, 2,5-dimethylphenol, 3,4-dimethylphenol, 3,5-dimethylphenol, 2-methyl-3-ethyl-phenol, 2-methyl-3-methoxyphenol, 2,3,4-trimethylphenol, 2,3,5-trimethylphenol, and 2,3,6-trimethylphenol. Among these, the present invention is not particulary limited, but the phenol compound is preferably selected from 2,3-dimethylphenol, 2,4-dimethylphenol, 2,5-dimethylphenol, 3,4-dimethylphenol, 3,5-dimethylphenol, and 2,6-dimethylphenol. The phenols may be used singly or two or more kinds thereof may be used in combination.

In a case where a phenol compound having 1 to 3 and preferably 2 to 3 substituents is used, intramolecular rotation is suppressed, and thus a phenol resin having sufficient heat resistance necessary for the composition may be obtained.

Examples of the aromatic aldehyde compound represented by Formula (Ald) include an unsubstituted aromatic aldehyde compound or an aromatic aldehyde compound having 3 or less substituents, and the substituent is an organic group selected from an alkyl group having 1 to 20 carbon atoms, an alkoxy group, and a hydroxy group. Specific examples of the alkyl group having 1 to 20 carbon atoms and the alkoxy group including a methyl group, an ethyl group, a propyl group, a methoxy group, and an ethoxy group. As the aromatic aldehyde compound, for example, benzaldehyde, 2-methylbenzaldehyde, 3-methylbenzaldehyde, 4-methylbenzaldehyde, 2,3-dimethylbenzaldehyde, 2,4-dimethylbenzaldehyde, 2,5-dimethylbenzaldehyde, 2,6-dimethylbenzaldehyde, 3,4-dimethylbenzaldehyde, 3,5-dimethylbenzaldehyde, 2,3,4-trimethylbenzaldehyde, 2,3,5-trimethylbenzaldehyde, 2,3,6-trimethylbenzaldehyde, 2,4,5-trimethylbenzaldehyde, 2,4,6-trimethylbenzaldehyde, 3,4,5-trimethylbenzaldehyde, 4-ethylbenzaldehyde, 4-tert-butylbenzaldehyde, 4-isobutylbenzaldehyde, 4-methoxybenzaldehyde, salicylaldehyde, 3-hydroxybenzaldehyde, 4-hydroxybenzaldehyde, 3-methylsalicylaldehyde, 4-methylsalicylaldehyde, 2-hydroxy-5-methoxybenzaldehyde, 2,4-dihydroxybenzaldehyde, 2,5-dihydroxybenzaldehyde, and 2,3,4-trihydroxybenzaldehyde may be used, and the present invention is not limited thereto. However, among these, $R_2$ in Formula (Ald) is preferably an aromatic aldehyde compound which is a hydrogen atom, a methyl group, and a hydroxy group and is more preferably a compound selected from aromatic aldehyde compounds provided below. Aldehydes may be used singly or two or more kinds thereof may be used in a mixture.

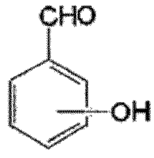

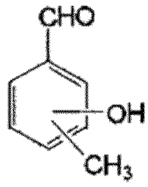

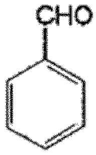

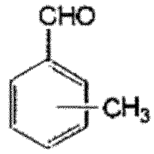

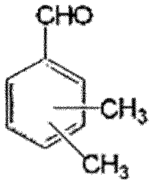

The weight-average molecular weight (Mw) of the novolak resin in terms of polystyrene is preferably 1,000 or more and more preferably 2,000 or more. The weight-average molecular weight is also preferably 5,000 or less. In a case where the weight-average molecular weight is in this range, the favorable sensitivity may be obtained.

The content of the novolak resin is preferably 1 part by mass to 70 parts by mass and more preferably 10 parts by mass to 70 parts by mass with respect to 100 parts by mass of the heterocycle-containing polymer precursor. In a case where the content is in this range, it is possible to obtain a pattern that has high-sensitivity and that does not flow after the heat treatment at high temperature. The novolak resin may be used singly or two or more kinds thereof may be used in combination. In a case where two or more kinds of novolak resins are used, it is preferable that the total amount is in the above range.

«Polyhydroxystyrene resin»

A hydroxystyrene resin is a polymer including hydroxystyrene and/or a derivative thereof, and is not particularly limited. However, the hydroxystyrene resin may be a copolymer including hydroxystyrene and/or a derivative thereof and a monomer in addition to these. Examples of the monomer used here include ethylene, propylene, 1-butene, 2-methylpropene, styrene, and a derivative thereof. Among these, in view of easily adjusting solubility to an alkaline solution, a copolymer including hydroxystyrene and/or derivative thereof and styrene and/or a derivative thereof are preferable. The derivative is obtained by substituting an alkyl group, an alkoxy group, a hydroxy group, or the like at the ortho, meta, para positions of an aromatic ring of hydroxystyrene and styrene. The hydroxystyrene of the hydroxystyrene resin may be any one of orthohydroxystyrene, metahydroxystyrene, or parahydroxystyrene. A plurality of kinds of mentioned hydroxystyrene may be mixed.

The constitutional ratio of hydroxystyrene and a derivative thereof in the hydroxystyrene resin is preferably 50% or more, more preferably 60% or more, preferably 90% or less, and more preferably 80% or less. In a case where the constitutional ratio is in the range, an effect of being excellent in the compatibility between reduction of the post exposure residues and high-sensitivity of the exposed portions is exhibited.

Among these, a hydroxystyrene resin having a repeating structural unit represented by Formula (PHS-1) is preferable.

Formula (PHS-1)

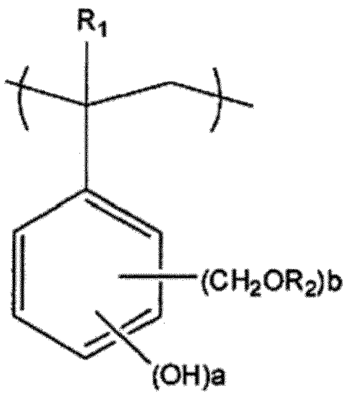

In Formula (PHS-1), $R_1$ represents a hydrogen atom or an alkyl group having 1 to 5 carbon atoms, a represents 1 to 4, b represents 1 to 3, and a + b is in the range of 1 to 5. $R_2$ represents an atom or a group selected from a hydrogen atom, a methyl group, an ethyl group, or a propyl group.

Addition reaction of an alkoxy group to a portion of a polymer or a copolymer obtained by polymerizing one or more kinds of aromatic vinyl compounds having a phenolic hydroxyl group such as p-hydroxystyrene, m-hydroxystyrene, o-hydroxystyrene, p-isopropenylphenol, m-isopropenylphenol, and o-isopropenylphenol and aromatic vinyl compounds of styrene, o-methylstyrene, m-methylstyrene, and p-methylstyrene by a known method may be performed by a known method so as to obtain the structural unit represented by Formula (PHS-1).

p-hydroxystyrene and/or m-hydroxystyrene is preferably used as the aromatic vinyl compound having a phenolic hydroxyl group, and styrene is preferably as an aromatic vinyl compound.

Among the hydroxystyrene resin having a repeating structural unit represented by Formula (PHS-1), a copolymer including a structural unit represented by Formulae (PHS-2), (PHS-3), and (PHS-4) is preferable, in view of further improving sensitivity and convenience to adjust solubility in an alkaline developer. In view of solubility to an alkaline developer, a structural unit of Formula (PHS-4) is preferably 50 mol% or less.

Formula (PHS-2)

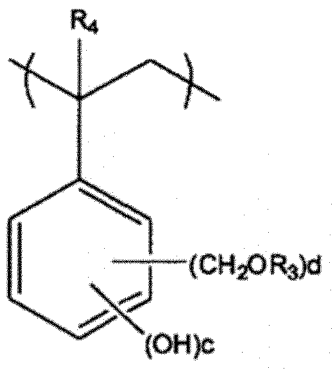

In Formula (PHS-2), $R_4$ represents a hydrogen atom or an alkyl group having 1 to 5 carbon atoms, c represents 1 to 4, d represents 1 to 3, and c + d represents in the range of 2 to 5. $R_3$ represents an atom or a group selected from a hydrogen atom, a methyl group, an ethyl group, or a propyl group.

Formula (PHS-3)

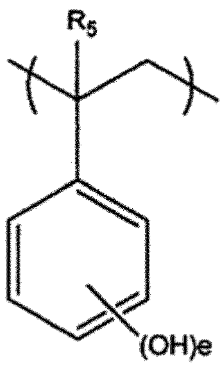

In Formula (PHS-3), $R_5$ represents a hydrogen atom or an alkyl group having 1 to 5 carbon atoms, and e represents 1 to 5.

Formula (PHS-4)

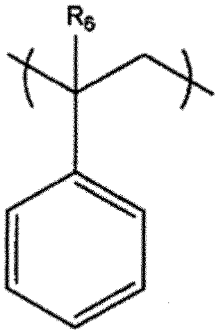

In Formula (PHS-4), $R_6$ represents a hydrogen atom or an alkyl group having 1 to 5 carbon atoms.

The weight-average molecular weight (Mw) of the hydroxystyrene resin is preferably 1,000 or more, more preferably 2,000 or more, particularly preferably 2,500 or more, preferably 10,000 or less, more preferably 8,000 or less, and particularly preferably 7,000 or less. In a case where the weight-average molecular weight is in the range, an effect of excellent compatibility between high-sensitivity and room temperature preservability of varnish is exhibited.

The content of the hydroxystyrene resin is preferably 1 parts by mass to 70 parts by mass and more preferably 10 parts by mass to 70 parts by mass with respect to 100 parts by mass of the heterocycle-containing polymer precursor. In a case where the content is in this range, it is possible to obtain a pattern that has high-sensitivity and that does not flow after the heat treatment at high temperature. The hydroxystyrene resin may be used singly and two or more kinds thereof may be used. In a case where two or more kinds of novolak resins are used, it is preferable that the total amount is in the above range.

<Thermal base generator>

The composition of the present invention may include a thermal base generator.

The kinds of the thermal base generator are not particularly limited, but it is preferable to include a thermal base generator including at least one selected from an acidic compound that generates a base in a case of being heated to 40°C or higher and ammonium salt that has an anion having pKa 1 of 0 to 4 and an ammonium cation. Here, pKa1 represents the logarithmic display (-Log10Ka) of a dissociation constant (Ka) of a first proton of a polyvalent acid.

In a case where the compound is formulated, the cyclization reaction of the polyimide precursor is performed at a low temperature, and thus it is possible to obtain a composition having more excellent stability. Since the thermal base generator does not generate a base in a case of not being heated, and thus in a case where the thermal base generator coexists with the polyimide precursor, cyclization of the polyimide precursor in the preservation may be suppressed, and thus preservation stability is excellent.

The thermal base generator according to the present invention includes at least one selected from an acidic compound (A1) that generates a base in a case of being heated to 40°C or higher and an ammonium salt (A2) having an anion having pKa1 of 0 to 4 and an ammonium cation.

Since the acidic compound (A1) and the ammonium salt (A2) generate a base in a case of being heated, the cyclization reaction of the polyimide precursor may be promoted by a base generated from these compounds, and the cyclization of the polyimide precursor may be performed at a low temperature. Even in a case where these compounds are caused to coexist with a polyimide precursor that is cured by being cyclized by a base, the cyclization of the polyimide precursor does not proceed, in a case of not being heated. Therefore, it is possible to prepare a polyimide precursor composition having excellent stability.

According to the present specification, with respect to the acidic compound, 1 g of a compound is taken into a container, 50 mL of a liquid mixture of ion exchange water and tetrahydrofuran (mass ratio is water/tetrahydrofuran = 1 / 4) is added, and stirring is performed for one hour at high temperature. The acidic compound means a compound in which a value measured with the solution by using a pH meter at 20°C is less than 7.

According to the present invention, the base generation temperature of the acidic compound (A1) and the ammonium salt (A2) is preferably 40°C or higher and more preferably 120°C to 200°C. The upper limit of the base generation temperature is preferably 190°C or lower, more preferably 180°C or lower, and even more preferably 165°C or lower. The lower limit of the base generation temperature is preferably 130°C or higher and more preferably 135°C or higher.

In a case where the base generation temperature of the acidic compound (A1) and the ammonium salt (A2) is 120°C or higher, a base is hardly generated during preservation, and thus it is possible to prepare a polyimide precursor

composition having excellent stability. In a case where the base generation temperature of the acidic compound (A1) and the ammonium salt (A2) is 200°C or lower, the cyclization temperature of the polyimide precursor may be decreased. For example, with respect to the base generation temperature, the compound is heated in a pressure capsule to 250°C at 5°C/min, by using differential scanning calorimetry, the peak temperature of the lowest temperature exothermic peak is read, the peak temperature may be measured as the base generation temperature.

According to the present invention, the base that is generated by the thermal base generator is preferably secondary amine or tertiary amine and more preferably tertiary amine. Since tertiary amine has high basicity, it is possible to decrease the cyclization temperature of the polyimide precursor. The boiling point of the base that is generated by the thermal base generator is preferably 80°C or higher, more preferably 100°C or higher, and most preferably 140°C or higher. The molecular weight of the generated base is preferably 80 to 2,000. The lower limit is more preferably 100 or more. The upper limit is more preferably 500 or less. The value of the molecular weight is a theoretical value obtained by the structural formula.

According to the present invention, the acidic compound (A1) preferably includes one or more kinds selected from ammonium salt and a compound represented by Formula (101) or (102).

According to the present invention, the ammonium salt (A2) is preferably an acidic compound. The ammonium salt (A2) may be a compound including an acidic compound that generates a base in a case of being heated to 40°C or higher (preferably 120°C to 200°C) and may be a compound except for an acidic compound that generates a base in a case of being heated to 40°C or higher (preferably 120 to 200°C).

<<Ammonium salt>>

According to the present invention, the ammonium salt means an ammonium cation represented by Formula (101) or (102) and a salt of an anion. The anion may be bonded via a covalent bonding to any of ammonium cations or may be outside the molecule of an ammonium cation but is preferably outside the molecule of an ammonium cation. The expression "an anion is outside the molecule of an ammonium cation" refers to a case where an ammonium cation and an anion are not bonded via a covalent bonding. Hereinafter, an anion outside the molecule of the cation moiety is also called a counter anion.

Formula (101) Formula (102)

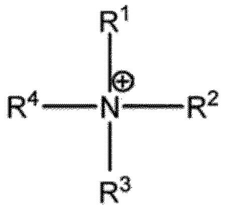

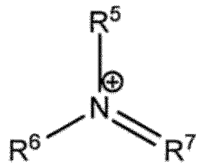

In the formula, $R^1$ to $R^6$ each independently represent a hydrogen atom or a hydrocarbon group, and $R^7$ represents a hydrocarbon group. $R^1$ and $R^2$, $R^3$ and $R^4$, $R^5$ and $R^6$, and $R^5$ and $R^7$ are respectively bonded to each other to form rings.

The ammonium cation is preferably represented by any one of Formulae (Y1-1) to (Y1-5).

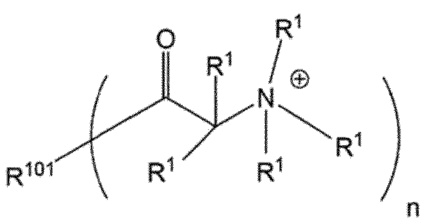

(Y1-1)

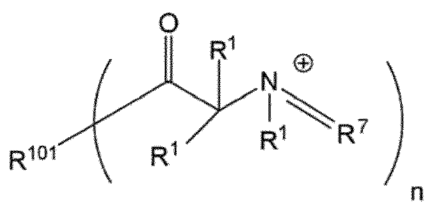

(Y1-2)

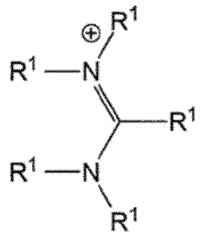

(Y1-3)

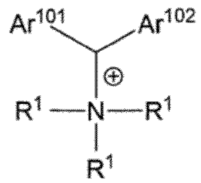

(Y1-4)

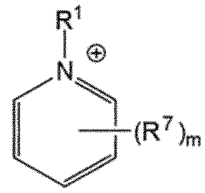

(Y1-5)

In the formula, $R^{101}$ represents an n-valent organic group, and $R^1$ and $R^7$ are the same as those in Formula (101) or (102).

$Ar^{101}$ and $Ar^{102}$ each independently represent an aryl group,
n represents an integer of 1 or more, and
m represents an integer of 0 to 5.

According to the present invention, the ammonium salt preferably has an anion having pKa1 of 0 to 4 and an ammonium cation. The upper limit of pKa1 of an anion is more preferably 3.5 or less and even more preferably 3.2 or less. The lower limit is preferably 0.5 or more and more preferably 1.0 or more. In a case where pKa1 of an anion is in the range, the polyimide precursor may be cyclized at a low temperature, and the stability of the polyimide precursor composition may be improved. In a case where pKa1 is 4 or less, the stability of the thermal base generator is favorable, the generation of a base without heating may be suppressed, and thus stability of the polyimide precursor composition is favorable. In a case where pKa1 is 0 or more, the generated base is hardly neutralized, the cyclization efficiency of the polyimide precursor is favorable.

The type of the anion is preferably one selected from a carboxylate anion, a phenol anion, a phosphate anion, and a sulfate anion and is more preferably a carboxylate anion for the reason of compatibility between stability of salt and heat decomposability. That is, ammonium salt is more preferably a salt of an ammonium cation and a carboxylate anion.

The carboxylate anion is preferably an anion of divalent or higher valent carboxylic acid having two or more carboxyl groups and is more preferably an anion of divalent carboxylic acid. According to this aspect, it is possible to obtain a thermal base generator that may improve the stability, the curability, and the developability of a polyimide precursor composition. Particularly, in a case where an anion of divalent carboxylic acid is used, it is possible to further improve the stability, the curability, and the developability of the polyimide precursor composition may be further developed.

According to the present invention, the carboxylate anion is preferably an anion of carboxylic acid in which pKa1 is 4 or less. pKa1 is more preferably 3.5 or less and even more preferably 3.2 or less. According to this aspect, it is possible to further improve the stability of the polyimide precursor composition.

Here, pKa1 represents the logarithm of the reciprocal of the first dissociation constant of the acid, and values disclosed in Determination of Organic Structures by Physical Methods (writer: Brown, H. C., McDaniel, D. H., Hafliger, O., Nachod, F. C.; editor: Braude, E. A., Nachod, F. C.; Academic Press, New York, 1955), and Data for Biochemical Research (writer: Dawson, R. M. C. et al; Oxford, Clarendon Press, 1959) may be referred to. With respect to the compounds not disclosed in these documents, values calculated from the structural formula by using software of ACD/pKa (manufactured by ACD/Labs) are used.

According to the present invention, a carboxylate anion is preferably represented by Formula (X1).

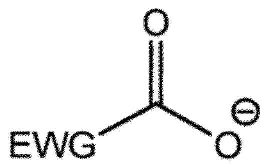

(X1)

In Formula (X1), EWG represents an electron withdrawing group.

The electron withdrawing group of the present invention means a value in which the Hammett' substituent constant σm is a positive value. Here, σm is described in detail in the review by TSUNO Yuho, Journal of the Society of Synthetic Organic Chemistry, Japan, Vol. 23, No. 8 (1965), p. 631 to 642. The electron withdrawing group of the

present invention is not limited to the substituents disclosed in these documents.

Examples of the substituent in which σm represents a positive value include a $CF_3$ group (σm = 0.43), a $CF_3CO$ group (σm = 0.63), a HC = C group (σm = 0.21), a $CH_2$=CH group (σm = 0.06), an Ac group (σm = 0.38), a MeOCO group (σm = 0.37), a MeCOCH=CH group (σm = 0.21), a PhCO group (σm = 0.34), and a $H_2NCOCH_2$ group (σm = 0.06). Me represents a methyl group, Ac represents an acetyl group, and Ph represents a phenyl group.

According to the present invention, EWG preferably represents a group represented by Formulae (EWG-1) to (EWG-6).

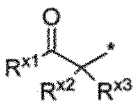
(EWG-1)

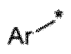
(EWG-2)

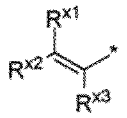
(EWG-3)

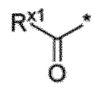
(EWG-4)

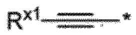
(EWG-5)

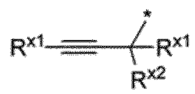
(EWG-6)

In the formula, $R^{x1}$ to $R^{x3}$ each independently represent a hydrogen atom, an alkyl group, an alkenyl group, an aryl group, a hydroxy group, or a carboxyl group, and Ar represents an aromatic group.

According to the present invention, a carboxylate anion is preferably represented by Formula (X).

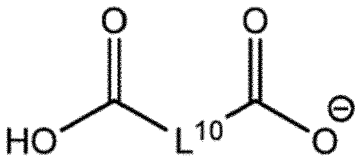
(X)

In Formula (X), $L^{10}$ represents a single bond or a divalent linking group selected from an alkylene group, an alkenylene group, an arylene group,-$NR^X$-, and a combination thereof, and $R^X$ represents a hydrogen atom, an alkyl group, an alkenyl group, or an aryl group.

Specific examples of the carboxylate anion include a malate anion, a phthate anion, an N-phenyliminodiacetate anion, and an oxalate anion. These may be preferably used.

Hereinafter, examples of the thermal base generator are provided.

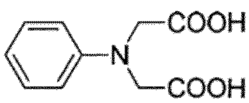
(A-1)

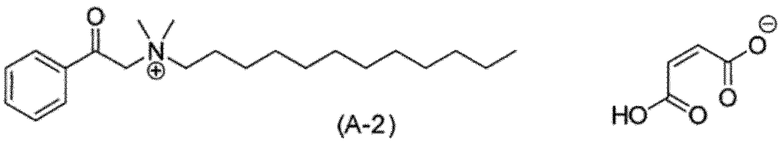
(A-2)

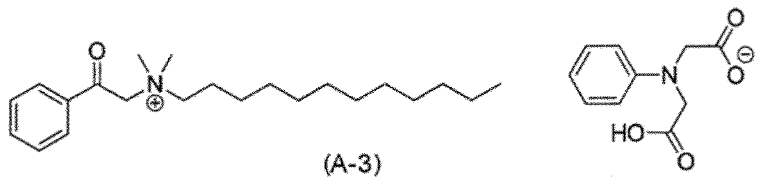
(A-3)

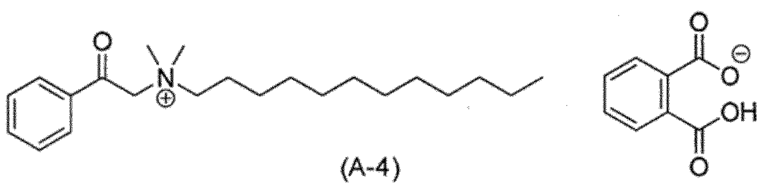
(A-4)

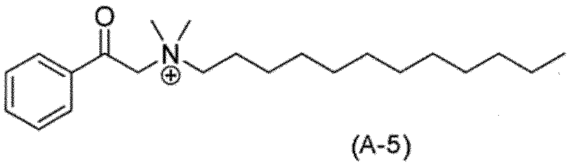
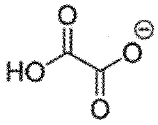

(A-5)

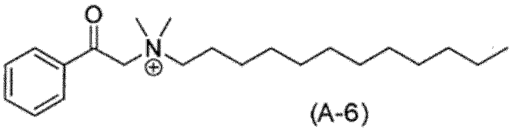
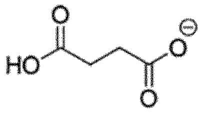

(A-6)

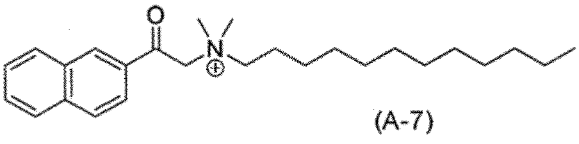
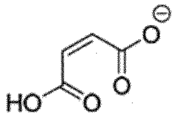

(A-7)

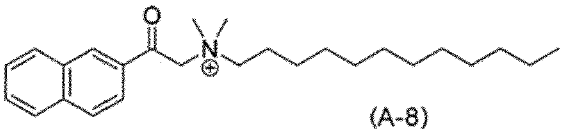
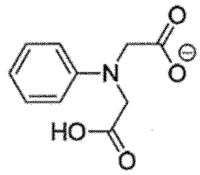

(A-8)

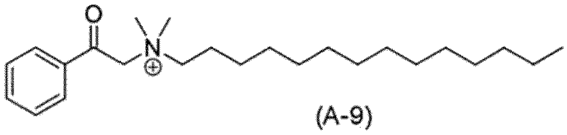
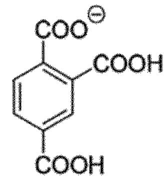

(A-9)

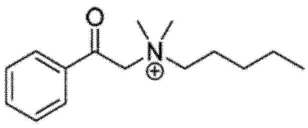
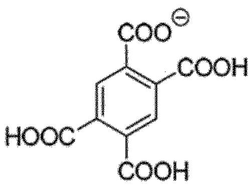

(A-10)

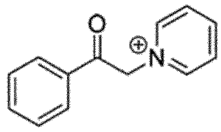
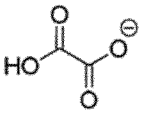

(A-11)

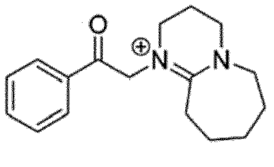
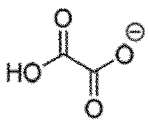

(A-12)

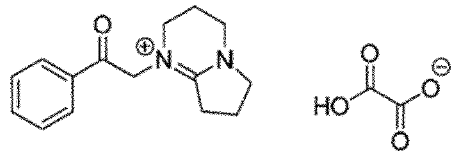
(A-13)

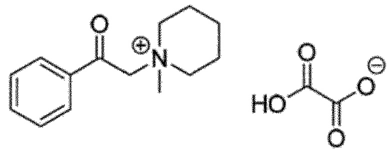
(A-14)

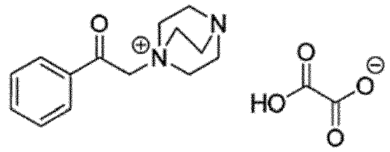
(A-15)

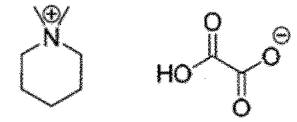
(A-16)

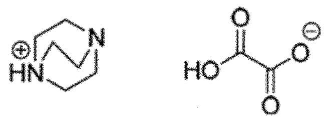
(A-17)

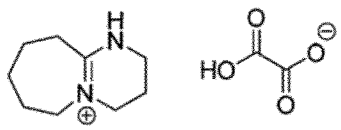
(A-18)

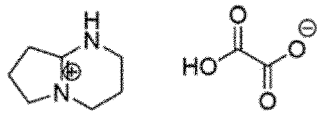
(A-19)

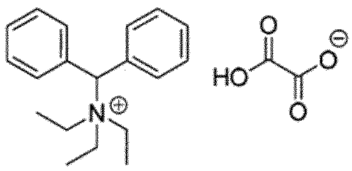
(A-20)

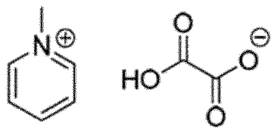
(A-21)

In a case where a thermal base generator is used, the content of the thermal base generator in the composition is preferably 0.1 to 50 mass% with respect to the total solid content of the composition. The lower limit is more preferably 0.5 mass% or more and even more preferably 1 mass% or more. The upper limit is more preferably 30 mass% or less and even more preferably 20 mass% or less.

The thermal base generator may be used singly and two or more kinds thereof may be used. In a case where two or more kinds are used, the total amount is preferably in the range.

<Photoacid generator>

The composition of the present invention may contain a photoacid generator. In a case where the photoacid generator is contained, acid is generated in an exposed portion, the solubility of the exposed portion to an aqueous alkaline solution increases, and thus the composition may be used as a positive-type photosensitive resin composition.

Examples of the photoacid generator include a quinone diazide compound, sulfonium salt, phosphonium salt, diazonium salt, and iodonium salt. Among them, a quinone diazide compound is preferably used in view of exhibiting an excellent solubility restraint effect and capable of obtaining a positive composition with high sensitivity and low film loss. Two or more kinds of photoacid generators may be contained. Accordingly, it is possible to increase dissolution rates of an exposed portion and an unexposed portion, and thus it is possible to obtain a positive-type photosensitive resin composition with high-sensitivity.

Examples of the quinone diazide compound include a compound in which sulfonic acid of quinonediazide is ester bonded to a polyhydroxy compound, a compound in which sulfonic acid of quinonediazide is sulfonamide bonded to a polyamino compound, and a compound in which sulfonic acid of quinone diazide is ester bonded and/or sulfonamide bonded to a polyhydroxy polyamino compound. In a case where a quinone diazide compound is used, it is possible to obtain a positive-type photosensitive resin composition sensitive to i rays (wavelength 365 nm), h rays (wavelength 405 nm), and g rays (wavelength 436 nm) of a mercury lamp which are general ultraviolet rays. All of the functional groups of these polyhydroxy compounds, polyamino compounds, and polyhydroxy polyamino compounds may not be substituted with quinone diazide, but it is preferable that two or more functional groups per molecule are substituted with quinone diazide.

For example, the following compounds are exemplified.

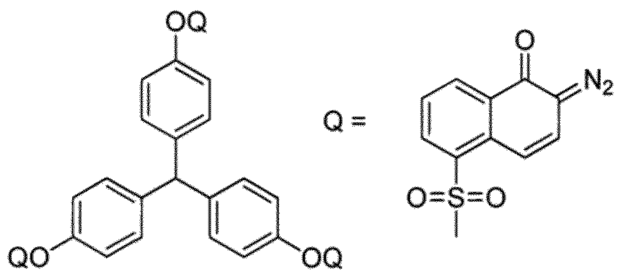

Q =

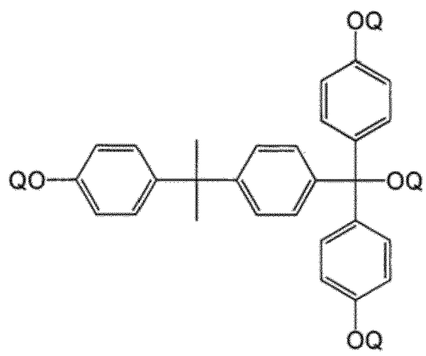

In the compound, 1 to 10% of the entire Q may be hydrogen atoms, and 4 to 6% thereof may be hydrogen atoms.

Examples of polyhydroxy compound include Bis-Z, BisP-EZ, TekP-4HBPA, TrisP-HAP, TrisP-PA, TrisP-SA, TrisOCR-PA, BisOCHP-Z, BisP-MZ, BisP-PZ, BisP-IPZ, BisOCP-IPZ, BisP-CP, BisRS-2P, BisRS-3P, BisP-OCHP, methylene tris-FR-CR, BisRS-26X, DML-MBPC, DML-MBOC, DML-OCHP, DML-PCHP, DML-PC, DML-PTBP, DML-34X, DML-EP,DML-POP, dimethylol-BisOC-P, DML-PFP, DML-PSBP, DML-MTrisPC, TriML-P, TriML-35XL, TML-BP, TML-HQ, TML-pp-BPF, TML-BPA, TMOM-BP, HML-TPPHBA, and HML-TPHAP (above are trade names manufactured by Honshu Chemical Industry Co., Ltd.), BIR-OC, BIP-PC, BIR-PC, BIR-PTBP, BIR-PCHP, BIP-BIOC-F, 4PC, BIR-BIPC-F, TEP-BIP-A, 46DMOC, 46DMOEP, and TM-BIP-A (above are trade names, manufactured by Asahi Yukizai Corporation), 2,6-dimethoxymethyl-4-t-butylphenol, 2,6-dimethoxymethyl-p-cresol, 2,6-diacetoxymethyl-p-cresol, naphthol, tetrahydroxybenzophenone, gallic acid methyl ester, bisphenol A, bisphenol E, methylene bisphenol, BisP-AP (trade name, manufactured by Honshu Chemical Industry Co., Ltd.), and a novolak resin, but the present invention is not limited thereto.

Examples of the polyamino compound include 1,4-phenylenediamine, 1,3-phenylenediamine, 4,4'-diaminodiphenyl ether, 4,4'-diaminodiphenylmethane, 4,4'-diaminodiphenyl sulfone, and 4,4'-diaminodiphenyl sulfide, but the present invention is not limited thereto.

Examples of the polyhydroxypolyamino compound include 2,2-bis(3-amino-4-hydroxyphenyl) hexafluoropropane, and 3,3'-dihydroxybenzidine.

As the quinone diazide compound, all of a compound having a 5-naphthoquinone diazide sulfonyl group and a compound having a 4-naphthoquinone diazide sulfonyl group are preferably used. Compounds having both of these groups in the same molecule may be used, or compounds using different groups may be used in combination.

Examples of the method for manufacturing the quinone diazide compound include a method of causing 5-naphthoquinonediazide sulfonyl chloride to react with a phenol compound in presence of triethylamine. Examples of the method of synthesizing a phenol compound include a method of causing an $\alpha$-(hydroxyphenyl) styrene derivative to react with a polyvalent phenol compound under an acid catalyst.

The content of the photoacid generator is preferably 3 to 40 parts by mass with respect to 100 parts by mass of the heterocycle-containing polymer precursor. In a case where the content of the photoacid generator in the range, high-sensitivity may be obtained. A sensitizer may be contained, if necessary.

The photoacid generator may be used singly and two or more kinds thereof may be used in combination. In a case where two or more kinds of novolak resins are used, it is preferable that the total amount is in the above range.

<Thermal acid generator>

The composition of the present invention may include a thermal acid generator. The thermal acid generator generates acid by heating has an effect of promoting crosslinking reaction of at least one compound selected from a compound having a hydroxymethyl group, an alkoxymethyl group, or an acyloxymethyl group, an epoxy compound, an oxetane compound, and a benzoxazine compound, in addition to promoting cyclization of the heterocycle-containing polymer precursor and improving mechanical characteristics of the cured film.

The thermal decomposition starting temperature of the thermal acid generator is preferably 50°C to 270°C and more preferably 250°C or lower. In a case where the non-generation of the acid during drying (prebaking: about 70°C to 140°C) after the substrate is coated with the composition and the generation of the acid during final heating (cure: about 100°C to 400°C) after patterning by subsequent exposure and development are selected, it is possible to suppress the decrease in sensitivity during development, and thus the selection is preferable.

The acid generated from the thermal acid generator is preferably strong acid, and arylsulfonic acid such as p-toluenesulfonic acid and benzenesulfonic acid, an alkyl sulfonic acid such as methanesulfonic acid, ethanesulfonic acid, and butane sulfonic acid, and haloalkylsulfonic acid such as trifluoromethanesulfonic acid are preferable. Examples of the thermal acid generator include those disclosed in paragraph 0055 of JP2013-072935A.

Among these, from the viewpoint that there are fewer residues in the cured film and the physical properties of the cured film are not deteriorated, it is more preferable to generate alkyl sulfonic acid having 1 to 4 carbon atoms and haloalkyl sulfonic acid having 1 to 4 carbon atoms, methanesulfonic acid (4-hydroxyphenyl) dimethylsulfonium, methanesulfonic acid (4-((methoxycarbonyl) oxy) phenyl) dimethylsulfonium, benzyl methanesulfonate (4-hydroxyphenyl) methylsulfonium, benzyl methanesulfonate (4-((methoxycarbonyl) oxy) phenyl) methylsulfonium, methanesulfonic acid (4-hydroxyphenyl) methyl ((2-methylphenyl) methyl) sulfonium, trifluoromethanesulfonic acid (4-hydroxyphenyl) dimethylsulfonium, trifluoromethanesulfonic acid (4-((methoxycarbonyl) oxy) phenyl) dimethylsulfonium, benzyl (4-hydroxyphenyl) methylsulfonium trifluoromethanesulfonate, benzyl trifluoromethanesulfonate (4-((methoxycarbonyl) oxy) phenyl) methylsulfonium, trifluoromethanesulfonic acid (4-hydroxyphenyl) methyl ((2-methylphenyl) methyl) sulfonium, 3-(5-(((propylsulfonyl) oxy) imino) thiophene-2-(5H)-ylidene)-2-(o-tolyl) propanenitrile, and 2,2-bis(3-(methanesulfonylamino)-4-hydroxyphenyl) hexafluoropropane is preferable.

The compounds disclosed in paragraphs 0059 of JP2013-167742A are preferable as the thermal acid generator.

The content of the thermal acid generator is preferably 0.01 parts by mass or more and more preferably 0.1 parts by mass or more with respect to 100 parts by mass of the heterocycle-containing polymer precursor. In a case where the content is 0.01 parts by mass or more, the crosslinking reaction and the cyclization of the heterocycle-containing polymer precursor are promoted, and thus the mechanical properties and chemical resistance of the cured film may be further improved. In view of electrical insulating properties of the cured film, the content is preferably 20 parts by mass or less, more preferably 15 parts by mass or less, and even more preferably 10 parts by mass or less.

The thermal acid generator may be used singly and two or more kinds thereof may be used. In a case where two or more kinds of novolak resins are used, it is preferable that the total amount is in the above range.

<Thermal polymerization initiator>

The composition of the present invention may include a thermal polymerization initiator (preferably thermal radical polymerization initiator). As the thermal radical polymerization initiator, well-known thermal radical polymerization

initiators may be used.

The thermal radical polymerization initiator is a compound that generates radicals by the energy of heat and initiates or promotes the polymerization reaction of the polymerizable compound. In a case where the cyclization reaction of the heterocycle-containing polymer precursor progresses by adding the thermal radical polymerization initiator, the polymerization reaction of the polymerizable compound may progress. In a case where the heterocycle-containing polymer precursor includes an ethylenically unsaturated bond, the polymerization reaction of the heterocycle-containing polymer precursor may progress together with the cyclization of the heterocycle-containing polymer precursor, and thus higher heat resistance may be achieved.

Examples of the thermal radical polymerization initiator include aromatic ketone, an onium salt compound, peroxide, a thio compound, a hexaarylbiimidazole compound, a keto oxime ester compound, a borate compound, an azinium compound, a metallocene compound, an active ester compound, a compound having a carbon halogen bond, and an azo-based compound. Among these, peroxide or azo-based compound is more preferable, and peroxide is particularly preferable.

With respect to the thermal radical polymerization initiator used in the present invention, the 10 hour half-life temperature is preferably 90°C to 130°C and more preferably 100°C to 120°C.

Specific examples thereof include compounds disclosed in paragraphs 0074 to 0118 of JP2008-63554A.

As commercially available products, PERBUTYL Z and PERCUMYL D (manufactured by NOF Corporation) may be appropriately used.

In a case where the composition has a thermal radical polymerization initiator, the content of the thermal radical polymerization initiator is preferably 0.1 to 50 mass%, more preferably 0.1 to 30 mass%, particularly preferably 0.1 to 20 mass% with respect to the total solid content of the composition. The content of the thermal radical polymerization initiator is preferably 0.1 to 50 parts by mass and more preferably 0.5 to 30 parts by mass with respect to 100 parts by mass of the polymerizable compound. According to this aspect, it is easy to form a cured film having excellent heat resistance.

The thermal radical polymerization initiator may be used singly and two or more kinds thereof may be used in combination. In a case where two or more kinds of the thermal radical polymerization initiators are used, it is preferable that the total amount thereof is in the range.

<Corrosion inhibitor>

It is preferable to add a corrosion inhibitor to the composition of the present invention. The corrosion inhibitor is added for the purpose of preventing the outflow of ions from the metal wiring, as the compound, for example, rust inhibitors disclosed in paragraph 0094 of JP2013-15701A, compounds disclosed in paragraphs 0073 to 0076 of JP2009-283711A, compounds disclosed in paragraph 0052 of JP2011-59656A, and compounds disclosed in paragraphs 0114, 0116, and 0118 of JP2012-194520A may be used. Among these, a compound having a triazole ring or a compound having a tetrazole ring may be preferably used, and 1,2,4-triazole, 1,2,3-benzotriazole, 5-methyl-1H-benzotriazole, 1H-tetrazole, and 5-methyl-1H-tetrazole are more preferable, and 1H- tetrazole is most preferable.

The formulating amount of the corrosion inhibitor is preferably in the range of 0.1 to 10 parts by mass, more preferably in the range of 0.2 to 5 parts by mass with respect to 100 parts by mass of the heterocycle-containing polymer precursor.

The corrosion inhibitor may be used singly and two or more kinds thereof may be used. In a case where two or more kinds of novolak resins are used, it is preferable that the total amount is in the above range.

<Metal adhesiveness improver>

The composition of the present invention preferably includes a metal adhesiveness improver for improving the adhesiveness to a metal material used in electrodes, wiring, and the like. Examples of the metal adhesiveness improver include a sulfide-based compound disclosed in paragraphs 0046 to 0049 of JP2014-186186A or paragraphs 0032 to 0043 of JP2013-072935A. As the metal adhesiveness improver, the following compounds are also exemplified. Et is an ethyl group.

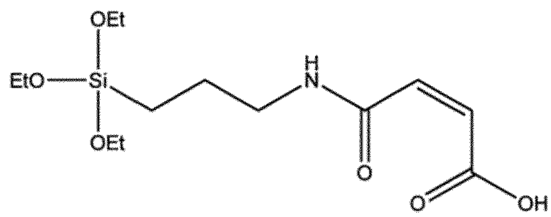

The content of the metal adhesiveness improver is preferably in the range of 0.1 to 30 parts by mass and more preferably in the range of 0.5 to 15 parts by mass with respect to 100 parts by mass of the heterocycle-containing polymer precursor. In a case where the content thereof is 0.1 parts by mass or more, the adhesiveness between the film after thermal curing and the metal becomes satisfactory, and in a case where the content thereof is 30 parts by mass or less, the heat resistance and mechanical properties of the film after curing become satisfactory.
The metal adhesiveness improver may be used singly or two or more kinds thereof may be used in combination. In a case where two or more kinds thereof are used, it is preferable that the total thereof is in the range.

<Silane coupling agent>

The composition of the present invention preferably includes a silane coupling agent in view of improving the adhesiveness to the substrate. Example of the silane coupling agent include compounds disclosed in paragraphs 0062 to 0073 of JP2014-191002A, compounds disclosed in paragraphs 0063 to 0071 of WO2011/080992A1, compounds disclosed in paragraphs 0060 to 0061 of JP2014-191252A, compounds disclosed in paragraphs 0045 to 0052 of JP2014-41264A, and compounds disclosed in paragraph 0055 of WO2014/097594A. It is preferable to use two or more different kinds of silane coupling agents as disclosed in paragraphs 0050 to 0058 of JP2011-128358A.
The content of the silane coupling agent is preferably in the range of 0.1 to 20 parts by mass and more preferably in the range of 1 to 10 parts by mass with respect to 100 parts by mass of the heterocycle-containing polymer precursor. In a case where the content thereof is 0.1 parts by mass or more, it is possible to provide sufficient adhesion to the substrate, and in a case where the content thereof is 20 parts by mass or less, it is possible to further suppress problems such as the increase of viscosity during preservation at room temperature.
The silane coupling agent may be used singly and two or more kinds thereof may be used. In a case where two or more kinds of novolak resins are used, it is preferable that the total amount is in the above range.

<Dissolution accelerator>

In a case where the composition of the present invention is a positive type using an alkaline developer, in view of the improvement of the sensitivity, it is preferable to add a dissolution accelerator (compound of promoting solubility). Examples of the dissolution accelerator include low molecule phenols (for example, Bis-Z, TekP-4HBPA, TrisP-HAP, TrisP-PA, BisRS-2P, and BisRS-3P (above are trade names manufactured by Honshu Chemical Industry Co., Ltd.), BIR-PC, BIR-PTBP, and BIR-BIPC-F (above are trade names manufactured by Asahi Yukizai Corporation), and phenols disclosed in paragraphs 0056 to 0062 of JP2013-152381A) or arylsulfonamide derivatives (for example, compounds disclosed in paragraph 0058 of JP2011-164454A).
The content of the dissolution accelerator is in the range of 0.1 to 20 parts by mass and more preferably in the range of 1 to 10 parts by mass with respect to 100 parts by mass of the heterocycle-containing polymer precursor.
The dissolution accelerator may be used singly and two or more kinds thereof may be used. In a case where two or more kinds of novolak resins are used, it is preferable that the total amount is in the above range.

<Dissolution inhibitor>

In a case where the composition of the present invention is a positive type using an alkaline developer, in order to adjust the solubility to an alkaline developer, it is possible to contain a dissolution inhibitor (compound that inhibits solubility). As the compound, onium salt, a diaryl compound, and tetraalkylammonium salt are preferable. Examples of the onium salt include iodonium salt such as diaryl iodonium salt, sulfonium salt such as triarylsulfonium salt, and diazonium salt such as phosphonium salt and aryl diazonium salt. Examples of the diaryl compound include diaryl urea, diarylsulfone, diaryl ketone, diaryl ether, diarylpropane, and a compound obtained by bonding two aryl groups such as diarylhexafluoropropane via a bonding group, and the aryl group is preferably a phenyl group.
Examples of the tetraalkylammonium salt include tetraalkylammonium halide in which the alkyl group is a methyl group, an ethyl group, or the like.
Among these, examples of the compound exhibiting a favorable effect of inhibiting dissolution include diaryl iodonium salt, a diaryl urea compound, a diaryl sulfone compound, and a tetramethyl ammonium halide compound, examples of the diaryl urea compound include diphenyl urea and dimethyl diphenyl urea, and examples of the tetramethyl ammonium halide compound include tetramethylammonium chloride, tetramethyl ammonium bromide, and tetramethylammonium iodide.
Among these, a diaryl iodonium salt compound represented by Formula (Inh) is preferable.

Formula (Inh)

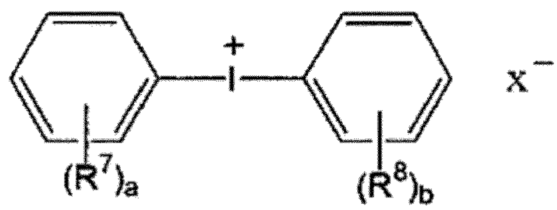

(In the formula, $X^-$ represents a counter anion, $R^7$ and $R^8$ each independently represent a monovalent organic group, and a and b each independently represent an integer of 0 to 5.)

Examples of the anion $X^-$ include a nitrate ion, a tetrafluoroborate ion, a perchlorate ion, a trifluoromethanesulfonate ion, a p-toluenesulfonic acid ion, a thiocyanate ion, a chlorine ion, a bromine ion, and an iodine ion.

Examples of the diaryl iodonium salt include diphenyliodonium nitrate, bis(p-tert-butylphenyl) iodonium nitrate, diphenyliodonium trifluoromethanesulfonate, bis(p-tert-butylphenyl) iodonium trifluoromethanesulfonate, diphenyliodonium bromide, diphenyliodonium chloride, and diphenyliodonium iodite.

Among these, diphenyliodonium nitrate, diphenyliodonium trifluoromethanesulfonate, and diphenyliodonium-8-anilinonaphthalene-1-sulfonate are exemplified as highly effective and preferable examples.

The content in a case of containing a dissolution inhibitor is preferably 0.1 to 20 parts by mass, more preferably 0.1 to 15 parts by mass, and even more preferably 0.5 to 10 parts by mass with respect to 100 parts by mass of the heterocycle-containing polymer precursor, in view of sensitivity and an allowable range of development time.

The dissolution inhibitor may be used singly and two or more kinds thereof may be used. In a case where two or more kinds of novolak resins are used, it is preferable that the total amount is in the above range.

<Sensitizing dye>

The composition of the present invention may include a sensitizing dye. The sensitizing dye absorbs specific actinic radiation and becomes an electron excited state. The sensitizing dye in the electronically excited state is brought into contact with an amine generator, a thermal radical polymerization initiator, a photopolymerization initiator, or the like to cause actions such as electron transfer, energy transfer, and heat generation. As a result, the amine generator, the thermal radical polymerization initiator, and the photopolymerization initiator are chemically changed to be decomposed and generate radical, acid, or base.

Examples of the preferable sensitizing dye include a sensitizing dye that belongs to the following compounds and that has an absorption wavelength from 300 nm to 450 nm. Examples thereof include polynuclear aromatic compounds (for example, phenanthrene, anthracene, pyrene, perylene, triphenylene, and 9,10-dialkoxyanthracene), xanthenes (for example, fluorescein, eosin, erythrosine, rhodamine B, and rose bengal), thioxanthones (for example, 2,4-diethylthioxanthone), cyanines (for example, thiacarbocyanine and oxacarbocyanine), merocyanines (for example, merocyanine, and carbomerocyanine), thiazines (for example, thionine, methylene blue, and toluidine blue), acridines (for example, acridine orange, chloroflavin, and acriflavin), anthraquinones (for example, anthraquinone), squaryliums (for example, squarylium), coumarins (for example, 7-diethylamino-4-methylcoumarin), styrylbenzenes, distyrylbenzenes, and carbazoles.

Among these, according to the present invention, a combination with polynuclear aromatic compounds (for example, phenanthrene, anthracene, pyrene, perylene, and triphenylene), thioxanthones, distyrylbenzenes, and styrylbenzenes is preferable in view of starting efficiency, and it is more preferable to use a compound having an anthracene skeleton. Particularly preferable and specific examples of the compound include 9,10-diethoxyanthracene and 9,10-dibutoxyanthracene.

In a case where the composition includes a sensitizing dye, the content of the sensitizing dye is preferably 0.01 to 20 mass%, more preferably 0.1 to 15 mass%, and even more preferably 0.5 to 10 mass% with respect to the total solid content of the composition. The sensitizing dye may be used singly and two or more kinds thereof may be used in combination.

<Chain transfer agent>

The composition of the present invention may contain a chain transfer agent. For example, the chain transfer agent is defined in pages 683 and 684 of Kobunshi Jiten (Polymer Dictionary), Third Edition (edited by The Society of Polymer Science, Japan, 2005). For example, as the chain transfer agent, a compound group having SH, PH, SiH, and GeH in a molecule is used. These may donate hydrogen to radical species of low activity so as to generate radicals or

may be oxidized and then deprotonated so as to generate radicals. Particularly, a thiol compound (for example, 2-mercaptobenzimidazoles, 2-mercaptobenzthiazoles, 2-mercaptobenzoxazoles, 3-mercaptotriazoles, and 5-mercaptotetrazoles) may be preferably used.

In a case where the composition has a chain transfer agent, a preferable content of the chain transfer agent is preferably 0.01 to 20 parts by mass, more preferably 1 to 10 parts by mass, and particularly preferably 1 to 5 parts by mass with respect to 100 parts by mass of the total solid content of the composition.

The chain transfer agent may be used singly or two or more kinds thereof may be used in combination. In a case where two or more kinds of chain transfer agents are used, it is preferable that the sum thereof is in the range.

<Polymerization inhibitor>

In the composition of the present invention, a polymerization inhibitor may be formulated in a polymerization inhibitor incorporated in the heterocycle-containing polymer precursor.

Examples of the polymerization inhibitor include hydroquinone, p-methoxyphenol, di-tert-butyl-p-cresol, pyrogallol, p-tert-butyl catechol, benzoquinone, 4,4'-thiobis(3-methyl-6-tert-butylphenol), 2,2'-methylenebis(4-methyl-6-tert-butylphenol), N-nitroso-N-phenylhydroxyamine aluminum salt, phenothiazine, N-nitrosodiphenylamine, N-phenylnaphthylamine, ethylenediaminetetraacetic acid, 1,2-cyclohexanediamine tetraacetic acid, glycol ether diamine tetraacetic acid, 2,6-di-tert-butyl-p-methylphenol, 5-nitroso-8-hydroxyquinoline, 1-nitroso-2-naphthol, 2-nitroso-1-naphthol, 2-nitroso-5-(N-ethyl-N-sulfopropylamino) phenol, N-nitroso-N-(1-naphthyl) hydroxyamine ammonium salt, and bis(4-hydroxy-3,5-tert-butyl) phenylmethane.

In a case where the composition has a polymerization inhibitor, the content of the polymerization inhibitor is preferably 0.01 to 5 mass% with respect to the total solid content of the composition.

The polymerization inhibitor may be used singly and two or more kinds thereof may be used. In a case where two or more kinds of polymerization inhibitors are used, the sum thereof is preferably in the range.

The composition of the present invention may have a configuration in which a polymerization inhibitor other than the polymerization inhibitor incorporated to the heterocycle-containing polymer precursor is not substantially formulated. The expression "not being substantially formulated" means that the solid content included in the composition of the present invention is less than 0.01 mass%, preferably less than 0.001 mass%, and particularly preferably less than 0.0001 mass%.

<Surfactant>

Various kinds of surfactants may be added to the composition of the present invention in view of further improving coatability. As the surfactant, various kinds of surfactants such as a fluorine-based surfactant, a nonionic surfactant, a cationic surfactant, an anionic surfactant, and a silicone-based surfactant may be used.

Particularly, in a case where a fluorine-based surfactant is included, the liquid properties (particularly, fluidity) in a case of being prepared as a coating liquid are further improved, and thus uniformity after coating and liquid saving properties may be further improved.

In a case where a film is formed by using a coating liquid including a fluorine-based surfactant, the wettability to the surface to be coated is improved by reducing the interfacial tension between the surface to be coated and the coating liquid, and thus the coatability to the surface to be coated is improved. Therefore, even in the case where a thin film of about several μm with a small amount of liquid is formed, it is effective in that a homogeneous thickness film with small thickness unevenness is appropriately formed.

The fluorine content of the fluorine-based surfactant is appropriately 3 to 40 mass%, more preferably 5 to 30 mass%, and particularly preferably 7 to 25 mass%. The fluorine-based surfactant in a case where the fluorine content is in this range is effective in view of the uniformity of the thickness of the coating film and liquid saving properties, and has favorable solubility.

Examples of the fluorine-based surfactant include MEGAFACE F171, F172, F173, F176, F177, F141, F142, F143, F144, R30, F437, F475, F479, F482, F554, F780, and F781 (above are manufactured by DIC Corporation), FLUORAD FC430, FC431, and FC171 (above are manufactured by Sumitomo 3m Limited ), SURFLON S-382, SC-101, SC-103, SC-104, SC-105, SC1068, SC-381, SC-383, S393, and KH-40 (above are manufactured by Asahi Glass Co., Ltd.), and PF636, PF656, PF6320, PF6520, and PF7002 (manufactured by OMNOVA Solutions Inc.).

As the fluorine-based surfactant, a block polymer may be used, and specific examples thereof include a compound disclosed in JP2011-89090A.

The following compounds are also exemplified as the fluorine-based surfactant used in the present invention.

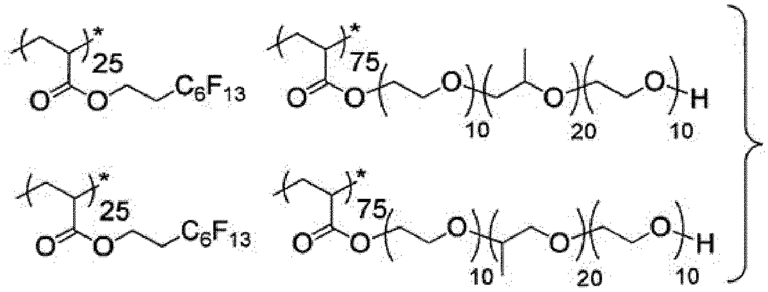

Mixture

The weight-average molecular weight of the compound is, for example, 14,000.

Specific examples of the nonionic surfactant include glycerol, trimethylolpropane, trimethylolethane, and ethoxylate and propoxylate thereof (for example, glycerol propoxylate and glycerol ethoxylate), polyoxyethylene lauryl ether, polyoxyethylene stearyl ether, polyoxyethylene oleyl ether, polyoxyethylene octyl phenyl ether, polyoxyethylene nonylphenyl ether, polyethylene glycol dilaurate, polyethylene glycol distearate, and sorbitan fatty acid ester (PLURONIC L10, L31, L61, L62, 10R5, 17R2, and 25R2, and TETRONIC 304, 701, 704, 901, 904, and 150R1 manufactured by BASF SE), and SOLSPERSE 20000 (Lubrizol Japan Limited). PIONIN D-6112-W manufactured by Takemoto Oil & Fat Co., Ltd., NCW-101, NCW-1001, and NCW-1002 manufactured by Wako Pure Chemical Industries, Ltd. may also be used.

Specific examples of the cationic surfactant include a phthalocyanine derivative (trade name: EFKA-745, manufactured by Morishita & Co., Ltd.), an organosiloxane polymer KP341 (manufactured by Shin-Etsu Chemical Co., Ltd.), a (meth)acrylic acid-based (co)polymer POLYFLOW No. 75, No. 90, and No. 95 (manufactured by Kyoeisha Chemical Co., Ltd.), and W001 (manufactured by Yuso Co., Ltd.).

Specific examples of the anionic surfactant include W004, W005, and W017 (manufactured by Yusho Co., Ltd.).

Examples of the silicone surfactant include "Toray Silicone DC 3 PA", "TORAY SILICONE SH7PA", "TORAY SILICONE DC 11 PA", "TORAY SILICONE SH 21 PA", "TORAY SILICONE SH 28 PA", "TORAY SILICONE SH 29 PA", "TORAY SILICONE SH30PA", and "TORAY SILICONE SH 8400" manufactured by Dow Corning Corporation, "TSF-4440", "TSF-4300", "TSF-4445", "TSF-4460", and "TSF-4452" manufactured by Momentive Performance Materials Inc., "KP341", "KF6001", and "KF6002" manufactured by Shin-Etsu Silicones of America, Inc., and "BYK307", "BYK323", and "BYK330" manufactured by BYK Japan KK.

In a case where the composition contains a surfactant, the content of the surfactant is preferably 0.001 to 2.0 mass% and more preferably 0.005 to 1.0 mass% with respect to the total solid content of the composition.

The surfactant may be used singly and two or more kinds thereof may be used. In a case where two or more kinds of surfactants are used, the sum thereof is in the range.

«Polymerization inhibitor»

The composition of the present invention preferably includes a small amount of polymerization inhibitor, in order to prevent unnecessary thermal polymerization of the heterocycle-containing polymer precursor and the polymerizable compound during manufacturing or during preservation.

Examples of the polymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol), and N-nitroso-N-phenylhydroxylamine aluminum salt.

In a case where the composition contains a polymerization inhibitor, the content of the polymerization inhibitor is preferably 0.01 to 5 mass% with respect to the total solid content of the photosensitive resin composition.

The polymerization inhibitor may be used singly and two or more kinds thereof may be used. In a case where two or more kinds of polymerization inhibitors are used, the sum thereof is preferably in the range.

<Higher fatty acid derivative and the like>

In order to prevent the polymerization inhibition due to oxygen, a higher fatty acid derivative such as behenic acid or behenic acid amide and the like may be added to the composition of the present invention so as to be unevenly distributed to the surface of the composition in the course of drying after coating.

In a case where the composition has a higher fatty acid derivative, the content of the higher fatty acid derivative is preferably 0.1 to 10 mass% with respect to the total solid content of the composition.

The higher fatty acid derivative and the like may be used singly or two or more kinds thereof may be used. In a case where two or more kinds of higher fatty acid derivatives and the like are used, it is preferable that the sum thereof is in the range.

<Solvent>

In a case where the composition of the present invention is applied in a layer shape, it is preferable to formulate the solvent. Well-known solvents may be used without limitation, as long as the composition may be formed to a layer shape.

Examples of esters include ethyl acetate, n-butyl acetate, isobutyl acetate, amyl formate, isoamyl acetate, isobutyl acetate, butyl propionate, isopropyl butyrate, ethyl butyrate, butyl butyrate, methyl lactate, ethyl lactate, γ-butyrolactone, ε-caprolactone, δ-valerolactone, alkyl oxyacetate (for example, methyl oxyacetate, ethyl oxyacetate, and butyl oxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-oxypropionate and ethyl 3-oxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-oxypropionate, ethyl 2-oxypropionate, and propyl 2-oxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-oxy-2-methylpropionate and ethyl 2-oxy-2-methylpropionate (for example, methyl 2-methoxy-2-methylpropionate, and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate, examples of ethers include diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, and propylene glycol monopropyl ether acetate, examples of ketones include methyl ethyl ketone, cyclohexanone, cyclopentanone, 2-heptanone, 3-heptanone, and n-methyl-2-pyrrolidone, examples of aromatic hydrocarbons include toluene, xylene, anisole, and limonene, and examples of sulfoxides include dimethyl sulfoxide.

In view of improving a coated surface shape, a form of mixing two or more kinds solvents is also preferable. Among these, a mixed solution including two or more selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, dimethyl sulfoxide, ethyl carbitol acetate, butyl carbitol acetate, propylene glycol methyl ether, and propylene glycol methyl ether acetate is preferable. A combination of dimethyl sulfoxide and γ-butyrolactone is particularly preferable.

In a case where the composition has a solvent, in view of coatability, the content of the solvent is preferably in an amount in which the concentration of the total solid content of the composition is 5 to 80 mass%, more preferably 5 to 70 mass%, and particularly preferably 10 to 60 mass%.

The solvent may be used singly and two or more kinds thereof may be used. In a case where two or more kinds of solvents are used, it is preferable that the sum thereof is in the range.

In view of film hardness, the content of N-methyl-2-pyrrolidone, N-ethyl-2-pyrrolidone, N,N-dimethylacetamide, and N,N-dimethylformamide is preferably less than 5 mass%, more preferably less than 1 mass%, even more preferably less than 0.5 mass%, and particularly preferably less than 0.1 mass% with respect to the total mass of the composition.

<Other additives>

In the composition of the present invention, various additives, for example, an inorganic particle, a curing agent, a curing catalyst, a filler, an antioxidant, an ultraviolet absorbing agent, and an aggregation inhibitor, may be formulated without deteriorating the effect of the present invention, if necessary. In a case where these additives are formulated, the total formulation amount is preferably 3 mass% or less of the solid content of the composition.

In view of the coated surface shape, the moisture content of the composition of the present invention is preferably less than 5 mass%, more preferably less than 1 mass%, and particularly preferably less than 0.6 mass%.

In view of insulation properties, the metal content of the composition of the present invention is preferably less than 5 mass ppm, more preferably less than 1 mass ppm, and particularly preferably less than 0.5 mass ppm. Examples of the metal include sodium, potassium, magnesium, calcium, iron, chromium, and nickel. In a case where a plurality of kinds of metal is included, it is preferable that the sum of the metal is in the range.

A method for reducing metal impurities unintentionally included in the composition includes a method of selecting a raw material having a small metal content as a raw material included in the composition, performing filter filtration on a raw material including the composition, lining the inside of a device with polytetrafluoroethylene or the like, and performing distillation under a condition where contamination is suppressed as much as possible.

In view of the wiring corrosiveness, the content of the halogen atom in the composition of the present invention is preferably less than 500 mass ppm, preferably less than 300 mass ppm, and particularly preferably less than 200 mass ppm. Among these, those that are present in a state of an halogen ion is preferably less than 5 mass ppm, more preferably less than 1 mass ppm, and particularly preferably less than 0.5 mass ppm. Examples of the halogen atom

include a chlorine atom and a bromine atom. It is preferable that each of the sum of a chlorine atom and a bromine atom or a chlorine ion and a bromide ion is in the range.

<Preparing of composition>

The composition of the present invention may be prepared by mixing the respective components. The mixing method is not particularly limited, and may be performed by a well-known method in the related art.
For the purpose of removing foreign matters such as dust and fine particles in the composition, it is preferable to perform filtration using a filter. A filter pore diameter is preferably 1 μm or less, more preferably 0.5 μm or less, and even more preferably 0.1 μm or less. The material of the filter is preferably polytetrafluoroethylene, polyethylene, and nylon. As the filter, a filter washed with an organic solvent in advance may be used. In the filter filtration step, a plurality of kinds of filters may be connected in series or juxtaposition, to be used. In a case where a plurality of kinds of filters are used, filters having different pore diameters and/or different materials may be used in combination. In addition, a variety of materials may be used in filtration in a plurality of steps, and the filtration in the plurality of steps may be a circulating filtration step. Filtration may be performed under pressure, and the pressurized pressure may be 0.05 MPa or more and is preferably 0.3 MPa or less.
In addition to the filtration using a filter, impurities may be removed by an adsorbent, and a filtration filter and an adsorbent may be combined to be used. As the adsorbent, well-known adsorbents may be used, and for example, an inorganic adsorbent such as silica gel and zeolite and an organic adsorbent such as activated carbon may be used.
Subsequently, the cured film, the method of manufacturing a cured film, and the semiconductor device according to the present invention are described.
The cured film of the present invention is obtained by curing the composition of the present invention. The method of manufacturing the cured film of the present invention includes a step of applying the composition of the present invention to the substrate and a step of curing the composition applied to the substrate.
In the field in which the cured film of the present invention may be applied, an insulating film of a semiconductor device, an interlayer insulating film for a rewiring layer, and the like may be preferably used. Particularly, the resolution is favorable, and thus the cured film of the present invention may be preferably used in an interlayer insulating film for a rewiring layer and the like in a three-dimensionally equipped device. That is, the present invention describes the semiconductor device including the cured film of the present invention.
The cured film in the present invention may also be used in a photoresist for electronics (a galvanic (electrolytic) resist (galvanic resist), an etching resist, and a solder top resist) may also be used.
The cured film in the present invention may also be used in the manufacturing of plate surfaces such as offset printing plates or screen printing plates, application in the etching of molded parts, in the manufacturing of protective lacquers and dielectric layers in electronics, particularly, microelectronics, or the like.
One embodiment of a semiconductor device using the composition in the interlayer insulating film for a rewiring layer is described.
A semiconductor device 100 illustrated in Fig. 1 is a three-dimensionally equipped device, and a laminate 101 in which a plurality of semiconductor elements (semiconductor chips) 101a to 101d are laminated is disposed on a wiring substrate 120.
The present embodiment is described with reference to a case where the number of laminated layers of the semiconductor element (semiconductor chip) is 4, but the number of laminated layers is not particularly limited, and for example, may be 2, 8, 16, 32, or the like. Otherwise, the number of laminated layers may be 1.
All of the plurality of semiconductor elements 101a to 101d are formed with a semiconductor wafer such as a silicon substrate.
The uppermost semiconductor element 101a does not have through electrodes, and an electrode pad (not illustrated) is formed on one surface thereof.
The semiconductor elements 101b to 101d have through electrodes 102b to 102d, and connection pads (not illustrated) integrally provided to the through electrodes are provided on both surfaces of the respective semiconductor elements.
The laminate 101 has a structure in which the semiconductor element 101a that does not have a through electrode and the semiconductor elements 101b to 101d that have the through electrodes 102b to 102d are flip-chip connected to each other.
That is, an electrode pad of the semiconductor element 101a that does not have a through electrode and a connection pad of the semiconductor element 101b that has the through electrode 102b adjacent thereto on the semiconductor element 101a side are connected by a metal bump 103a such as a solder bump, and a connection pad on the other side of the semiconductor element 101b that has the through electrode 102b is connected to a connection pad of the semiconductor element 101c that has the through electrode 102c adjacent thereto on the semiconductor element 101b side by a metal bump 103b such as a solder bump. In the same manner, a connection pad of the semiconductor

element 101c that has the through electrode 102c on the other side is connected to a connection pad of the semiconductor element 101d that has the through electrode 102d adjacent thereto on the semiconductor element 101c side by a metal bump 103c such as a solder bump.

An underfill layer 110 is formed in the gaps between the semiconductor elements 101a to 101d, and the semiconductor elements 101a to 101d are laminated with the underfill layer 110 interposed therebetween.

The laminate 101 is laminated on the wiring substrate 120.

For example, as the wiring substrate 120, a multilayer wiring substrate using an insulating substrate such as a resin substrate, a ceramic substrate, and a glass substrate as a base material is used. Examples of the wiring substrate 120 to which the resin substrate is applied include a multilayer copper-clad laminate (multilayer printed wiring substrate).

A surface electrode 120a is provided on one surface of the wiring substrate 120.

An insulating layer 115 in which a rewiring layer 105 formed between the wiring substrate 120 and the laminate 101 is disposed, and the wiring substrate 120 and the laminate 101 are electrically connected to each other via the rewiring layer 105. The insulating layer 115 is formed by using the composition according to the present invention.

That is, one end of the rewiring layer 105 is connected to an electrode pad formed on the surface of the semiconductor element 101d on the rewiring layer 105 side via a metal bump 103d such as a solder bump. The other side of the rewiring layer 105 is connected to the surface electrode 120a of the wiring substrate via a metal bump 103e such as a solder bump.

An underfill layer 110a is formed between the insulating layer 115 and the laminate 101. An underfill layer 110b is formed between the insulating layer 115 and the wiring substrate 120.

In addition to the above, the cured film according to the present invention can be widely employed for various applications using polyimide or polybenzoxazole.

Since polyimide and polybenzoxazole are resistant to heat, the cured film and the like according to the present invention are suitably used as a transparent plastic substrate for a display device such as a liquid crystal display and electronic paper, a vehicle component, heat resistant paint, a coating agent, and film applications.

Examples

Hereinafter, the present invention is specifically described with reference to the examples. A material, an amount used, a treatment detail, a treatment order, and the like provided in the following examples can be, suitably, changed without departing from the gist of the present invention. The scope of the present invention should not be limited by the following specific examples. "Part" and "%" are based on mass unless described otherwise.

(Synthesis example 1)

[Synthesis of Polyimide Precursor Composition A-1 from 4,4'-oxydiphthalic acid dianhydride, 2-hydroxyethyl methacrylate, and Diamine (DA-7)]

21.2 g (68.3 mmol) of 4,4'-oxydiphthalic acid dianhydride, 18.0 g of 2-hydroxyethyl methacrylate, 23.9 g of pyridine, and 250 ml diglyme (diglyme and diethylene glycol dimethyl ether) are mixed, stirred at a temperature of 60°C for four hours, so as to manufacture diester of 4,4'-oxydiphthalic anhydride and 2-hydroxyethyl methacrylate. The water content of the obtained reaction solution was measured and 1.3 mmol was included. Subsequently, the reaction mixture was cooled to -10°C and 16.3 g (137.2 mmol) of $SOCl_2$ was added over 60 minutes while the temperature was maintained at -10 ± 5°C. After diluting with 50 ml of N-methylpyrrolidone, 38.0 g of a solution obtained by dissolving Hydroxy Group-Containing Diamine (DA-7) in 100 ml of N-methylpyrrolidone was dropwise added to a reaction mixture at -10 ± 5°C over 60 minutes, and the mixture was stirred for two hours. A polyimide precursor was precipitated in 6 liters of water, and the water-polyimide precursor mixture was stirred at a speed of 5,000 rpm for 15 minutes. The polyimide precursor solid was filtrated and dissolved in 380 g of tetrahydrofuran. A polyimide precursor was precipitated in six liters of water from the obtained solution and the water-polyimide precursor mixture was stirred at a speed of 5,000 rpm for 15 minutes. The polyimide precursor solid was filtrated again and dried under reduced pressure at 45°C for three days. The polyimide precursor had a weight-average molecular weight of 28,800, a number-average molecular weight of 8,900, and an acid value (the neutralization point of the acid group was in the range of pH 5.0 to 9.0) of 2.5 mg KOH/g.

Difference in molar amounts of halogenating agent and water /molar amounts of dicarboxylic acid or the like as a raw material:

$$(137.2\ \text{mmol} - 1.3\ \text{mmol}) / 68.3\ \text{mmol} = 1.99$$

Molar amount of halogenating agent / molar amount of dicarboxylic acid or the like as a raw material:

137.2 mmol / 68.3 mmol = 2.01

Diamine (DA-7)

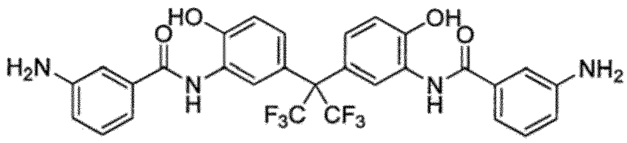

(Synthesis example 2)

[Synthesis of Polyimide Precursor Composition A-2 from pyromellitic acid dianhydride, 2-hydroxyethyl methacrylate, and 4,4'-diamino-2,2'-bis(trifluoromethyl) biphenyl]

14.9 g (68.3 mmol) of pyromellitic acid dianhydride, 18.0 g of 2-hydroxyethyl methacrylate, 23.9 g of pyridine, 0.10 g of water, and 250 ml of diglyme were mixed and stirred at 60°C for four hours to prepare a diester of pyromellitic anhydride and 2-hydroxyethyl methacrylate. The water content of the obtained reaction solution was measured, and 6.9 mmol was included. Subsequently, the reaction mixture was cooled to -10°C and 16.9 g (142.1 mmol) of $SOCl_2$ was added over 60 minutes while the temperature was maintained at -10 ± 5°C. After diluting was performed with 50 ml of N-methylpyrrolidone, a solution obtained by dissolving 20.1 g of 4,4'-diamino-2,2'-bis(trifluoromethyl) biphenyl in 100 ml of N-methylpyrrolidone was dropwise added to a reaction mixture at -10 ± 5°C over 60 minutes, and the mixture was stirred for two hours. A polyimide precursor was precipitated in 6 liters of water, and the water-polyimide precursor mixture was stirred at a speed of 5,000 rpm for 15 minutes. The polyimide precursor solid was filtrated and dissolved in 380 g of tetrahydrofuran. A polyimide precursor was precipitated in six liters of water from the obtained solution and the water-polyimide precursor mixture was stirred at a speed of 5,000 rpm for 15 minutes. The polyimide precursor solid was filtrated again and dried under reduced pressure at 45°C for three days. With respect to this polyimide precursor, the weight-average molecular weight was 26,800, the number-average molecular weight was 8,400, and an acid value (a neutralization point of an acid group was in the range of pH 5.0 to 9.0) was 2.4 mgKOH/g.

Difference in molar amounts of halogenating agent and water /molar amounts of dicarboxylic acid or the like as a raw material:

$$(142.1 \text{ mmol} - 6.9 \text{ mmol}) / 68.3 \text{ mmol} = 1.98$$

Molar amount of halogenating agent / molar amount of dicarboxylic acid or the like as a raw material:

$$142.1 \text{ mmol} / 68.3 \text{ mmol} = 2.08$$

(Synthesis example 3)

[Synthesis of Polyimide Precursor Composition A-3 from pyromellitic acid dianhydride, 2-hydroxyethyl methacrylate, and 4,4'-diamino-2,2'-bis(trifluoromethyl) biphenyl]

14.9 g (68.3 mmol) of pyromellitic acid dianhydride, 18.0 g of 2-hydroxyethyl methacrylate, 23.9 g of pyridine, and 250 ml of diglyme were mixed and stirred at 60°C for four hours to prepare a diester of pyromellitic anhydride and 2-hydroxyethyl methacrylate. The water content of the obtained reaction solution was measured, and 3.4 mmol was included. Subsequently, the reaction mixture was cooled to -10°C, and 17.2 g (144.8 mmol) of SOCl2 was added over 60 minutes while the temperature was maintained at -10 ± 5°C. After diluting was performed with 50 ml of N-methylpyrrolidone, a solution obtained by dissolving 20.1 g of 4,4'-diamino-2,2'-bis(trifluoromethyl) biphenyl in 100 ml of N-methylpyrrolidone was dropwise added to a reaction mixture at -10 ± 5°C over 60 minutes, and the mixture was stirred for two hours. A polyimide precursor was precipitated in 6 liters of water, and the water-polyimide precursor mixture was stirred at a speed of 5,000 rpm for 15 minutes. The polyimide precursor solid was filtrated and dissolved in 380 g of tetrahydrofuran. A polyimide precursor was precipitated in six liters of water from the obtained solution and the water-polyimide precursor mixture was stirred at a speed of 5,000 rpm for 15 minutes. The polyimide precursor solid was filtrated again and dried under reduced pressure at 45°C for three days. With respect to this polyimide precursor, the weight-average molecular weight was 24,900, the number-average molecular weight was 7,900, and an acid value (a

neutralization point of an acid group was in the range of pH 5.0 to 9.0) was 3.5 mgKOH/g.

Difference in molar amounts of halogenating agent and water /molar amounts of dicarboxylic acid or the like as a raw material:

$$(144.8 \text{ mmol} - 3.4 \text{ mmol}) / 68.3 \text{ mmol} = 2.13$$

Molar amount of halogenating agent / molar amount of dicarboxylic acid or the like as a raw material:

$$144.8 \text{ mmol} / 68.3 \text{ mmol} = 2.172.12$$

(Synthesis example 4)

[Synthesis of Polyimide Precursor Composition A-4 from 4,4'-oxydiphthalic acid dianhydride, 2-hydroxyethyl methacrylate, and 4,4'-diaminodiphenyl ether]

21.2 g (68.3 mmol) of 4,4'-oxydiphthalic acid dianhydride, 18.0 g of 2-hydroxyethyl methacrylate, 23.9 g of pyridine, 0.05 g of water, and 250 ml diglyme were mixed and stirred at a temperature of 60°C for four hours, so as to manufacture diester of 4,4'-oxydiphthalic anhydride and 2-hydroxyethyl methacrylate. The water content of the obtained reaction solution was measured, and 4.7 mmol was included. Subsequently, the reaction mixture was cooled to -10°C and 16.5 g (138.6 mmol) of $SOCl_2$ was added over 60 minutes while the temperature was maintained at -10 ± 5°C. After diluting was performed with 50 ml of N-methylpyrrolidone, a solution obtained by dissolving 12.6 g of 4,4'-diaminodiphenyl ether in 100 ml of N-methylpyrrolidone was dropwise added to a reaction mixture at -10 ± 5°C over 60 minutes, and the mixture was stirred for two hours. A polyimide precursor was precipitated in 6 liters of water, and the water-polyimide precursor mixture was stirred at a speed of 5,000 rpm for 15 minutes. The polyimide precursor solid was filtrated and dissolved in 380 g of tetrahydrofuran. A polyimide precursor was precipitated in six liters of water from the obtained solution and the water-polyimide precursor mixture was stirred at a speed of 5,000 rpm for 15 minutes. The polyimide precursor solid was filtrated again and dried under reduced pressure at 45°C for three days. With respect to this polyimide precursor, the weight-average molecular weight was 25,200, the number-average molecular weight was 8,000, and an acid value (a neutralization point of an acid group was in the range of pH 5.0 to 9.0) was 1.8 mgKOH/g.

Difference in molar amounts of halogenating agent and water /molar amounts of dicarboxylic acid or the like as a raw material:

$$(138.6 \text{ mmol} - 4.7 \text{ mmol}) / 68.3 \text{ mmol} = 1.96$$

Molar amount of halogenating agent / molar amount of dicarboxylic acid or the like as a raw material:

$$138.6 \text{ mmol} / 68.3 \text{ mmol} = 2.03$$

(Synthesis example 5)

[Synthesis of Polyimide Precursor Composition A-5 from 4,4'-oxydiphthalic acid dianhydride, 2-hydroxyethyl methacrylate, and 4,4'-diaminodiphenyl ether]

21.2 g (68.3 mmol) of 4,4'-oxydiphthalic acid dianhydride, 18.0 g of 2-hydroxyethyl methacrylate, 23.9 g of pyridine, 0.10 g of water, and 250 ml diglyme were mixed and stirred at a temperature of 60°C for four hours, so as to manufacture diester of 4,4'-oxydiphthalic anhydride and 2-hydroxyethyl methacrylate. The water content of the obtained reaction solution was measured, and 2.7 mmol was included. Subsequently, the reaction mixture was cooled to -10°C and 17.1 g (144.1 mmol) of $SOCl_2$ was added over 60 minutes while the temperature was maintained at -10 ± 5°C. After diluting was performed with 50 ml of N-methylpyrrolidone, a solution obtained by dissolving 12.6 g of 4,4'-diaminodiphenyl ether in 100 ml of N-methylpyrrolidone was dropwise added to a reaction mixture at -10 ± 5°C over 60 minutes, and the mixture was stirred for two hours. A polyimide precursor was precipitated in 6 liters of water, and the water-polyimide precursor mixture was stirred at a speed of 5,000 rpm for 15 minutes. The polyimide precursor solid was filtrated and dissolved in 380 g of tetrahydrofuran. A polyimide precursor was precipitated in six liters of water from the obtained solution and the water-polyimide precursor mixture was stirred at a speed of 5,000 rpm for 15 minutes. The

polyimide precursor solid was filtrated again and dried under reduced pressure at 45°C for three days. With respect to this polyimide precursor, the weight-average molecular weight was 26,200, the number-average molecular weight was 8,500, and an acid value (a neutralization point of an acid group was in the range of pH 5.0 to 9.0) was 3.6 mgKOH/g.

Difference in molar amounts of halogenating agent and water /molar amounts of dicarboxylic acid or the like as a raw material:

$$(144.1 \text{ mmol} - 2.7 \text{ mmol}) / 68.3 \text{ mmol} = 2.07$$

Molar amount of halogenating agent / molar amount of dicarboxylic acid or the like as a raw material:

$$144.1 \text{ mmol} / 68.3 \text{ mmol} = 2.11$$

(Synthesis example 6)

[Synthesis of Polybenzoxazole Precursor Composition A-6 from 4,4'-carbonyl dibenzoic acid and 2,2'-bis(3-amino-4-hydroxyphenyl) hexafluoropropane]

18.5 g (68.3 mmol) of 4,4'-carbonyl dibenzoic acid, 0.03 g of water, and 250 ml of N-methylpyrrolidone were mixed, the water content of the reaction solution was measured, and 6.8 mmol was included. Subsequently, the reaction mixture was cooled to -10°C and 17.2 g (144.8 mmol) of $SOCl_2$ was added over 60 minutes while the temperature was maintained at -10 ± 5°C. Subsequently, a solution obtained by dissolving 21.0 g of 2,2'-bis(3-amino-4-hydroxyphenyl) hexafluoropropane in 100 ml of N-methylpyrrolidone was dropwise added to a reaction mixture at -10 ± 5°C over 60 minutes, and the mixture was stirred for two hours. A polybenzoxazole precursor was deposited in six liters of water, and the water-polybenzoxazole precursor mixture was stirred at a speed of 5,000 rpm for 15 minutes. The polybenzoxazole precursor solid was filtrated and dissolved in 380 g of tetrahydrofuran. A polybenzoxazole precursor was deposited in six liters of water from the obtained solution and the water-polybenzoxazole precursor mixture was stirred at a speed of 5,000 rpm for 15 minutes. The polybenzoxazole precursor solid was filtrated again and dried under reduced pressure at 45°C for three days. With respect to this polybenzoxazole precursor, the weight-average molecular weight was 29,800, the number-average molecular weight was 9,200, and an acid value (a neutralization point of an acid group was in the range of pH 5.0 to 9.0) was 2.8 mgKOH/g.

Difference in molar amounts of halogenating agent and water /molar amounts of dicarboxylic acid or the like as a raw material:

$$(144.8 \text{ mmol} - 6.8 \text{ mmol}) / 68.3 \text{ mmol} = 2.02$$

Molar amount of halogenating agent / molar amount of dicarboxylic acid or the like as a raw material:

$$144.8 \text{ mmol} / 68.3 \text{ mmol} = 2.12$$

(Synthesis example 7)

[Synthesis of Polyimide Precursor Composition A-7 from 4,4'-oxydiphthalic acid dianhydride, 2-hydroxyethyl methacrylate, and 4,4'-diaminodiphenyl ether]

21.2 g (68.3 mmol) of 4,4'-oxydiphthalic acid dianhydride, 18.0 g of 2-hydroxyethyl methacrylate, 23.9 g of pyridine, and 250 ml diglyme were mixed and stirred at a temperature of 60°C for four hours, so as to manufacture diester of 4,4'-oxydiphthalic acid and 2-hydroxyethyl methacrylate. The water content of the obtained reaction solution was measured, and 1.4 mmol was included. Subsequently, the reaction mixture was cooled to -10°C and 17.6 g (148.2 mmol) of $SOCl_2$ was added over 60 minutes while the temperature was maintained at -10 ± 5°C. After diluting was performed with 50 ml of N-methylpyrrolidone, a solution obtained by dissolving 12.6 g of 4,4'-diaminodiphenyl ether in 100 ml of N-methylpyrrolidone was dropwise added to a reaction mixture at -10 ± 5°C over 60 minutes, and the mixture was stirred for two hours. A polyimide precursor was deposited in 6 liters of water, and the water-polyimide precursor mixture was stirred at a speed of 5,000 rpm for 15 minutes. The polyimide precursor solid was filtrated and dissolved in 380 g of tetrahydrofuran. A polyimide precursor was deposited in six liters of water from the obtained solution and the

water-polyimide precursor mixture was stirred at a speed of 5,000 rpm for 15 minutes. The polyimide precursor solid was filtrated again and dried under reduced pressure at 45°C for three days. With respect to this polyimide precursor, the weight-average molecular weight was 24,600, the number-average molecular weight was 7,600, and an acid value (a neutralization point of an acid group was in the range of pH 5.0 to 9.0) was 4.5 mgKOH/g.

Difference in molar amounts of halogenating agent and water /molar amounts of dicarboxylic acid or the like as a raw material:

$$(148.2\ \text{mmol} - 1.4\ \text{mmol}) / 68.3\ \text{mmol} = 2.15$$

Molar amount of halogenating agent / molar amount of dicarboxylic acid or the like as a raw material:

$$148.2\ \text{mmol} / 68.3\ \text{mmol} = 2.17$$

(Synthesis example 8)

[Synthesis of Polybenzoxazole Precursor Composition A-8 from 4,4'-carbonyl dibenzoic acid and 2,2'-bis(3-amino-4-hydroxyphenyl) hexafluoropropane]

18.5 g (68.3 mmol) of 4,4'-carbonyl dibenzoic acid, and 250 ml of N-methylpyrrolidone were mixed, the water content of the reaction solution was measured, and 1.4 mmol was included. Subsequently, the reaction mixture was cooled to -10°C and 17.6 g (148.2 mmol) of $SOCl_2$ was added over 60 minutes while the temperature was maintained at -10 ± 5°C. Subsequently, a solution obtained by dissolving 21.0 g of 2,2'-bis(3-amino-4-hydroxyphenyl) hexafluoropropane in 100 ml of N-methylpyrrolidone was dropwise added to a reaction mixture at -10 ± 5°C over 60 minutes, and the mixture was stirred for two hours. A polybenzoxazole precursor was deposited in six liters of water, and the water-polybenzoxazole precursor mixture was stirred at a speed of 5,000 rpm for 15 minutes. The polybenzoxazole precursor solid was filtrated and dissolved in 380 g of tetrahydrofuran. A polybenzoxazole precursor was deposited in six liters of water from the obtained solution and the water-polybenzoxazole precursor mixture was stirred at a speed of 5,000 rpm for 15 minutes. The polybenzoxazole precursor solid was filtrated again and dried under reduced pressure at 45°C for three days. With respect to this polybenzoxazole precursor, the weight-average molecular weight was 28,900, the number-average molecular weight was 8,800, and an acid value (a neutralization point of an acid group was in the range of pH 5.0 to 9.0) was 5.0 mgKOH/g.

Difference in molar amounts of halogenating agent and water /molar amounts of dicarboxylic acid or the like as a raw material:

$$(148.2\ \text{mmol} - 1.4\ \text{mmol}) / 68.3\ \text{mmol} = 2.15$$

Molar amount of halogenating agent / molar amount of dicarboxylic acid or the like as a raw material:

$$148.2\ \text{mmol} / 68.3\ \text{mmol} = 2.17$$

(Evaluation)

[Measuring of water content]

The water content in the synthesis reaction solution of the heterocycle-containing polymer precursor was measured according to the following method.

1.0 g of the synthesis reaction solution was measured using a Karl Fischer moisture titrator (manufactured by Kyoto Electronics Manufacturing Co., Ltd.), and the water content in the synthesis reaction solution was measured.

[Measuring of weight-average molecular weight and number-average molecular weight]

The weight-average molecular weight (Mw) and the number-average molecular weight (Mn) of the heterocycle-containing polymer precursor were values in terms of polystyrene as measured by gel permeation chromatography (GPC) and were measured by the following method.

HLC-8220 (manufactured by Tosoh Corporation) was used as a measuring device, and guard column HZ-L, TSKgel Super HZM-M, TSKgel Super HZ4000, TSKgel Super HZ3000, and TSKgel Super HZ2000 (manufactured by Tosoh Corporation) were used as columns. The eluent was measured by using tetrahydrofuran (THF) at 40°C at a flow rate of 0.35 ml/min. The detection was performed by using an ultraviolet ray (UV) 254 nm detector. A sample in which the heterocycle-containing polymer precursor was adjusted and diluted to 0.1% by mass with THF was used as a measurement sample.

[Method of measuring acid value]

An acid value of an acid group in which pH of the neutralization point in the heterocycle-containing polymer precursor was in the range of 5.0 to 9.0 was measured according to the following method.

3.0 g of the heterocycle-containing polymer precursor was dissolved in 80 mL of N-methylpyrrolidone and 1 mL of water and titrated with 0.01 N sodium hydroxide aqueous solution, so as to calculate an acid value from a peak having pH in the range of 5.0 to 9.0.

[Cyclization time]

The components provided in Table 1 were mixed to prepare a coating liquid of a photosensitive resin composition as a uniform solution.

The photosensitive resin composition obtained above was filtrated under pressure through a filter having a pore width of 0.8 μm and was then applied onto a silicon wafer by spinning (1,200 rpm, 30 seconds). The silicon wafer to which the photosensitive resin composition was applied was dried on a hot plate at 100°C for five minutes so as to form a uniform film having a thickness of 10 μm on the silicon wafer. Subsequently, the film applied to the silicon wafer was exposed using an aligner (Karl-Suss MA 150). The exposure was performed with a high pressure mercury lamp and irradiated at 500 mJ/cm$^2$ in terms of exposure energy at a wavelength of 365 nm. After exposure, the photosensitive resin composition was scratched, the temperature was raised to 180°C at a rate of 5°C/min in a nitrogen atmosphere, thermogravimetric analysis (TGA measurement) was performed in a state in which the temperature was maintained at 180°C, and the cyclization time was evaluated.

The weights of the polyimide precursor and the polybenzoxazole precursor were reduced with the progress of the cyclization reaction, but the time until this weight reduction did not occur was evaluated according to the following standards. The shorter time refers to the faster cyclization rate, and thus becomes a preferable result.

A: More than 0 minutes and 20 minutes or less
B: More than 20 minutes and 30 minutes or less
C: More than 30 minutes and 60 minutes or less
D: More than 60 minutes and 120 minutes or less
E: More than 120 minutes

[Evaluation of constancy of cyclization rate]

With respect to Synthesis Examples A-1 to A-8, the synthesis of heterocycle-containing polymer precursors was performed three times, and the cyclization time of the heterocycle-containing polymer precursors obtained in each time was measured for in the same manner as above. Among the cyclization rates of heterocycle-containing polymer precursors obtained by synthesis of three times, the difference between the fastest cyclization rate and the slowest cyclization rate was evaluated as follows.

A: 30 minutes or less
B: More 30 minutes and 50 minutes or less
C: More 50 minutes

(Component of photosensitive resin composition)

Heterocycle-containing polymer precursor

A-1 to A-8: heterocycle-containing polymer precursor manufactured in Synthesis Examples 1 to 8

Polymerizable compound

B-1: NK ESTER M-40G (manufactured by Shin Nakamura Chemical Co., Ltd., monofunctional methacrylate, the following structure)

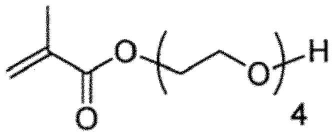

B-2: NK ESTER M-4G (manufactured by Shin Nakamura Chemical Co., Ltd., difunctional methacrylate, the following structure)

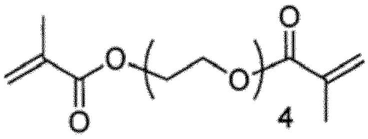

B-3: NK ESTER A-9300 (manufactured by Shin Nakamura Chemical Co., Ltd., trifunctional acrylate, the following structure)

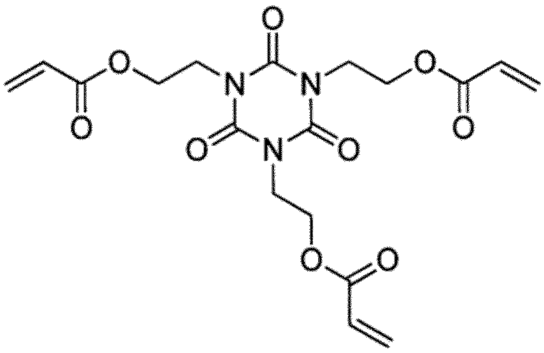

Photopolymerization initiator

C-1: IRGACURE OXE-01 (manufactured by BASF SE)

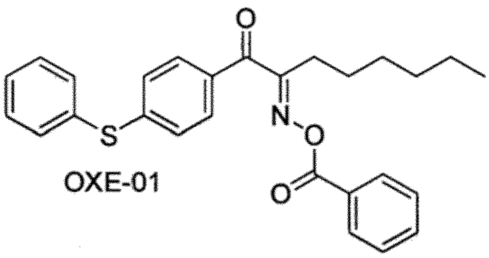

OXE-01

C-2: Compound 24 disclosed in paragraph 0345 of JP2014-500852A
C-3: Compound 36 disclosed in paragraph 0345 of JP2014-500852A
C-4: Compound 37 disclosed in paragraph 0345 of JP2014-500852A
C-5: Compound 40 disclosed in paragraph 0345 of JP2014-500852A

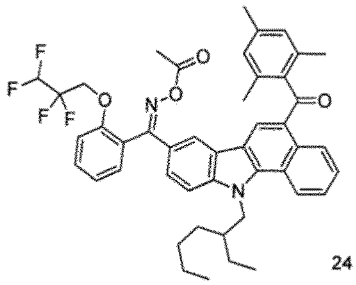
24

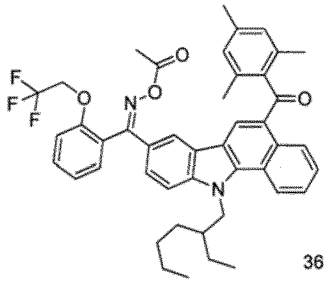
36

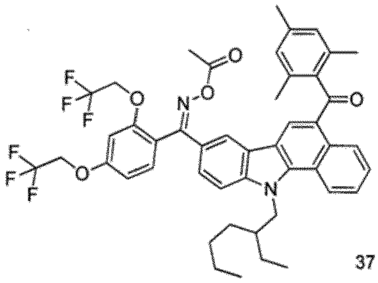
37

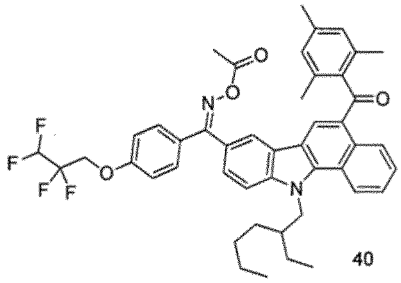
40

Thermal polymerization initiator

D-1: PERBUTYL Z (tert-butyl peroxybenzoate, manufactured by NOF Corporation, decomposition temperature (10 hour half-life temperature = 104°C))
D-2: PERCUMYL D (manufactured by NOF Corporation, dicumyl peroxide, decomposition temperature (10-hour half-life temperature = 116.4°C))

Additives

E-1: 1H-tetrazole
E-2: 1,2,4-triazole
E-3: The following compound

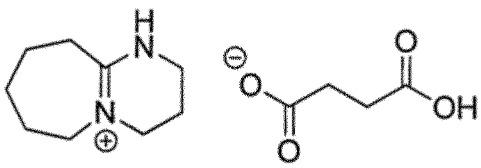

E-4: 1,4-benzoquinone

Solvent

F-1: γ-butyrolactone
F-2: Dimethyl sulfoxide

[Table 1]

| | Heterocycle-containing polymer precursor | | Polymerizable compound | | Photopolymerization initiator | | Thermal polymerization initiator | | Additive | | Solvent | | Cyclization time | Evaluation of constancy of cyclization rate |
|---|---|---|---|---|---|---|---|---|---|---|---|---|---|---|
| | Type | mass% | Type | mass% | Type | mass% | Type | mass% | Type | mass% | Type | mass% | | |
| Example 1 | A-1 | 39.0 | | | C-1 | 1.0 | | | | | F-1 | 60 | B | A |
| Example 2 | A-1 | 33.8 | B-1 | 5.0 | C-1 | 1.0 | | | E-1 | 0.2 | F-1 | 60 | B | A |
| Example 3 | A-1 | 33.0 | B-2 | 5.0 | C-1 | 1.0 | D-1 | 1.0 | | | F-1/F-2 | 48+12 | B | A |
| Example 4 | A-2 | 33.9 | B-1 | 5.0 | C-2 | 1.0 | | | E-4 | 0.1 | F-1 | 60 | B | A |
| Example 5 | A-2 | 34.0 | B-2 | 5.0 | C-1 | 1.0 | | | | | F-1 | 60 | B | A |
| Example 6 | A-2 | 27.0 | B-3 | 7.0 | C-1 | 1.0 | | | E-3 | 5.0 | F-1 | 60 | B | A |
| Example 7 | A-3 | 39.0 | | | C-3 | 1.0 | | | | | F-1/F-2 | 48+12 | C | A |
| Example 8 | A-3 | 33.0 | B-1 | 5.0 | C-1 | 1.0 | D-2 | 1.0 | | | F-1 | 60 | C | A |
| Example 9 | A-3 | 32.0 | B-2 | 7.0 | C-1 | 1.0 | | | | | F-1 | 60 | C | A |
| Example 10 | A-4 | 33.8 | B-2 | 5.0 | C-1 | 1.0 | | | E-2 | 0.2 | F-1 | 60 | A | A |
| Example 11 | A-4 | 34.0 | B-2 | 5.0 | C-1 | 1.0 | | | | | F-1/F-2 | 48+12 | A | A |
| Example 12 | A-4 | 33.0 | B-3 | 5.0 | C-1 | 1.0 | D-1 | 1.0 | | | F-1 | 60 | A | A |
| Example 13 | A-5 | 34.0 | | | C-1 | 1.0 | | | E-3 | 5.0 | F-1 | 60 | C | A |
| Example 14 | A-5 | 34.0 | B-2 | 5.0 | C-1 | 1.0 | | | | | F-1 | 60 | C | A |
| Example 15 | A-5 | 34.0 | B-3 | 5.0 | C-4 | 1.0 | | | | | F-1/F-2 | 48+12 | C | A |
| Example 16 | A-6 | 39.0 | | | C-1 | 1.0 | | | | | F-1 | 60 | B | A |
| Example 17 | A-6 | 33.9 | B-2 | 5.0 | C-1 | 1.0 | | | E-4 | 0.1 | F-1 | 60 | B | A |
| Example 18 | A-6 | 34.0 | B-3 | 5.0 | C-5 | 1.0 | | | | | F-1 | 60 | B | A |
| Comparative Example 1 | A-7 | 34.0 | B-1 | 5.0 | C-1 | 1.0 | | | | | F-1 | 60 | D | C |
| Comparative Example 2 | A-7 | 33.9 | B-2 | 5.0 | C-1 | 1.0 | | | E-4 | 0.1 | F-1/F-2 | 48+12 | D | C |
| Comparative Example 3 | A-8 | 34.0 | B-2 | 5.0 | C-1 | 1.0 | | | | | F-1 | 60 | E | B |

As is apparent from the above table, the heterocycle-containing polymer precursor obtained by the method of manufacturing the heterocycle-containing polymer precursor of the present invention had short cyclization time and constant cyclization time in a case where synthesis method was performed in a plurality of steps.

In contrast, in a case where the difference between the molar amount of the halogenating agent and the molar amount of water included in the reaction system before the reaction of the halogenating agent was more than 2.10 times of the molar amount of dicarboxylic acid or the like as a raw material (Comparative Examples 1 to 3), the cyclization time was long and cyclization time varies in a case where synthesis method was performed in a plurality of steps.

<Example 100>

The photosensitive resin composition of Example 1 was subjected to pressure filtration through a filter having a pore width of 0.8 μm and was applied by spinning (3,500 rpm, 30 seconds) to a resin substrate having a thin copper layer. The photosensitive resin composition applied to the resin substrate was dried at 100°C for 5 minutes and was then exposed using an aligner (Karl-Suss MA 150). The exposure was performed with a high pressure mercury lamp, and exposure energy was measured at a wavelength of 365 nm. After the exposure, the image was developed with cyclopentanone for 75 seconds.

Subsequently, the substrate was heated at 180°C for 20 minutes. In this manner, an interlayer insulating film for a rewiring layer was formed.

This interlayer insulating film for a rewiring layer had excellent insulation properties.

A semiconductor device was manufactured by using this interlayer insulating film for a rewiring layer, and it was confirmed that the semiconductor device operates without a problem.

Explanation of References

100: semiconductor device
101a to 101d: semiconductor element
101: laminate
102b to 102d: through electrode
103a to 103e: metal bump
105: rewiring layer
110, 110a, 110b: underfill layer
115: insulating layer
120: wiring substrate
120a: surface electrode

## Claims

**1.** A method of manufacturing a heterocycle-containing polymer precursor using dicarboxylic acid or dicarboxylic acid derivative and diamine as raw materials, comprising:

halogenating the dicarboxylic acid or the dicarboxylic acid derivative by using a halogenating agent and performing reaction with diamine; and
adjusting a difference between a molar amount of the halogenating agent and a molar amount of water included in a reaction system before reaction of the halogenating agent to become 2.10 times or less of a total molar amount of the dicarboxylic acid and the dicarboxylic acid derivative as the raw materials.

**2.** The method of manufacturing a heterocycle-containing polymer precursor according to claim 1,
wherein, in the heterocycle-containing polymer precursor, an acid value of an acid group having pH at a neutralization point in a range of 5.0 to 9.0 is 4.0 mgKOH/g or less, and wherein the acid value of an acid group is measured according to the following method:
3.0 g of the heterocycle-containing polymer precursor is dissolved in 80 mL of N-methylpyrrolidone and 1 mL of water and titrated with 0.01 N sodium hydroxide aqueous solution, so as to calculate an acid value from a peak having pH in the range of 5.0 to 9.0.

**3.** The method of manufacturing a heterocycle-containing polymer precursor according to claim 1 or 2, further comprising:
measuring a water content of the reaction system before the reaction of the halogenating agent and adjusting an addition amount of the halogenating agent according to the water content.

4. The method of manufacturing a heterocycle-containing polymer precursor according to claim 1 or 2, further comprising:
adding water before the halogenating agent is added.

5. The method of manufacturing a heterocycle-containing polymer precursor according to any one of claims 1 to 4, wherein the molar amount of the halogenating agent is 2.00 to 2.10 times of the total molar amount of the dicarboxylic acid and the dicarboxylic acid derivative as the raw materials.

6. The method of manufacturing a heterocycle-containing polymer precursor according to any one of claims 1 to 5,

wherein the heterocycle-containing polymer precursor includes a repeating unit represented by Formula (2) or a repeating unit represented by Formula (3),

Formula (2)

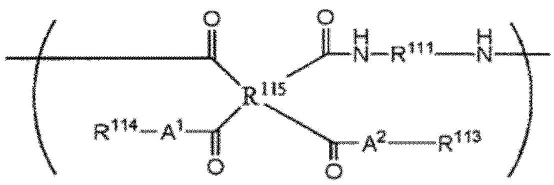

Formula (3)

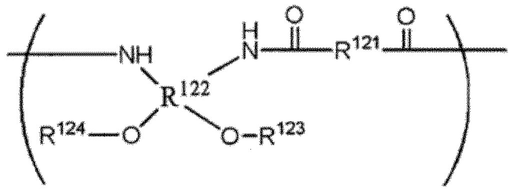

in Formula (2), $A^1$ and $A^2$ each independently represent an oxygen atom or NH,
$R^{111}$ represents a divalent organic group, $R^{115}$ represents a tetravalent organic group, $R^{113}$ and $R^{114}$ each independently represent a hydrogen atom or a monovalent organic group; and
in Formula (3), $R^{121}$ represents a divalent organic group, $R^{122}$ represents a tetravalent organic group, and $R^{123}$ and $R^{124}$ each independently represent a hydrogen atom or a monovalent organic group.

7. The method of manufacturing a heterocycle-containing polymer precursor according to any one of claims 1 to 6,

wherein a total number of a terminal group represented by Formula (2-2) and a terminal group represented by Formula (3-2) included in the heterocycle-containing polymer precursor is 2.5% or less of a total number of a total repeating unit;

Formula (2-2)

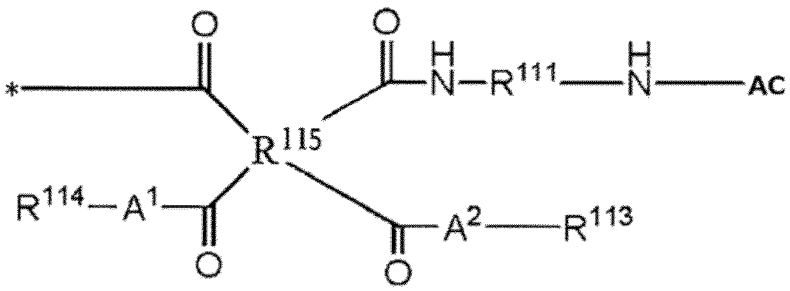

Formula (3-2)

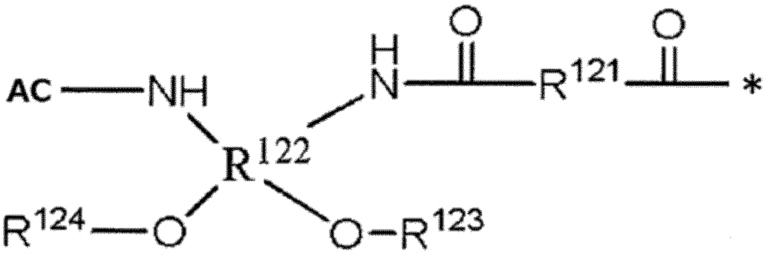

in Formula (2-2), $A^1$ and $A^2$ each independently represent an oxygen atom or NH, $R^{111}$ represents a divalent organic group, $R^{115}$ represents a tetravalent organic group, $R^{113}$ and $R^{114}$ each independently represent a hydrogen atom or a monovalent organic group, AC represents an acid group having pH of a neutralization point in a range of 5.0 to 9.0, and * represents a bonding position to a main chain of a polyimide precursor; and

in Formula (3-2), $R^{121}$ represents a divalent organic group, $R^{122}$ represents a tetravalent organic group, and $R^{123}$ and $R^{124}$ each independently represent a hydrogen atom or a monovalent organic group, AC represents an acid group having pH of the neutralization point in a range of 5.0 to 9.0, and * represents a bonding position to a main chain of a polybenzoxazole precursor.

**8.** The method of manufacturing a heterocycle-containing polymer precursor according to any one of claims 1 to 7, wherein a weight-average molecular weight of the heterocycle-containing polymer precursor is 20,000 to 30,000.

**9.** A heterocycle-containing polymer precursor, which is selected from a polyimide precursor material and a polybenzoxazole precursor material and in which an acid value of an acid group having pH of a neutralization point in a range of 5.0 to 9.0 is 4.0 mgKOH/g or less, wherein the acid value of an acid group is measured according to the following method:

3.0 g of the heterocycle-containing polymer precursor is dissolved in 80 mL of N-methylpyrrolidone and 1 mL of water and titrated with 0.01 N sodium hydroxide aqueous solution, so as to calculate an acid value from a peak having pH in the range of 5.0 to 9.0,

wherein a total number of a terminal group represented by Formula (2-2) and a terminal group represented by Formula (3-2) included in the heterocycle-containing polymer precursor is 2.5% or less of a total number of a total repeating unit;

Formula (2-2)

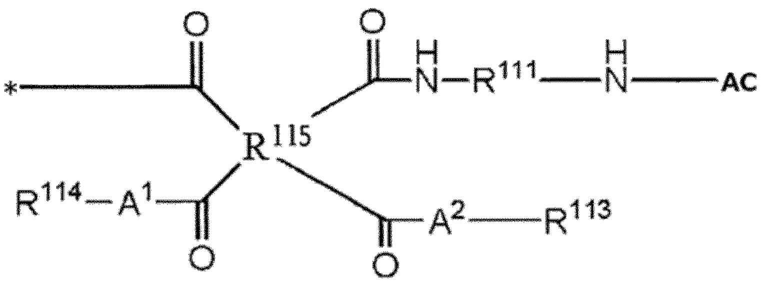

Formula (3-2)

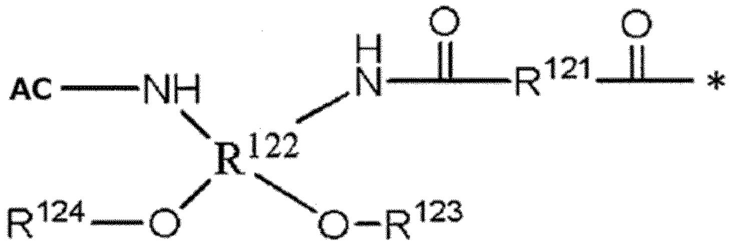

in Formula (2-2), $A^1$ and $A^2$ each independently represent an oxygen atom or NH,
$R^{111}$ represents a divalent organic group, $R^{115}$ represents a tetravalent organic group, $R^{113}$ and $R^{114}$ each independently represent a hydrogen atom or a monovalent organic group, AC represents an acid group having pH of a neutralization point in a range of 5.0 to 9.0, and * represents a bonding position to a main chain of a polyimide precursor; and
in Formula (3-2), $R^{121}$ represents a divalent organic group, $R^{122}$ represents a tetravalent organic group, and $R^{123}$ and $R^{124}$ each independently represent a hydrogen atom or a monovalent organic group, AC represents an acid group having pH of the neutralization point in a range of 5.0 to 9.0, and * represents a bonding position to a main chain of a polybenzoxazole precursor.

**10.** The heterocycle-containing polymer precursor according to claim 9,
wherein a weight-average molecular weight of the heterocycle-containing polymer precursor is 20,000 to 30,000.

**11.** A composition comprising:
the heterocycle-containing polymer precursor according to any one of claims 9 to 10.

**12.** The composition according to claim 11, further comprising:
a photopolymerization initiator.

**13.** A cured film obtained by curing the composition according to claim 11 or 12.

**14.** The cured film according to claim 13, which is an interlayer insulating film for a rewiring layer.

**15.** A method of manufacturing a cured film comprising:

applying the composition according to claim 11 or 12 to a substrate; and
curing the composition applied to the substrate.

**16.** A semiconductor device comprising:
the cured film according to claim 13 or 14.

**Patentansprüche**

**1.** Verfahren zur Herstellung eines Heterozyklus-haltigen Polymervorläufers unter Verwendung von Dicarbonsäure oder Dicarbonsäurederivat und Diamin als Ausgangsmaterialien, umfassend:

Halogenieren der Dicarbonsäure oder des Dicarbonsäurederivats unter Verwendung eines Halogenierungsmittels und Durchführen einer Reaktion mit Diamin; und
Einstellen des Unterschieds zwischen der molaren Menge des Halogenierungsmittels und der molaren Menge von Wasser, die in einem Reaktionssystem enthalten ist, vor der Reaktion des Halogenierungsmittels zum 2,10-fachen oder weniger der gesamten molaren Menge der Dicarbonsäure und des Dicarbonsäurederivats als Ausgangsmaterialien.

**2.** Verfahren zur Herstellung eines Heterozyklus-haltigen Polymervorläufers gemäß Anspruch 1,
worin in dem Heterozyklus-haltigen Polymervorläufer der Säurewert einer Säuregruppe mit einem pH-Wert beim Neutralisationspunkt im Bereich von 5,0 bis 9,0 4,0 mgKOH/g oder weniger beträgt, und worin der Säurewert einer

Säuregruppe gemessen wird mit dem folgenden Verfahren:
3,0 g des Heterozyklus-haltigen Polymervorläufers wird in 80 ml N-Methylpyrrolidon und 1 ml Wasser gelöst und mit einer wässrigen 0,01 N-Natriumhydroxidlösung titriert, um so einen Säurewert aus einem Peak mit einem pH-Wert im Bereich von 5,0 bis 9,0 zu berechnen.

**3.** Verfahren zur Herstellung eines Heterozyklus-haltigen Polymervorläufers gemäß Anspruch 1 oder 2, ferner umfassend:
Messen des Wassergehalts des Reaktionssystems vor der Reaktion des Halogenierungsmittels und Einstellen der Zugabemenge des Halogenierungsmittels in Übereinstimmung mit dem Wassergehalt.

**4.** Verfahren zur Herstellung eines Heterozyklus-haltigen Polymervorläufers gemäß Anspruch 1 oder 2, ferner umfassend:
Zugeben von Wasser, bevor das Halogenierungsmittels zugegeben wird.

**5.** Verfahren zur Herstellung eines Heterozyklus-haltigen Polymervorläufers gemäß irgendeinem der Ansprüche 1 bis 4, worin die molar Menge des Halogenierungsmittels das 2,00- bis 2,10-fache der molaren Gesamtmenge der Dicarbonsäure und des Dicarbonsäurederivats als Ausgangsmaterialien beträgt.

**6.** Verfahren zur Herstellung eines Heterozyklus-haltigen Polymervorläufers gemäß irgendeinem der Ansprüche 1 bis 5,

worin der Heterozyklus-haltige Polymervorläufer eine durch die Formel (2) dargestellte Wiederholungseinheit oder eine durch die Formel (3) dargestellte Wiederholungseinheit umfasst

Formel (2)

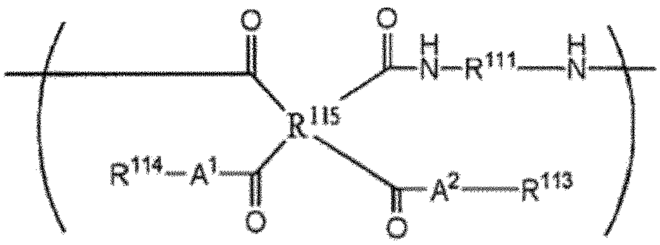

Formel (3)

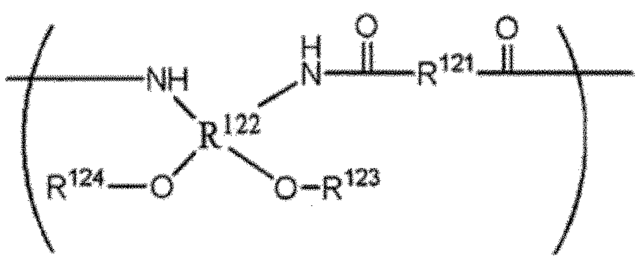

worin in der Formel (2) $A^1$ und $A^2$ jeweils unabhängig ein Sauerstoffatom oder NH darstellen,
$R^{111}$ eine divalente organische Gruppe darstellt, $R^{115}$ eine tetravalente organische Gruppe darstellt, $R^{113}$ und $R^{114}$ jeweils unabhängig ein Wasserstoffatom oder eine monovalente organische Gruppe darstellen; und
in der Formel (3) $R^{121}$ eine divalente organische Gruppe darstellt, $R^{122}$ eine tetravalente organische Gruppe darstellt und $R^{123}$ und $R^{124}$ jeweils unabhängig ein Wasserstoffatom oder eine monovalente organische Gruppe darstellen.

**7.** Verfahren zur Herstellung eines Heterozyklus-haltigen Polymervorläufers gemäß irgendeinem der Ansprüche 1 bis 6,

worin die Gesamtanzahl einer durch die Formel (2-2) dargestellten endständigen Gruppe und einer durch die Formel (3-2) dargestellten endständigen Gruppe, die in dem Heterozyklus-haltigen Polymervorläufer enthalten

sind, 2,5 % oder weniger der Gesamtanzahl der gesamten Wiederholungseinheiten beträgt;

Formel (2-2)

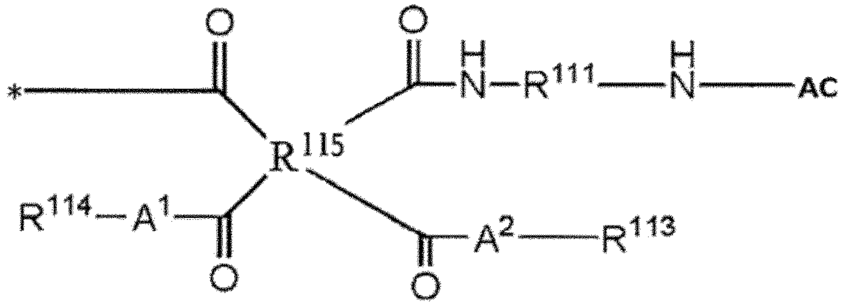

Formel (3-2)

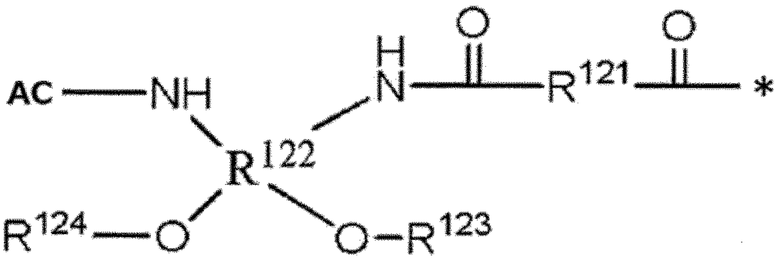

worin in der Formel (2-2) $A^1$ und $A^2$ jeweils unabhängig ein Sauerstoffatom oder NH darstellen, $R^{111}$ eine divalente organische Gruppe darstellt, $R^{115}$ eine tetravalente organische Gruppe darstellt, $R^{113}$ und $R^{114}$ jeweils unabhängig ein Wasserstoffatom oder eine monovalente organische Gruppe darstellen, AC eine Säuregruppe mit einem pH-Wert mit einem Neutralisationspunkt im Bereich von 5,0 bis 9,0 darstellt, und * eine Bindungsposition an eine Hauptkette eines Polyimidvorläufers darstellt; und
in der Formel (3-2) $R^{121}$ eine divalente organische Gruppe darstellt, $R^{122}$ eine tetravalente organische Gruppe darstellt und $R^{123}$ und $R^{124}$ jeweils unabhängig ein Wasserstoffatom oder eine monovalente organische Gruppe darstellen, AC eine Säuregruppe mit einem pH-Wert des Neutralisationspunkts im Bereich von 5,0 bis 9,0 darstellt, und * eine Bindungsposition an eine Hauptkette eines Polybenzoxazol-Vorläufers darstellt.

**8.** Verfahren zur Herstellung eines Heterozyklus-haltigen Polymervorläufers gemäß irgendeinem der Ansprüche 1 bis 7, worin das gewichtsgemittelte Molekulargewicht des Heterozyklus-haltigen Polymervorläufers 20.000 bis 30.000 beträgt.

**9.** Heterozyklus-haltiger Polymervorläufer, der ausgewählt ist aus einem Polyimid-Vorläufermaterial und einem Polybenzoxazol-Vorläufermaterial und worin ein Säurewert einer Säuregruppe mit einem pH-Wert eines Neutralisationspunkts im Bereich von 5,0 bis 9,0 4,0 mgKOH/g oder weniger beträgt, worin der Säurewert einer Säuregruppe mit dem folgenden Verfahren gemessen wird:

3,0 g des Heterozyklus-haltigen Polymervorläufers wird in 80 ml N-Methylpyrrolidon und 1 ml Wasser gelöst und mit einer wässrigen 0,01 N-Natriumhydroxidlösung titriert, um so einen Säurewert aus einem Peak mit einem pH-Wert im Bereich von 5,0 bis 9,0 zu berechnen,
worin eine Gesamtanzahl einer durch die Formel (2-2) dargestellten endständigen Gruppe und einer durch die Formel (3-2) dargestellten endständigen Gruppe, die in dem Heterozyklus-haltigen Polymervorläufer enthalten sind, 2,5 % oder weniger der Gesamtanzahl von allen Wiederholungseinheiten beträgt;

Formel (2-2)

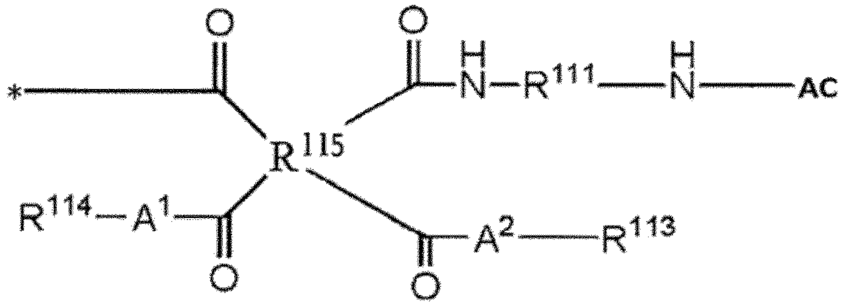

Formel (3-2)

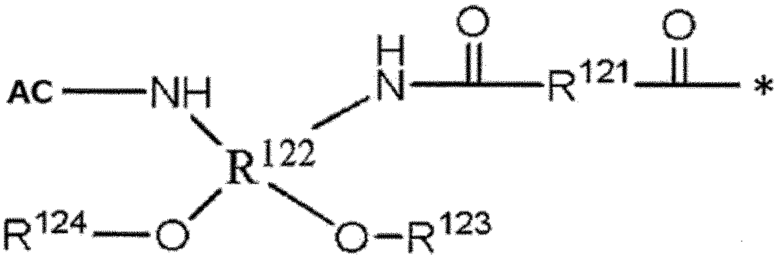

worin in der Formel (2-2) $A^1$ und $A^2$ jeweils unabhängig ein Sauerstoffatom oder NH darstellen, $R^{111}$ eine divalente organische Gruppe darstellt, $R^{115}$ eine tetravalente organische Gruppe darstellt, $R^{113}$ und $R^{114}$ jeweils unabhängig ein Wasserstoffatom oder eine monovalente organische Gruppe darstellen, AC eine Säuregruppe mit einem pH-Wert mit einem Neutralisationspunkt im Bereich von 5,0 bis 9,0 darstellt, und * eine Bindungsposition an eine Hauptkette eines Polyimidvorläufers darstellt; und
in der Formel (3-2) $R^{121}$ eine divalente organische Gruppe darstellt, $R^{122}$ eine tetravalente organische Gruppe darstellt und $R^{123}$ und $R^{124}$ jeweils unabhängig ein Wasserstoffatom oder eine monovalente organische Gruppe darstellen, AC eine Säuregruppe mit einem pH-Wert des Neutralisationspunkts im Bereich von 5,0 bis 9,0 darstellt, und * eine Bindungsposition an eine Hauptkette eines Polybenzoxazol-Vorläufers darstellt.

**10.** Heterozyklus-haltiger Polymervorläufer gemäß Anspruch 9,
worin das gewichtsgemittelte Molekulargewicht des Heterozyklus-haltigen Polymervorläufers 20.000 bis 30.000 beträgt.

**11.** Zusammensetzung, umfassend:
den Heterozyklus-haltigen Polymervorläufer gemäß irgendeinem der Ansprüche 9 bis 10.

**12.** Zusammensetzung gemäß Anspruch 11, ferner umfassend:
einen Fotopolymerisationsinitiator.

**13.** Gehärtete(r) Film/Folie, erhalten durch Härten der Zusammensetzung gemäß Anspruch 11 oder 12.

**14.** Gehärtete(r) Film/Folie gemäß Anspruch 13, welcher ein Isolier-Zwischenfilm bzw. eine -Folie für eine Umverdrahtungsschicht ist.

**15.** Verfahren zur Herstellung eines gehärteten Films bzw. einer gehärteten Folie, umfassend:

Auftragen der Zusammensetzung gemäß Anspruch 11 oder 12 auf en Substrat; und
Härten der auf das Substrat aufgetragenen Zusammensetzung.

**16.** Halbleitervorrichtung, umfassend:

den gehärteten Film bzw. die gehärtete Folie gemäß Anspruch 13 oder 14.

**Revendications**

1. Procédé de fabrication d'un précurseur de polymère contenant un hétérocycle au moyen d'un acide dicarboxylique ou d'un dérivé d'acide dicarboxylique et d'une diamine servant de matières premières, comprenant :

   une halogénation de l'acide dicarboxylique ou du dérivé d'acide dicarboxylique en utilisant un agent d'halogénation et en réalisant une réaction avec la diamine ; et
   un ajustement d'une différence entre une quantité molaire de l'agent d'halogénation et une quantité molaire d'eau incluse dans un système de réaction avant une réaction de l'agent d'halogénation pour qu'elle devienne égale à 2,10 fois ou moins une quantité molaire totale de l'acide dicarboxylique et du dérivé d'acide dicarboxylique servant de matières premières.

2. Procédé de fabrication d'un précurseur de polymère contenant un hétérocycle selon la revendication 1,
   dans lequel, dans le précurseur de polymère contenant un hétérocycle, un indice d'acidité d'un groupe acide présentant un pH à un point de neutralisation dans une plage de 5,0 à 9,0 est 4,0 mgKOH/g ou moins, et dans lequel l'indice d'acidité d'un groupe acide est mesuré conformément au procédé suivant :
   3,0 g du précurseur de polymère contenant un hétérocycle sont dissous dans 80 ml de N-méthylpyrrolidone et 1 ml d'eau et titrés avec 0,01 N d'hydroxyde de sodium en solution aqueuse, de manière à calculer un indice d'acidité à partir d'un pic présentant un pH dans la plage de 5,0 à 9,0.

3. Procédé de fabrication d'un précurseur de polymère contenant un hétérocycle selon la revendication 1 ou 2, comprenant en outre :
   une mesure d'une teneur en eau du système de réaction avant la réaction de l'agent d'halogénation et un ajustement d'une quantité ajoutée de l'agent d'halogénation conformément à la teneur en eau.

4. Procédé de fabrication d'un précurseur de polymère contenant un hétérocycle selon la revendication 1 ou 2, comprenant en outre :
   un ajout d'eau avant que l'agent d'halogénation ne soit ajouté.

5. Procédé de fabrication d'un précurseur de polymère contenant un hétérocycle selon l'une quelconque des revendications 1 à 4,
   dans lequel la quantité molaire de l'agent d'halogénation est 2,00 à 2,10 fois la quantité molaire totale de l'acide dicarboxylique et du dérivé d'acide dicarboxylique servant de matières premières.

6. Procédé de fabrication d'un précurseur de polymère contenant un hétérocycle selon l'une quelconque des revendications 1 à 5,

   dans lequel le précurseur de polymère contenant un hétérocycle inclut une unité de répétition représentée par la Formule (2) ou une unité de répétition représentée par la Formule (3),

Formule (2)

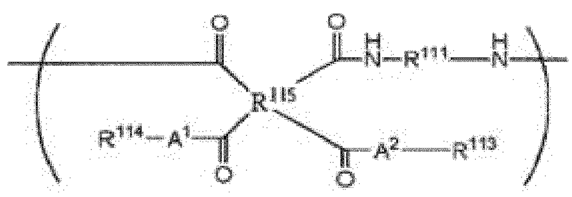

Formule (3)

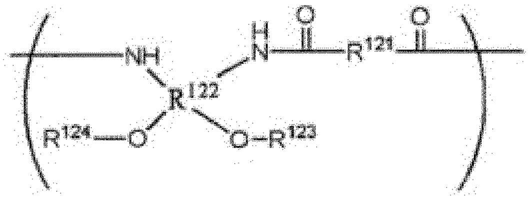

dans la Formule (2), $A^1$ et $A^2$ représentent chacun indépendamment un atome d'oxygène ou NH, $R^{111}$ représente un groupe organique divalent, $R^{115}$ représente un groupe organique tétravalent, $R^{113}$ et $R^{114}$ représentent chacun indépendamment un atome d'hydrogène ou un groupe organique monovalent ; et dans la Formule (3), $R^{121}$ représente un groupe organique divalent, $R^{122}$ représente un groupe organique tétravalent, et $R^{123}$ et $R^{124}$ représentent chacun indépendamment un atome d'hydrogène ou un groupe organique monovalent.

**7.** Procédé de fabrication d'un précurseur de polymère contenant un hétérocycle selon l'une quelconque des revendications 1 à 6,

dans lequel un indice total d'un groupe terminal représenté par la Formule (2-2) et d'un groupe terminal représenté par la Formule (3-2) inclus dans le précurseur de polymère contenant un hétérocycle est 2,5 % ou moins d'un indice total d'une unité de répétition totale ;

Formule (2-2)

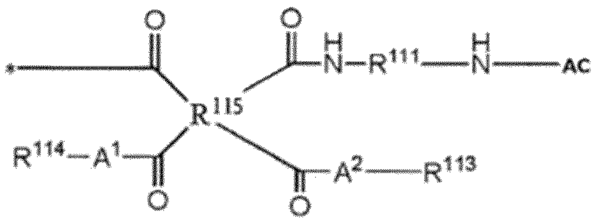

Formule (3-2)

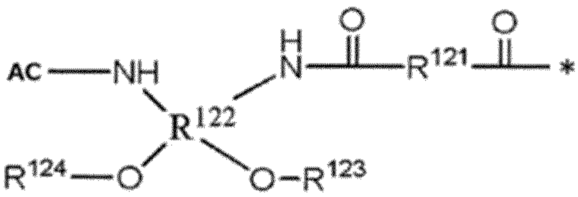

dans la Formule (2-2), $A^1$ et $A^2$ représentent chacun indépendamment un atome d'oxygène ou NH, $R^{111}$ représente un groupe organique divalent, $R^{115}$ représente un groupe organique tétravalent, $R^{113}$ et $R^{114}$ représentent chacun indépendamment un atome d'hydrogène ou un groupe organique monovalent, AC représente un groupe acide présentant un pH d'un point de neutralisation dans une plage de 5,0 à 9,0, et * représente une position de liaison à une chaîne principale d'un précurseur de polyimide ; et dans la Formule (3-2), $R^{121}$ représente un groupe organique divalent, $R^{122}$ représente un groupe organique tétravalent, et $R^{123}$ et $R^{124}$ représentent chacun indépendamment un atome d'hydrogène ou un groupe organique monovalent, AC représente un groupe acide présentant un pH du point de neutralisation dans une plage de 5,0 à 9,0, et * représente une position de liaison à une chaîne principale d'un précurseur de polybenzoxazole.

**8.** Procédé de fabrication d'un précurseur de polymère contenant un hétérocycle selon l'une quelconque des revendications 1 à 7,
dans lequel un poids moléculaire moyen en poids du précurseur de polymère contenant un hétérocycle est 20 000

à 30 000.

**9.** Précurseur de polymère contenant un hétérocycle, qui est sélectionné parmi un matériau de précurseur de polyimide et un matériau de précurseur de polybenzoxazole et dans lequel un indice d'acidité d'un groupe acide présentant un pH d'un point de neutralisation dans une plage de 5,0 à 9,0 est 4,0 mgKOH/g ou moins, dans lequel l'indice d'acidité d'un groupe acide est mesuré conformément au procédé suivant :

3,0 g du précurseur de polymère contenant un hétérocycle sont dissous dans 80 ml de N-méthylpyrrolidone et 1 ml d'eau et titrés avec 0,01 N d'hydroxyde de sodium en solution aqueuse, de manière à calculer un indice d'acidité à partir d'un pic présentant un pH dans la plage de 5,0 à 9,0,
dans lequel un indice total d'un groupe terminal représenté par la Formule (2-2) et d'un groupe terminal représenté par la Formule (3-2) inclus dans le précurseur de polymère contenant un hétérocycle est 2,5 % ou moins d'un indice total d'une unité de répétition totale ;

Formule (2-2)

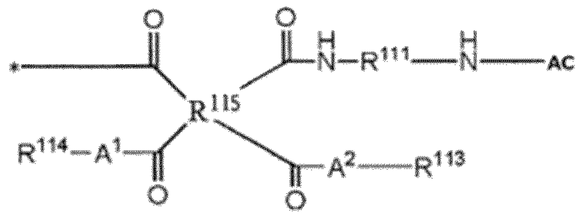

Formule (3-2)

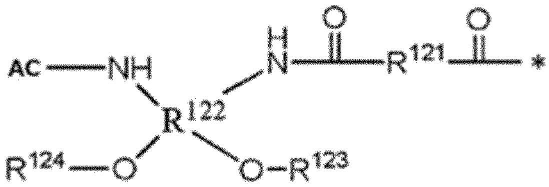

dans la Formule (2-2), $A^1$ et $A^2$ représentent chacun indépendamment un atome d'oxygène ou NH, $R^{111}$ représente un groupe organique divalent, $R^{115}$ représente un groupe organique tétravalent, $R^{113}$ et $R^{114}$ représentent chacun indépendamment un atome d'hydrogène ou un groupe organique monovalent, AC représente un groupe acide présentant un pH d'un point de neutralisation dans une plage de 5,0 à 9,0, et * représente une position de liaison à une chaîne principale d'un précurseur de polyimide ; et
dans la Formule (3-2), $R^{121}$ représente un groupe organique divalent, $R^{122}$ représente un groupe organique tétravalent, et $R^{123}$ et $R^{124}$ représentent chacun indépendamment un atome d'hydrogène ou un groupe organique monovalent, AC représente un groupe acide présentant un pH du point de neutralisation dans une plage de 5,0 à 9,0, et * représente une position de liaison à une chaîne principale d'un précurseur de polybenzoxazole.

**10.** Précurseur de polymère contenant un hétérocycle selon la revendication 9, dans lequel un poids moléculaire moyen en poids du précurseur de polymère contenant un hétérocycle est 20 000 à 30 000.

**11.** Composition comprenant :
le précurseur de polymère contenant un hétérocycle selon l'une quelconque des revendications 9 à 10.

**12.** Composition selon la revendication 11, comprenant en outre : un initiateur de photopolymérisation.

**13.** Film durci obtenu par durcissement de la composition selon la revendication 11 ou 12.

**14.** Film durci selon la revendication 13, qui est un film isolant intercouche pour une couche de recâblage.

**15.** Procédé de fabrication d'un film durci comprenant : une application de la composition selon la revendication 11 ou 12 sur un substrat ; et un durcissement de la composition appliquée sur le substrat.

**16.** Dispositif à semi-conducteur comprenant : le film durci selon la revendication 13 ou 14.

FIG. 1

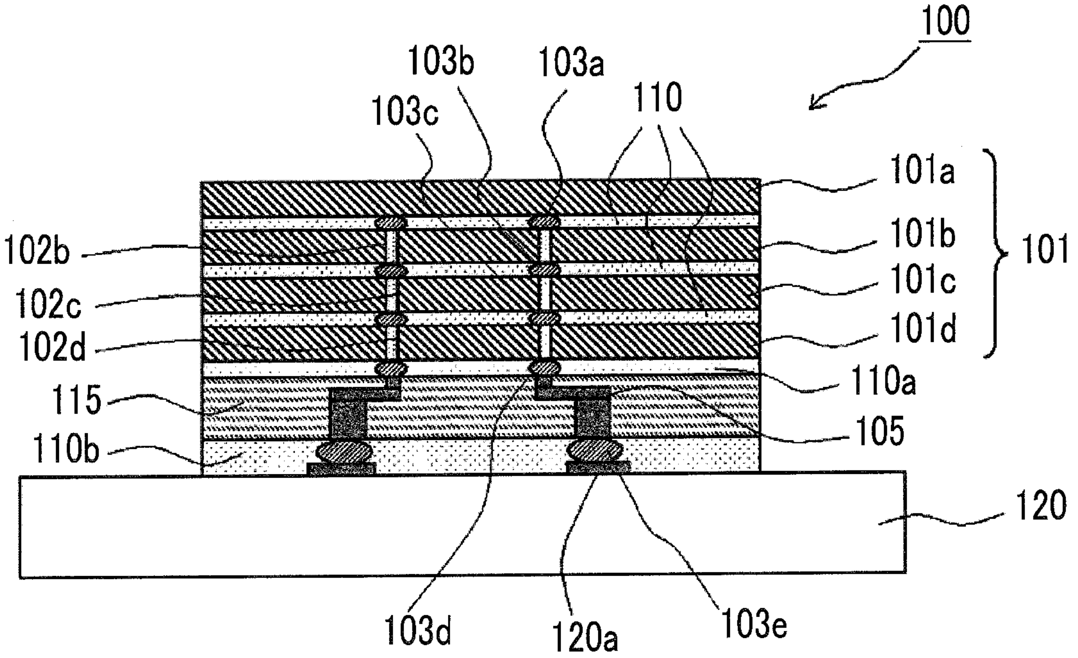
100
103b
103a
103c
110
101a
102b
101b
101
102c
101c
102d
101d
110a
115
105
110b
120
103d
120a
103e

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014122279 A
- JP 2015108053 A
- JP S59068332 A
- JP 2013256506 A
- GB 1388492 B
- JP 53133428 A
- JP S53133428 A
- DE 3337024 B
- JP 62058241 A
- JP S6258241 A
- JP 5281728 A
- JP H05281728 A
- JP 5034920 A
- JP H0534920 A
- US 4212976 A
- JP 2015087611 A
- JP 57001819 B
- JP S571819 B
- JP 57006096 B
- JP S576096 B
- US 3615455 A
- JP 10291969 A
- JP H10291969 A
- JP 4225898 B
- JP 2009191179 A
- JP 2001233842 A
- JP 2000080068 A
- JP 2006342166 A
- JP 2000066385 A
- JP 2004534797 A
- JP 2009519904 A
- US 7626957 B
- JP 2010015025 A
- US 2009292039 A
- US 2009131189 A
- US 7556910 B
- JP 2009221114 A
- JP 2007231000 A
- JP 2007322744 A
- JP 2010032985 A
- JP 2010185072 A
- JP 2009242469 A
- JP 2010262028 A
- JP 2014500852 A
- JP 2013164471 A
- JP 2007269779 A
- JP 2009191061 A
- JP 46027926 B
- JP S4627926 B
- JP 51047334 B
- JP S5147334 B
- JP 57196231 A
- JP S57196231 A
- JP 59005240 A
- JP S595240 A
- JP 59005241 A
- JP S595241 A
- JP 2226149 A
- JP H02226149 B
- JP 1165613 A
- JP H01165613 A
- JP 54021726 B
- JP S5421726 B
- JP 48041708 B
- JP S4841708 B
- JP 51037193 A
- JP S5137193 A
- JP 2032293 B
- JP H0232293 B
- JP 2016765 B
- JP H0216765 B
- JP 58049860 B
- JP S5849860 B
- JP 56017654 B
- JP S5617654 B
- JP 62039417 B
- JP S6239417 B
- JP 62039418 B
- JP S6239418 B
- JP 2009288705 A
- JP 50006034 B
- JP 48064183 A
- JP S4864183 A
- JP 49043191 B
- JP S4943191 B
- JP 52030490 B
- JP S5230490 B
- JP 2008292970 A
- JP 2010160418 A
- JP 2010129825 A
- JP 4364216 B
- JP 46043946 B
- JP S4643946 B
- JP 1040337 B
- JP H0140337 B
- JP 1040336 B
- JP H0140336 B
- JP 2025493 A

- JP H0225493 A
- JP 61022048 A
- JP S6122048 A
- JP 10062986 A
- JP H1062986 A
- JP 2015187211 A
- JP 63277653 A
- JP S63277653 A
- JP 63260909 A
- JP S63260909 A
- JP 1105238 A
- JP H01105238 A
- JP 2013072935 A
- JP 2013167742 A
- JP 2008063554 A
- JP 2013015701 A
- JP 2009283711 A
- JP 2011059656 A
- JP 2012194520 A
- JP 2014186186 A
- JP 2014191002 A
- WO 2011080992 A1
- JP 2014191252 A
- JP 2014041264 A
- WO 2014097594 A
- JP 2011128358 A
- JP 2013152381 A
- JP 2011164454 A
- JP 2011089090 A

**Non-patent literature cited in the description**


- *Chemische Berichte,* 1910, vol. 43, 3297
- **WAKABAYASHI.** *Bull. Chem. Soc. Japan,* 1969, vol. 42, 2924
- **F. C. SCHAEFER.** *J. Org. Chem.,* 1964, vol. 29, 1527
- *J. C. S. Perkin,* 1979, vol. II, 1653-1660
- *J. C. S. Perkin,* 1979, vol. II, 156-162
- *Journal of Photopolymer Science and Technology,* 1995, 202-232
- *Journal of the Adhesion Society of Japan,* 1984, vol. 20 (7), 300-308
- **BROWN, H. C. ; MCDANIEL, D. H. ; HAFLIGER, O. ; NACHOD, F. C.** Determination of Organic Structures by Physical Methods. Academic Press, 1955
- **DAWSON, R. M. C. et al.** Data for Biochemical Research. Oxford, Clarendon Press, 1959
- **TSUNO YUHO.** *Journal of the Society of Synthetic Organic Chemistry, Japan,* 1965, vol. 23 (8), 631-642
- **KOBUNSHI JITEN.** Polymer Dictionary. 2005, 683-684